# EUROPEAN PATENT APPLICATION

(11) **EP 4 276 103 A1**
(43) Date of publication of application: **15.11.2023**
(21) Application number: 22859804.1
(22) Date of filing: 09.02.2022
(51) Int. Cl.: C07F 5/02, C09K 11/06, H10K 50/00, H10K 85/00

(54) **SPIRO COMPOUND, PREPARATION, ORGANIC ELECTROLUMINESCENT DIODE, AND DISPLAY DEVICE**

(30) Priority: 23.08.2021 CN 202110964534
(71) Applicant: Zhejiang Huaxian Photoelectricity Technology Co., Ltd, Jiaxing, Zhejiang 314107 (CN)
(72) Inventor: ZHAO, Xiaoyu, Jiaxing, Zhejiang 314107 (CN); SHENGTU, Xiaobo, Jiaxing, Zhejiang 314107 (CN); WU, Kongwu, Jiaxing, Zhejiang 314107 (CN)
(74) Representative: HGF
(86) International application number: PCT/CN2022/075574
(87) International publication number: WO 2023/024445

(57) **Abstract**

Disclosed in the present invention are a spiro compound, a preparation, an organic electroluminescent diode comprising the spiro compound, and a display device. The spiro compound has a structure as represented by formula (I). The spiro compound of the present invention has good thermal stability. An organic electroluminescent diode manufactured by using the spiro compound of the present invention as an organic functional layer, especially as a light-emitting layer, has improved current efficiency and a reduced turn-on voltage, and the service life of the organic electroluminescent diode is also greatly prolonged.

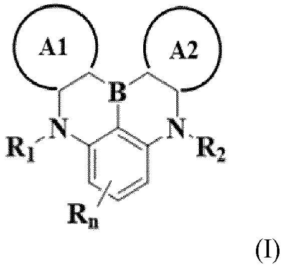

## Description

### TECHNICAL FIELD

The present discourse relates to spiro compounds, in particular, to a spiro compound and an organic electroluminescent diode including the same, and belongs to the field of organic photoelectrics.

### BACKGROUND

Organic electroluminescent diodes (OLEDs), as a new type of display technology, have the special advantages of self-luminescence, a wide viewing angle, low energy consumption, high luminescence efficiency, thinness, rich colors, a fast response, wide temperature adaptability, a low drive voltage, manufacturability into flexible and transparent display panels, environmental friendliness and the like, can be applied to flat panel displays and new generation lighting, and can also be used as the backlight of LCDs.

Since the end of the 1980s, organic electroluminescent devices have been applied in industry. The OLED luminescence can be divided into fluorescent luminescence and phosphorescent luminescence. According to theoretical speculation, the ratio of singlet excited states to triplet excited states formed by the recombination of charges is 1:3. Small molecule fluorescent materials can utilize 25% of energy, the remaining 75% of energy is lost due to the non-luminescence mechanism of triplet excited states, and therefore, the internal quantum efficiency limit of fluorescent materials is generally considered to be 25%. In 2016, Takuji Hatakeyama's team proposed the design strategy of multi-resonance thermally activated delayed fluorescence (MR-TADF) materials, which is to induce the distribution of the highest occupied molecular orbital (HOMO) and the lowest unoccupied molecular orbital (LUMO) on different atoms using multi-resonance effects based on boron and nitrogen atoms to achieve a smaller energy level difference between S1 and triplet excited states (T1). At the same time, the rigid structure of such materials limits the vibration and rotation of molecules, inhibits the distortion or deformation of excited state structures, reduces the non-radiative relaxation pathways, and is beneficial to the improvement of color purity and luminescence efficiency. Therefore, the MR-TADF materials exhibit high OLED device efficiency (maximum external quantum efficiency > 20%) and high color purity (full width at half maximum (FWHM) < 30 nm).

At present, almost all the emissive layers in organic OLED modules use the host-guest luminescence system mechanism, that is, a guest light-emitting material is doped in a host material. Generally speaking, the energy system of the organic host material is larger than that of the guest material, that is, energy is transferred from the host to the guest, so that the guest material is excited to emit light. At present, the MR-TADF has been applied to commercial OLED materials, but there are still some technical difficulties, for example, OLEDs require high efficiency, a long lifetime and a lower operating voltage. Since the skeleton of MR-TADF molecules has a planar structure, molecules are easily stacked in the solid state, and the strong interaction between luminescent molecules easily causes aggregation-induced fluorescence quenching, which reduces the luminescence efficiency of MR-TADF OLED devices.

Therefore, it is necessary to develop a new organic compound, and the organic electroluminescent diode including the organic compound has better efficiency, a longer lifetime and a lower driving voltage.

### SUMMARY

To overcome the defects in the existing art, the object of the present disclosure is to provide a spiro compound and an organic electroluminescent diode including the same, and the organic electroluminescent diode has better efficiency, a longer lifetime and a reduced driving voltage.

To achieve the object of the present disclosure, the solutions of the present disclosure are as follows:
The present disclosure provides a spiro compound whose structure is represented by Formula (I): 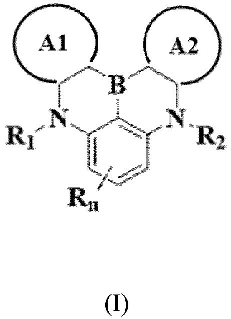
   wherein A₁ and A₂ are each independently selected from the group consisting of: 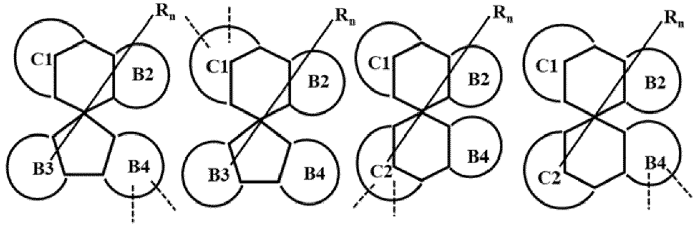 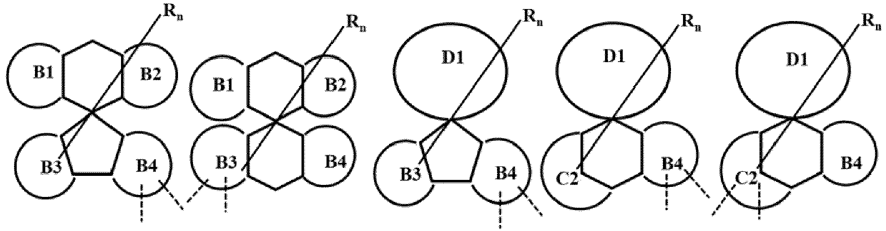 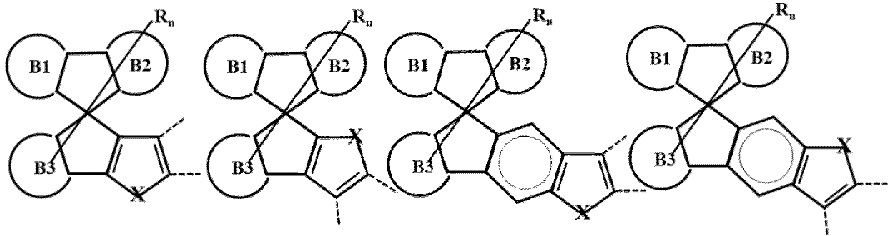 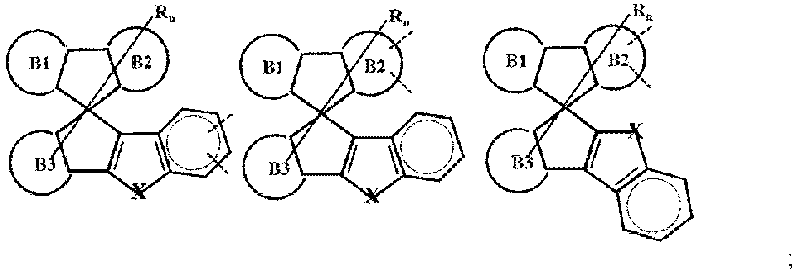
   wherein B1, B2, B3, B4, C1, C2 and D1 are each independently selected from C6-C60 aryl or C1-C60 heteroaryl;
   B1, B2, B3, B4, C1, C2 and D1 can be mono-substituted or multi-substituted according to the valence bond theory;
   X is selected from C, O, N, S or Se;
   the dashed line represents attachment to the N atom and the B atom in Formula (I) to form chemical bonds;
   R₁, R and R₂ are each independently selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10; and
   undeuterated groups in the above structures can be partially or fully deuterated.

Preferably, B1, B2, B3 and B4 are each independently selected from the group consisting of: 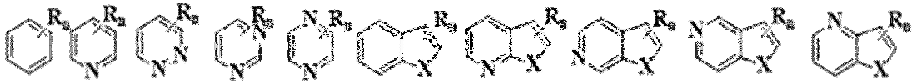 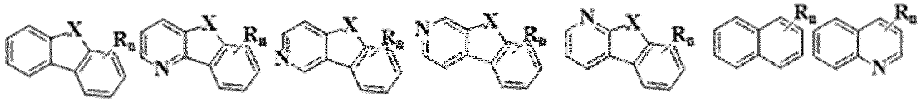 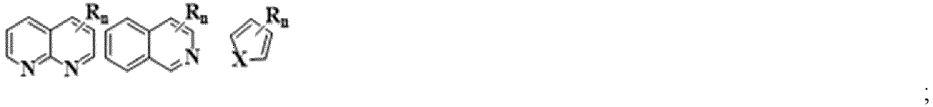
wherein R is independently selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se; and
undeuterated groups in the above structures can be partially or fully deuterated.

More preferably, C1 and C2 are each independently selected from the following structures: 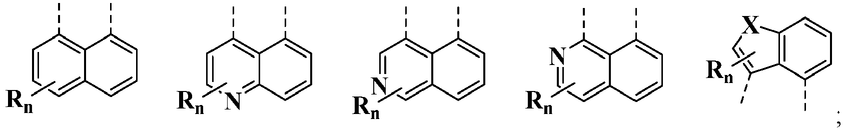
wherein R is selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se;
undeuterated groups in the above structures can be partially or fully deuterated; and
the dashed line represents attachment to the six-membered ring in the above structures to form chemical bonds.

More preferably, D1 is selected from the following structures: 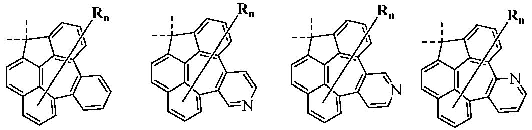 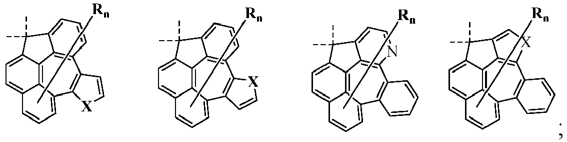
wherein R is selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se; and
undeuterated groups in the above structures can be partially or fully deuterated.

More preferably, A₁ and A₂ are each independently selected from the group consisting of: 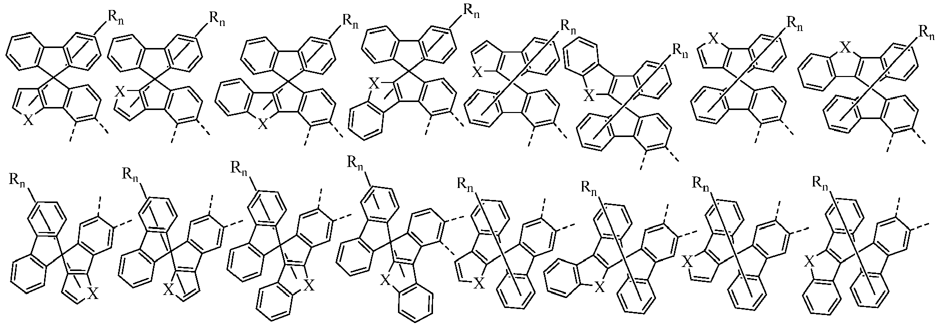 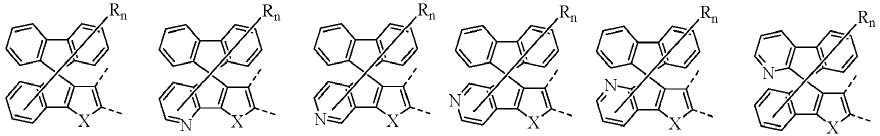 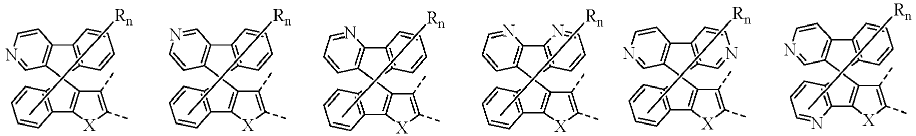 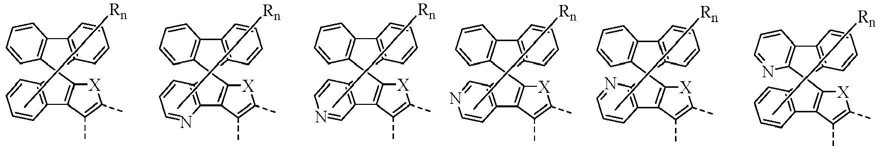 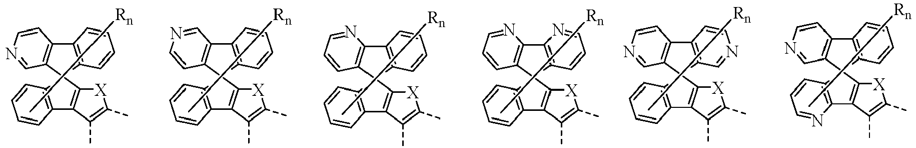 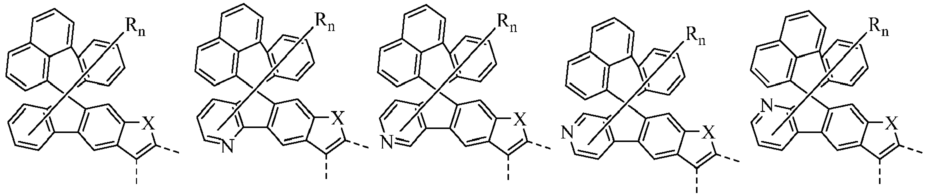 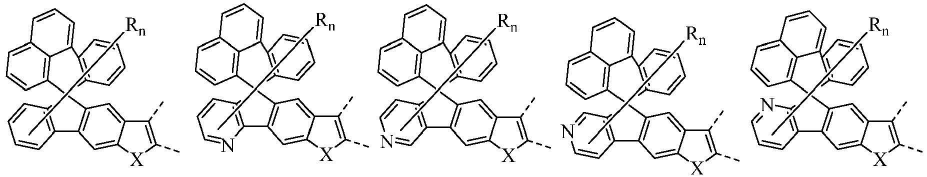 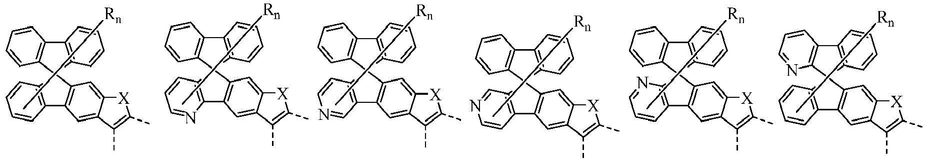 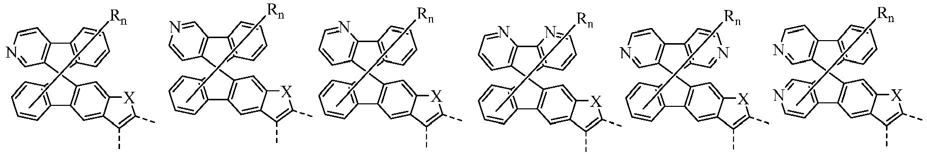 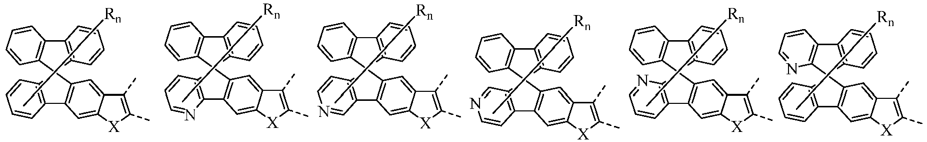 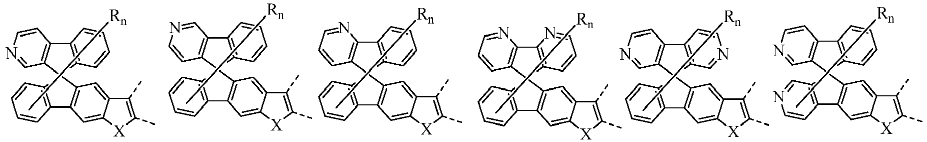 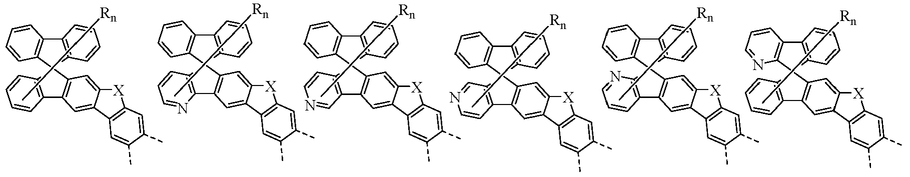 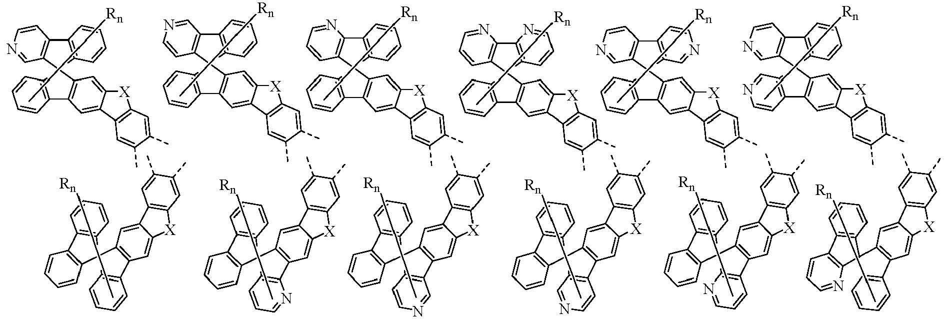 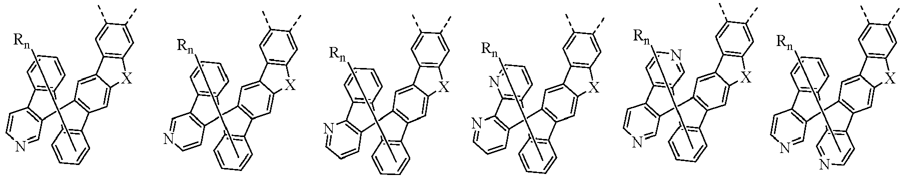 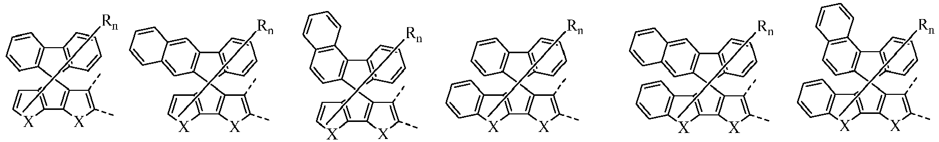 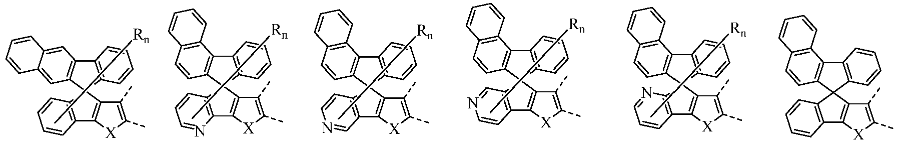 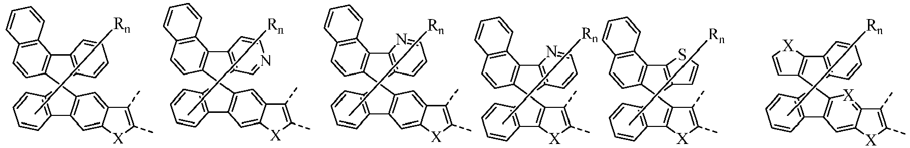 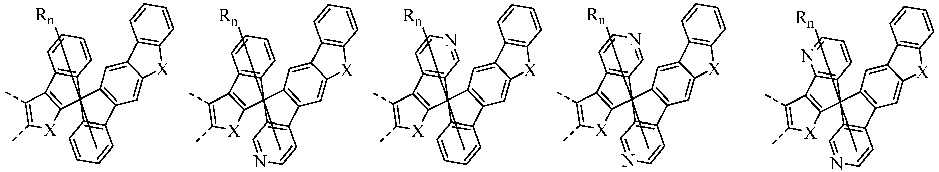 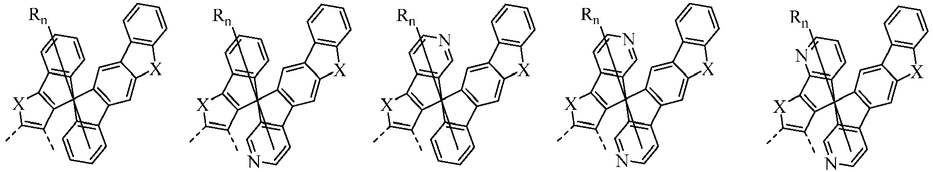 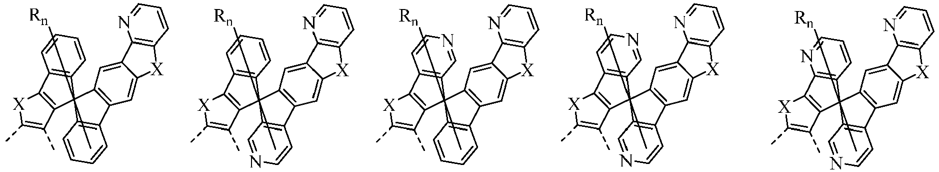 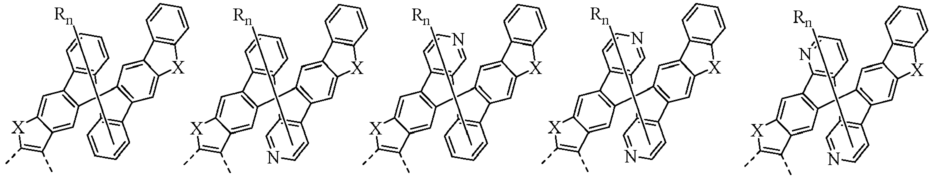 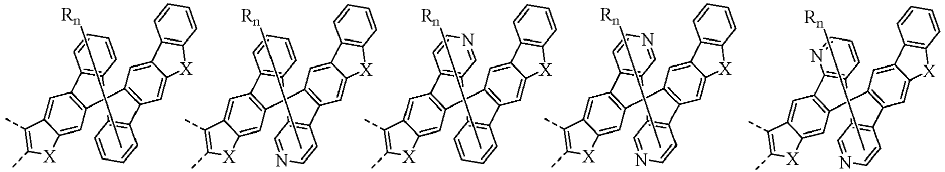 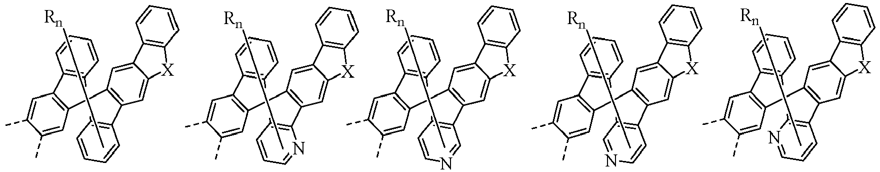 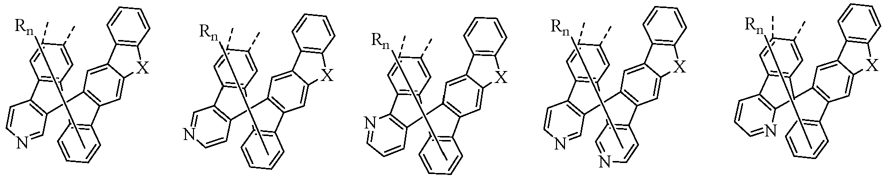 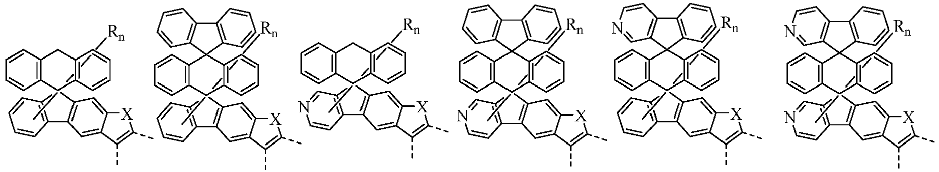 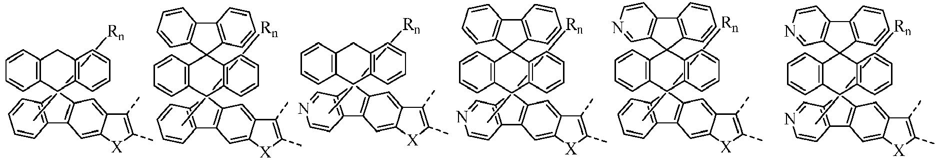 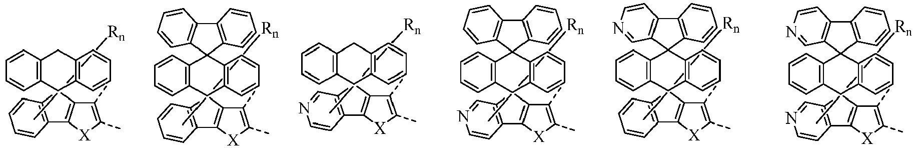 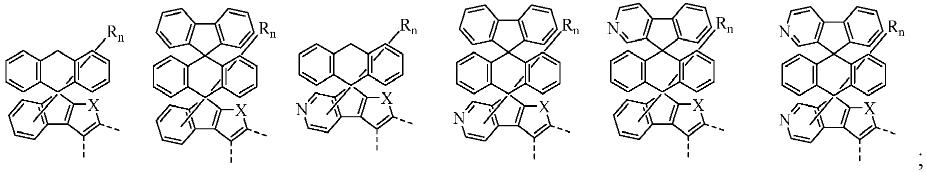
wherein R can be mono-substituted or multi-substituted according to the valence bond theory, and R is selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se;
the dashed line represents the attachment to N atom and the B atom in Formula (I) to form chemical bonds; and
undeuterated groups in the above structures can be partially or fully deuterated.

More preferably, the spiro compound of the present disclosure is selected from the group consisting of:

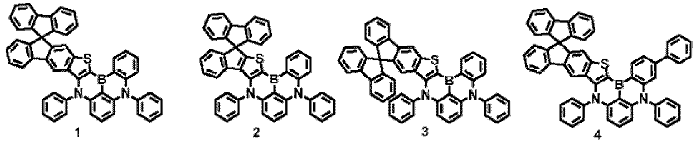

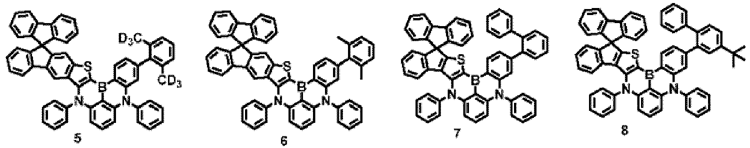

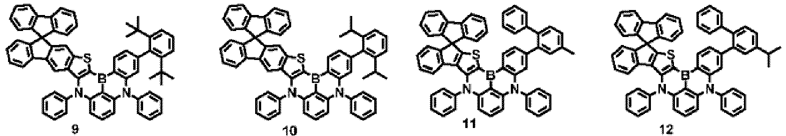

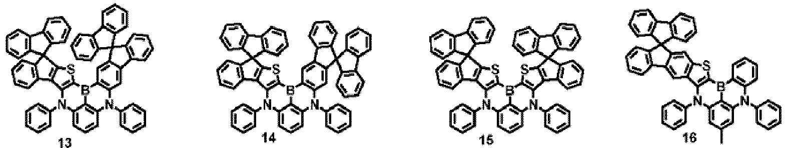

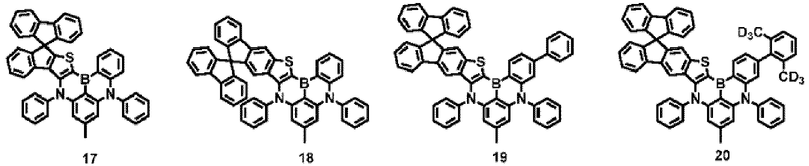

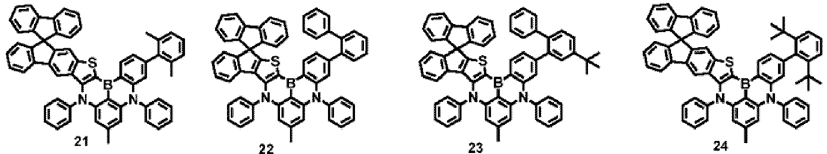

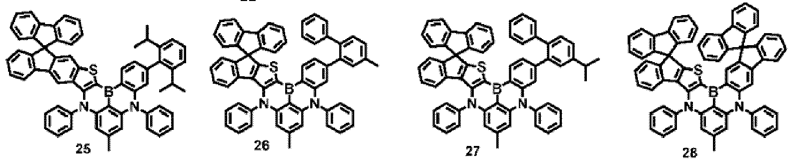

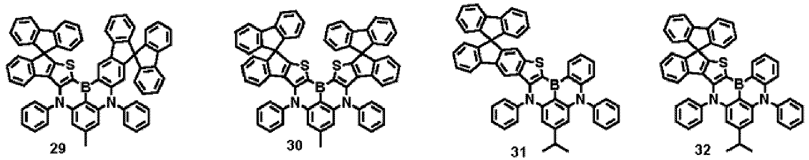

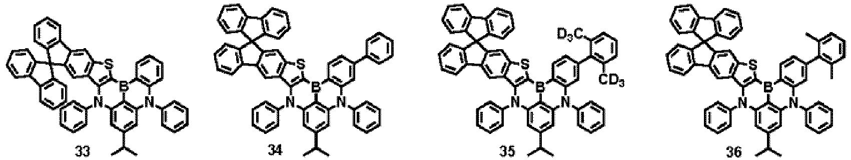

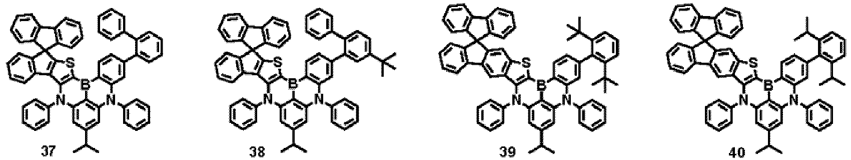

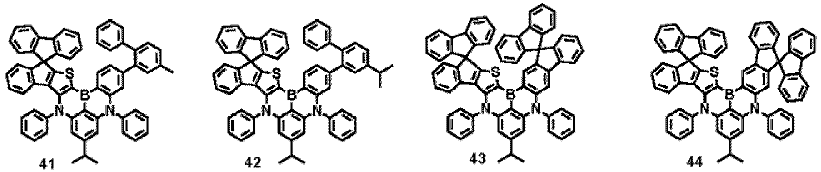

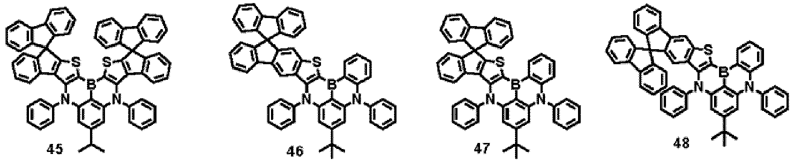

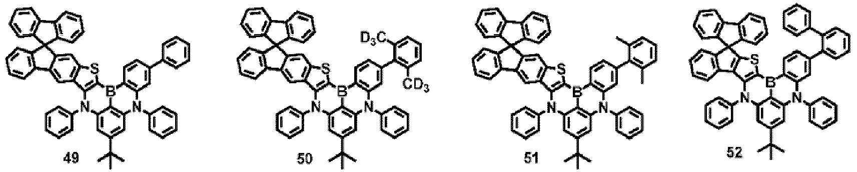

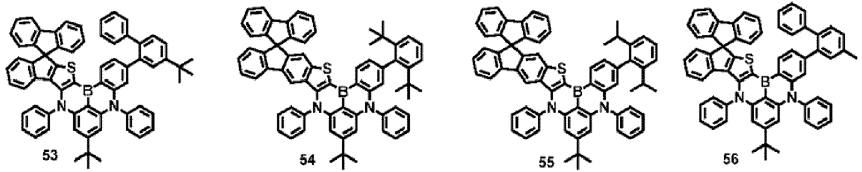

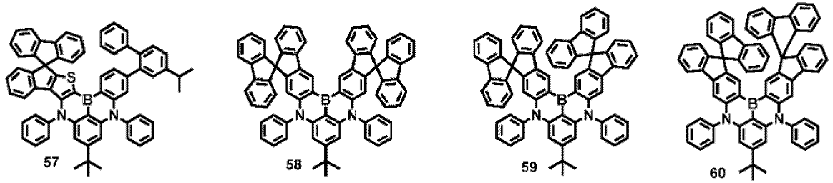

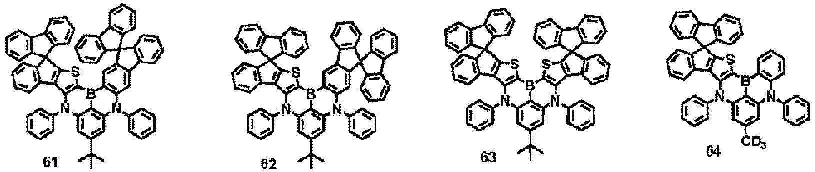

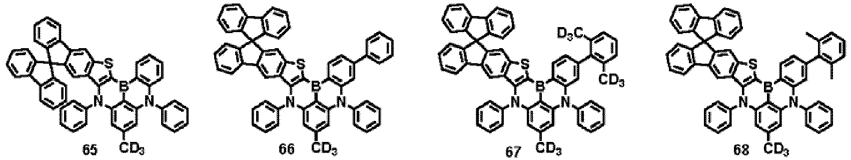

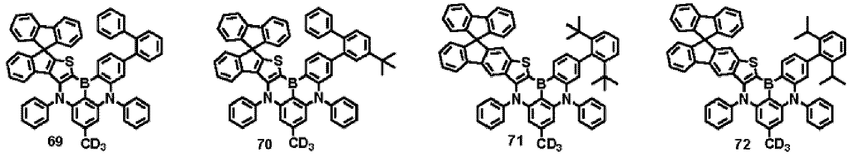

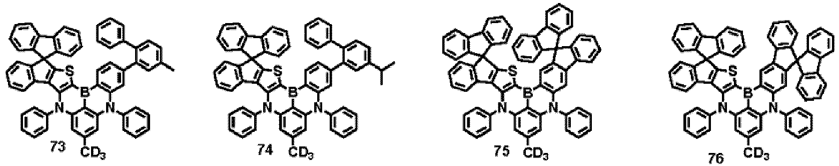

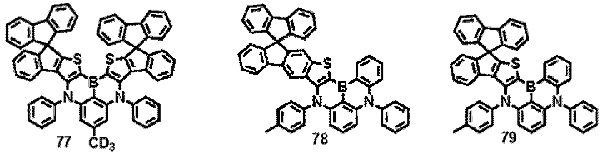

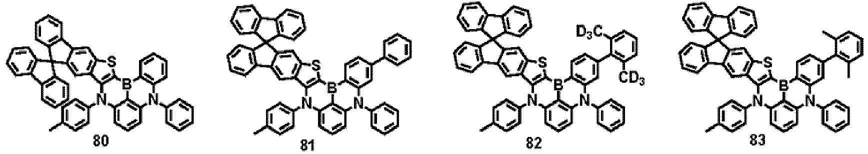

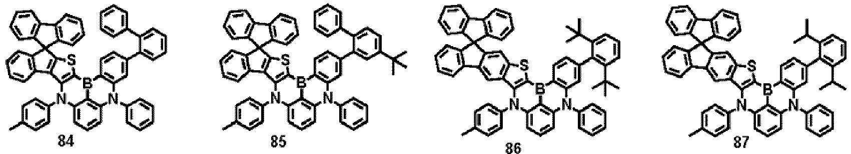

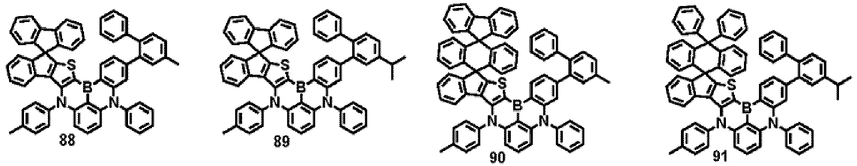

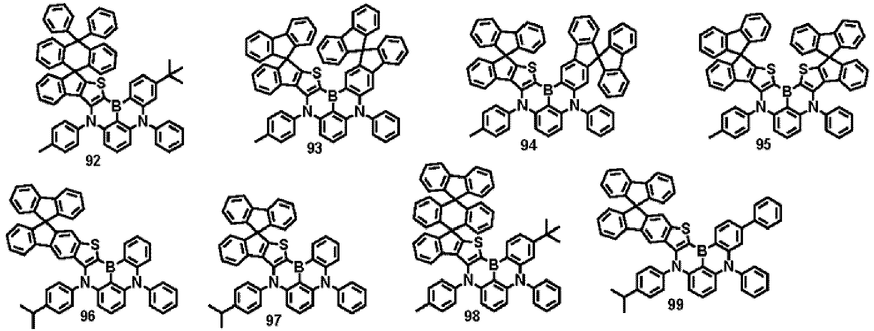

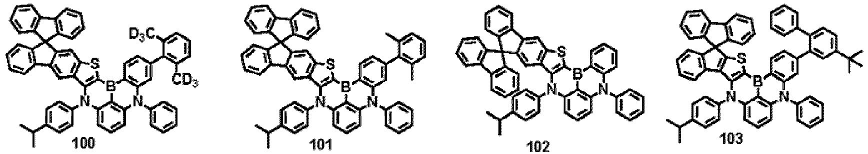

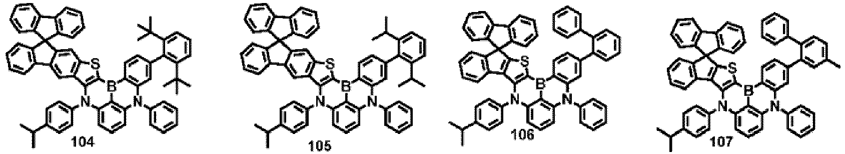

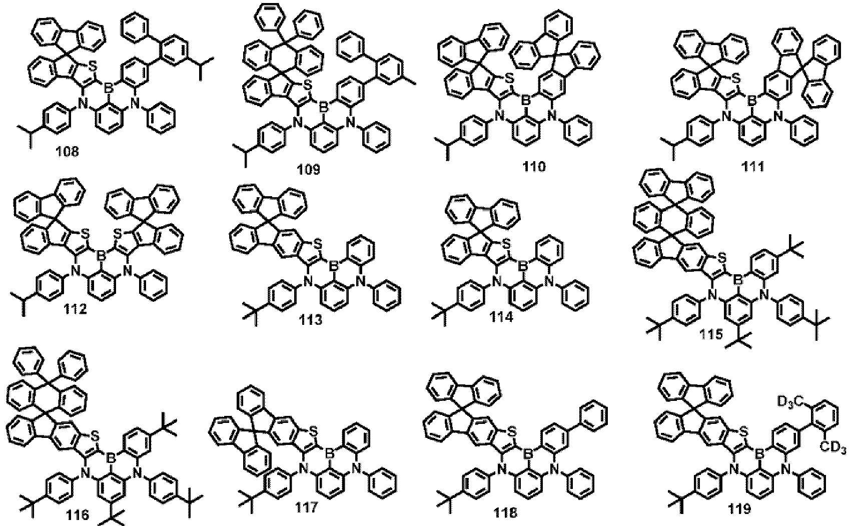

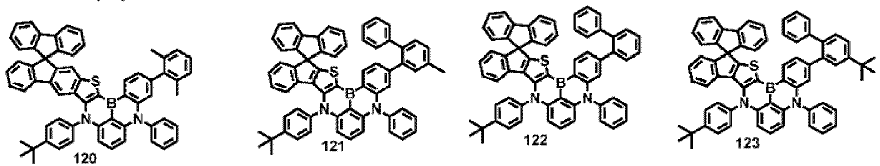

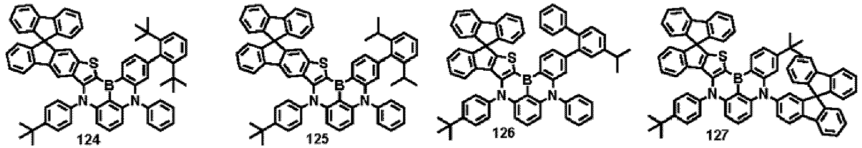

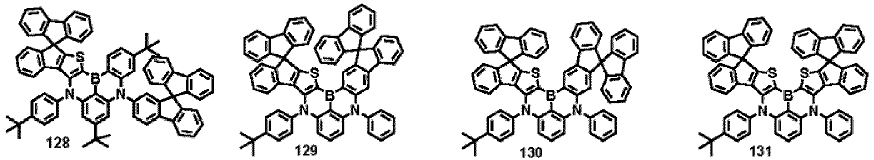

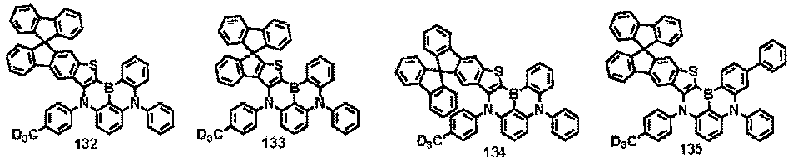

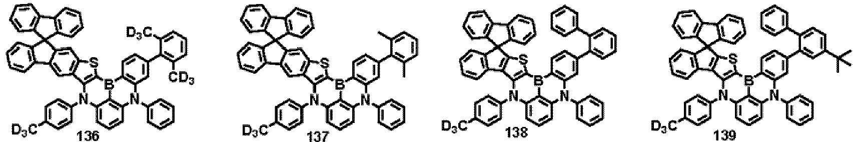

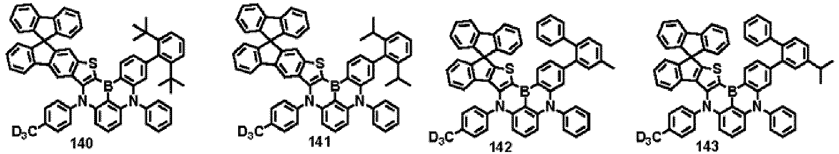

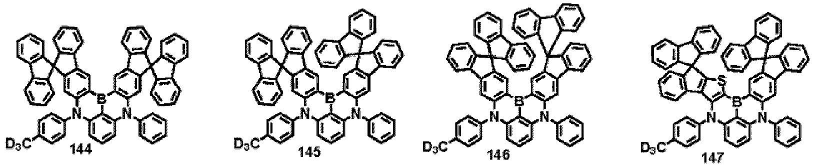

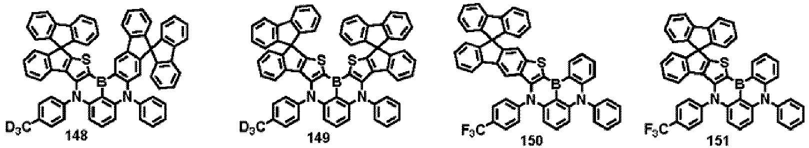

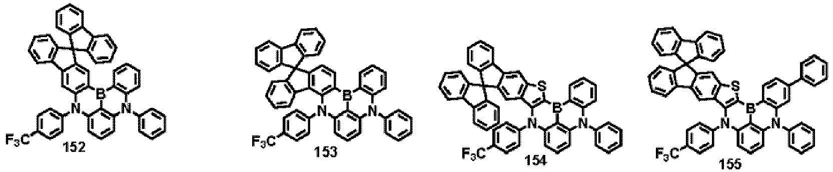

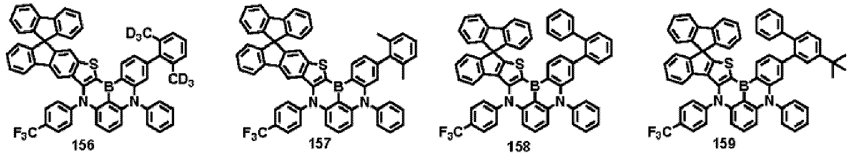

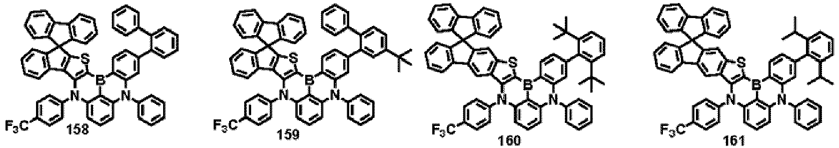

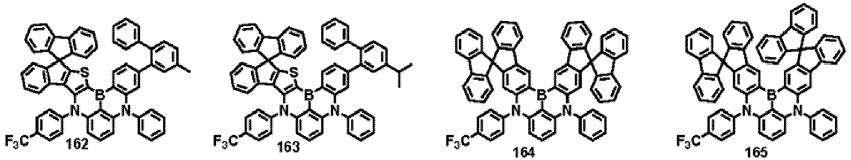

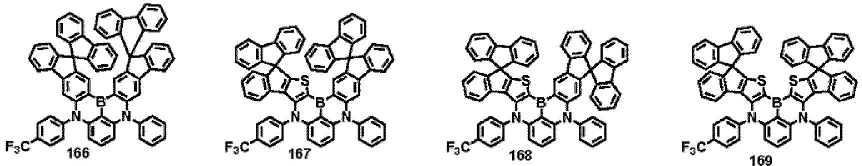

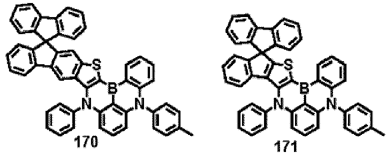

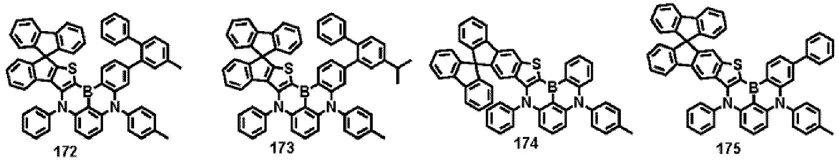

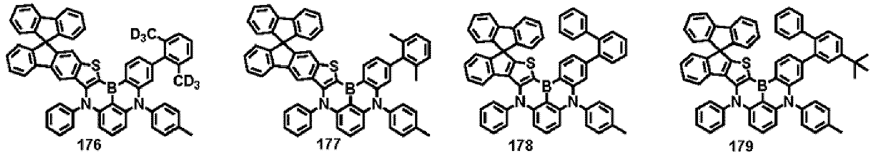

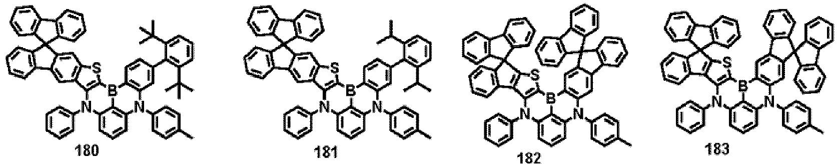

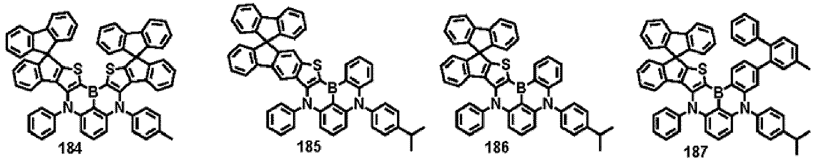

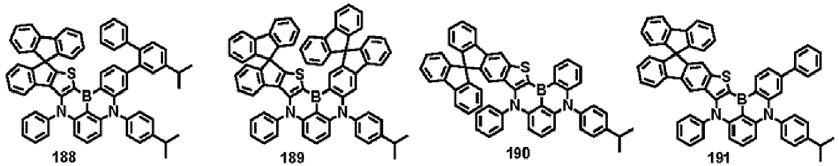

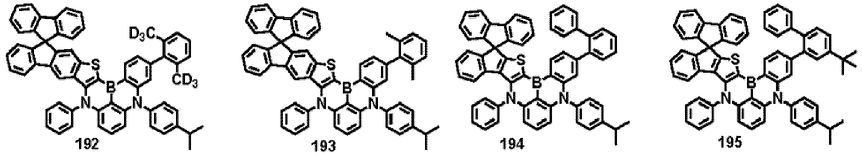

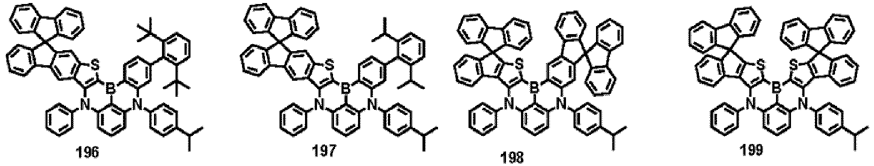

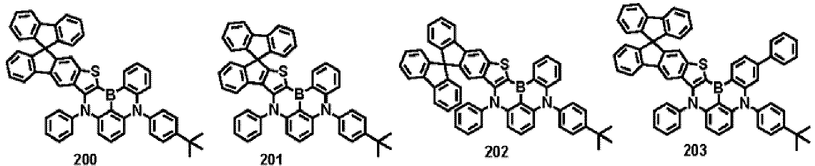

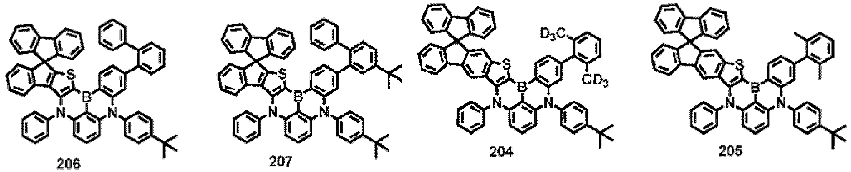

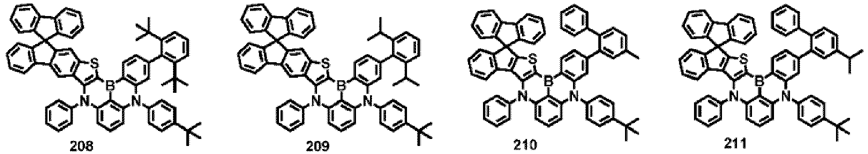

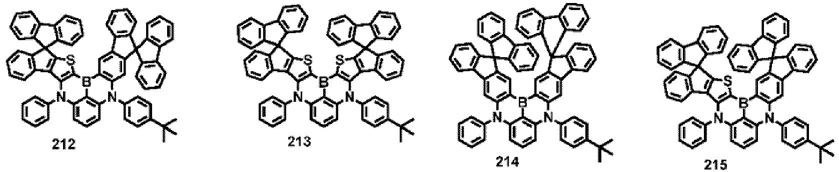

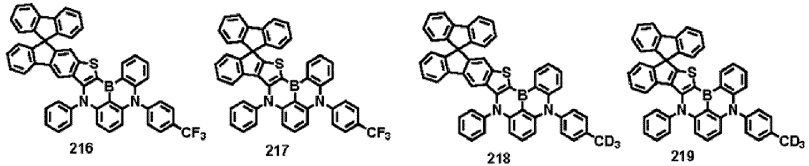

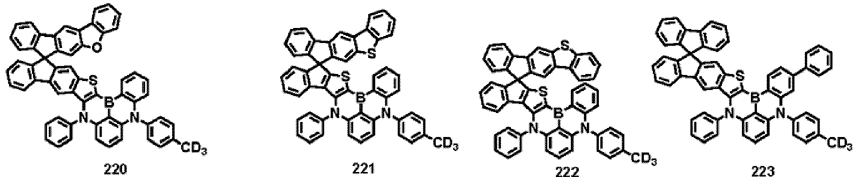

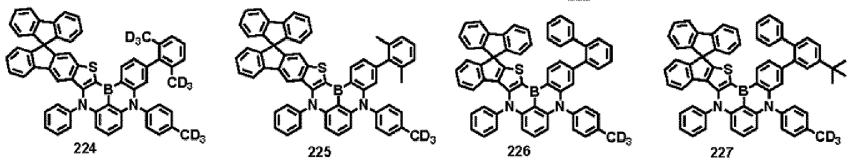

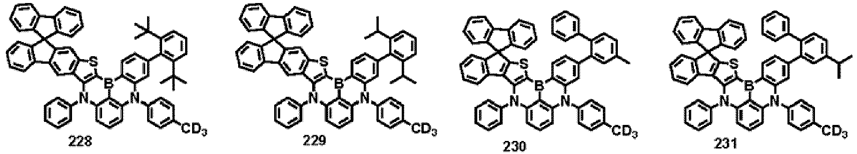

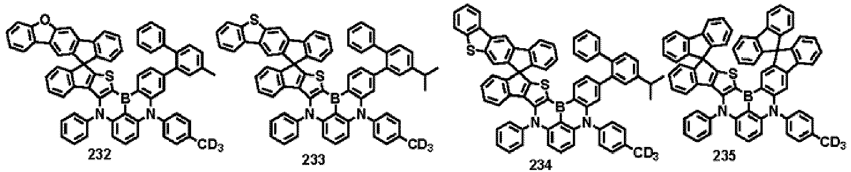

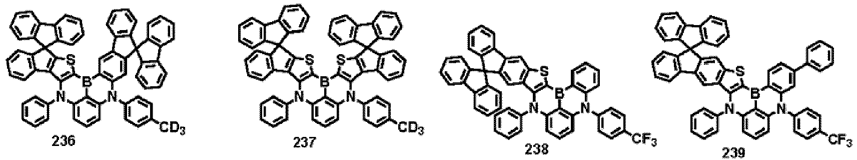

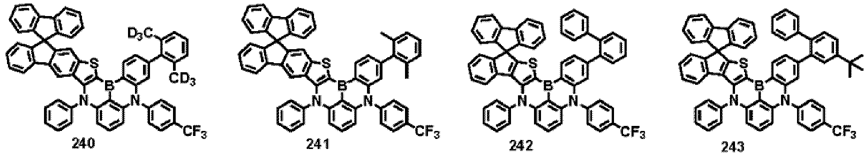

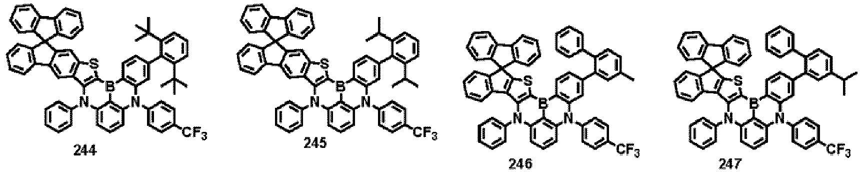

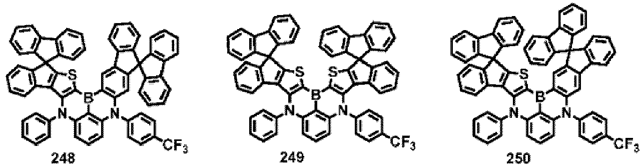

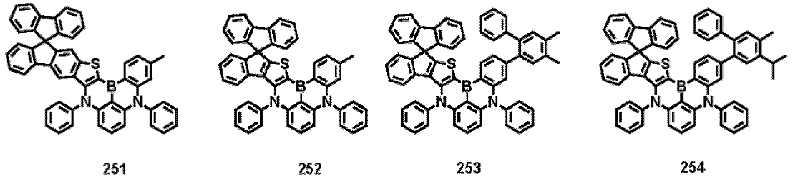

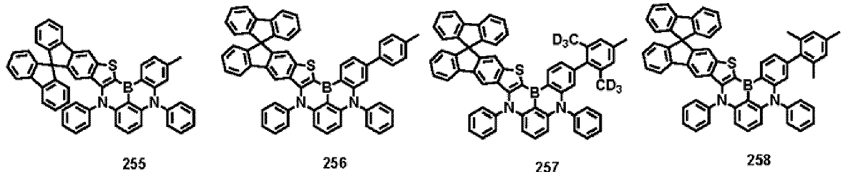

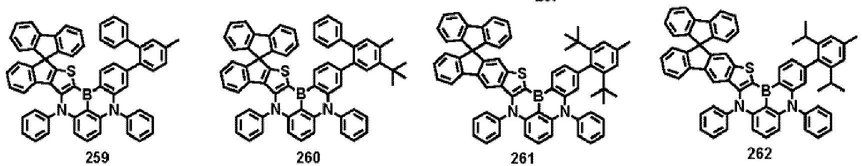

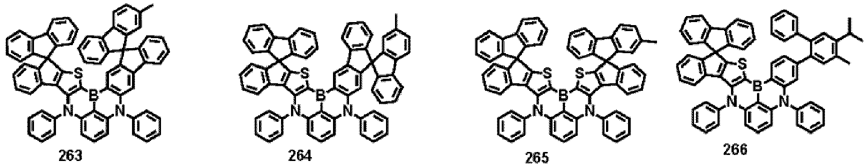

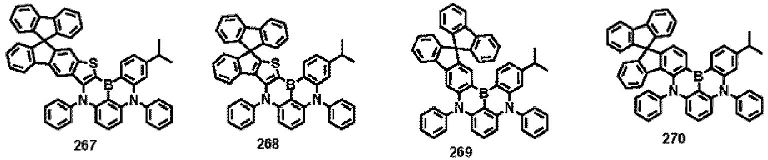

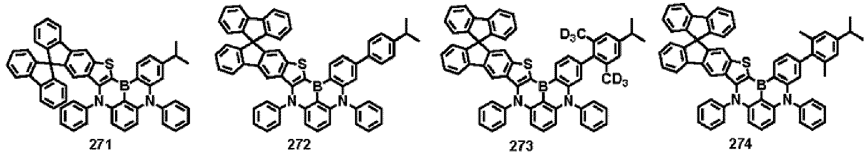

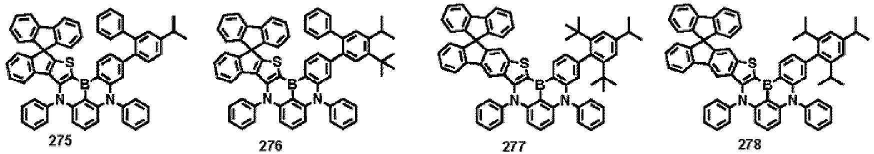

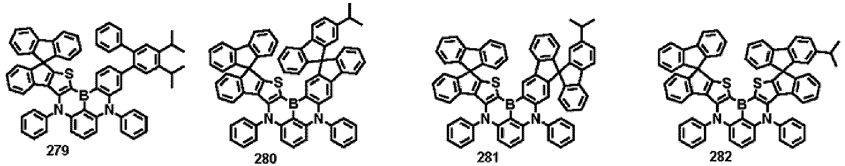

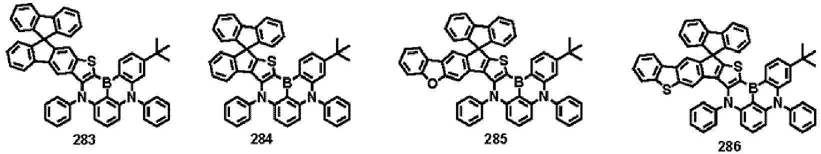

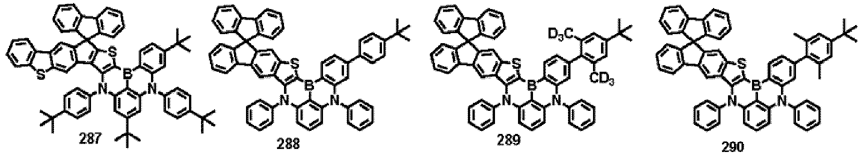

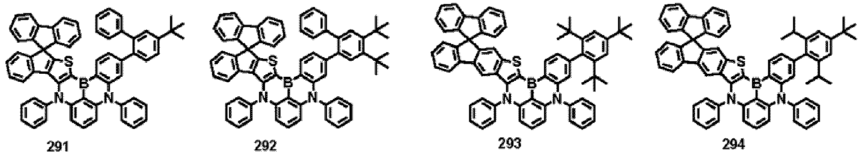

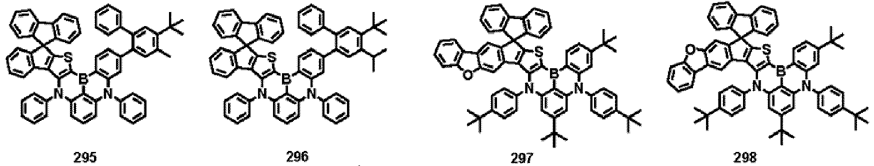

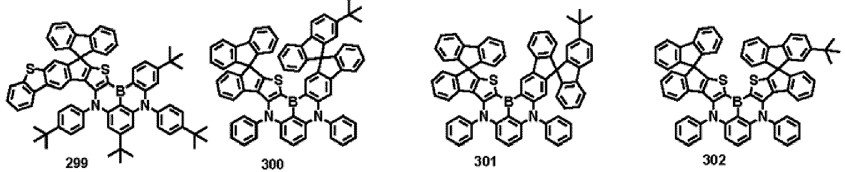

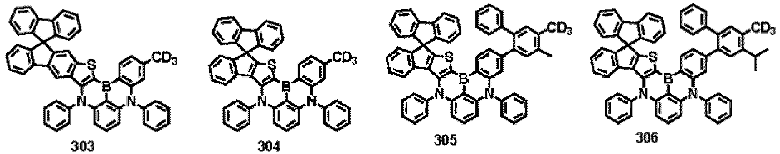

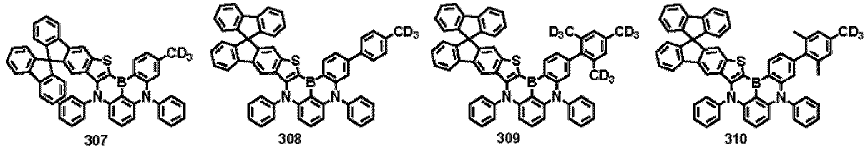

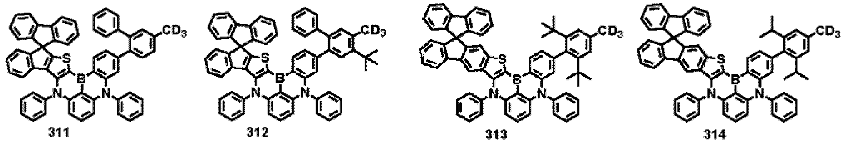

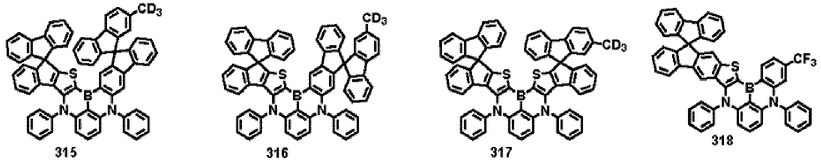

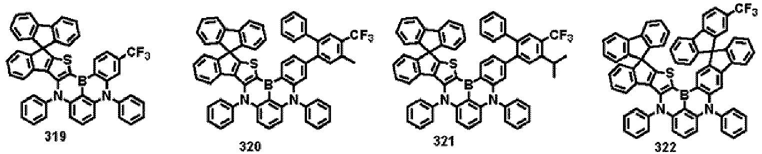

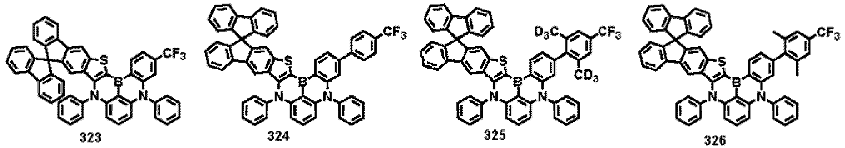

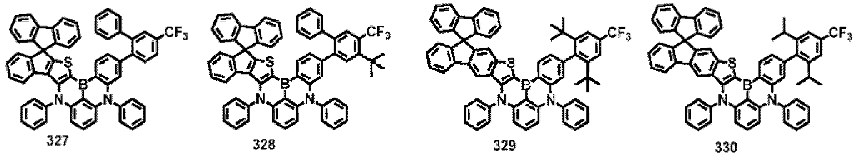

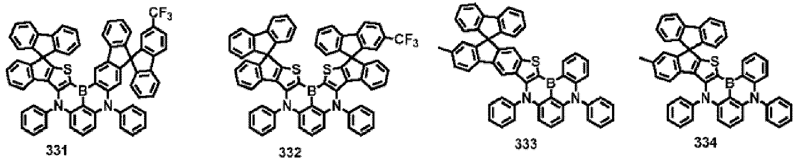

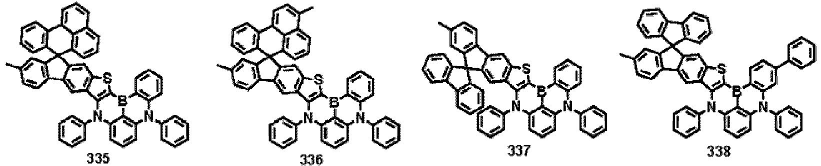

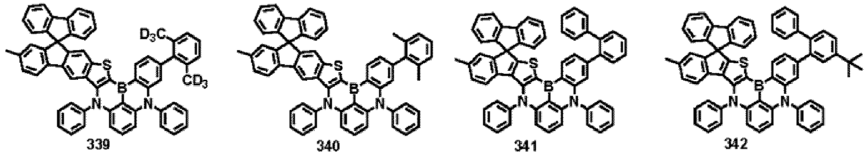

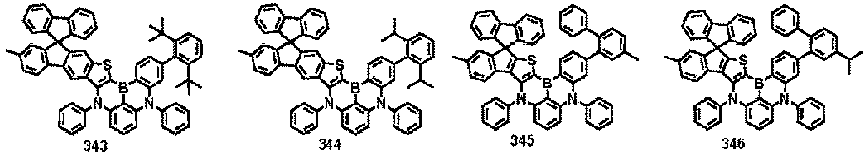

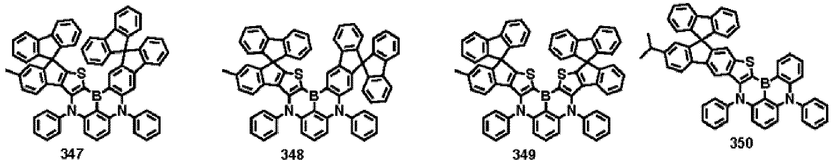

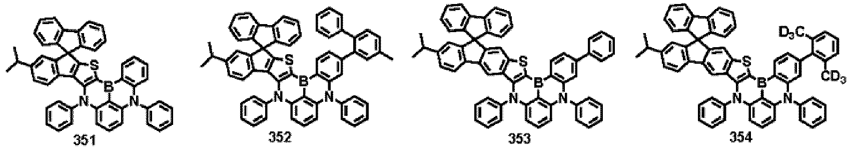

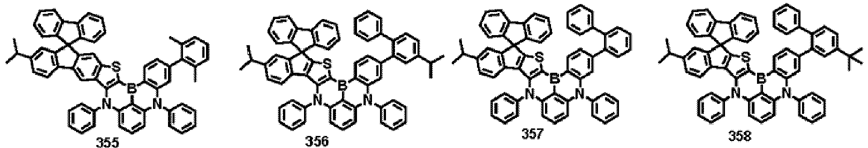

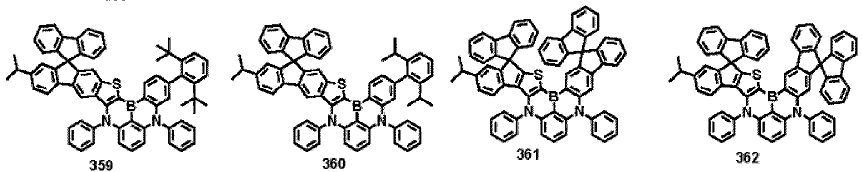

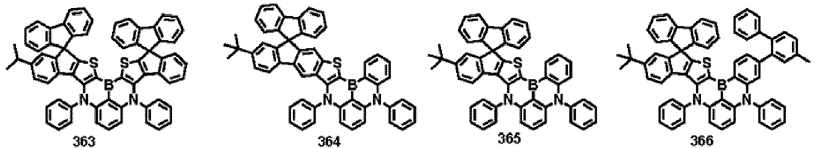

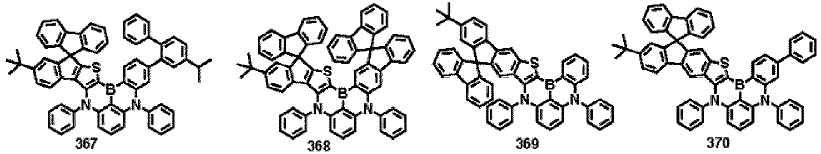

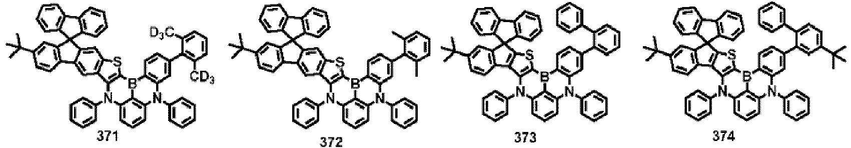

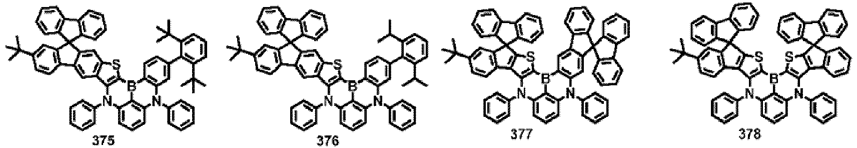

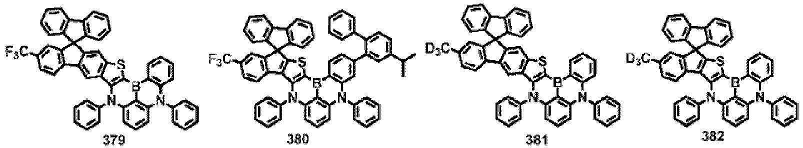

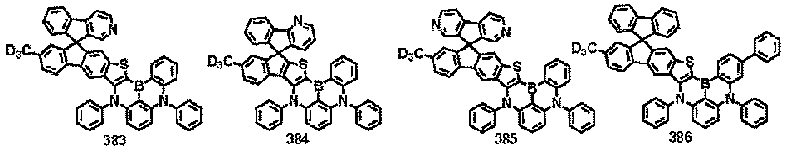

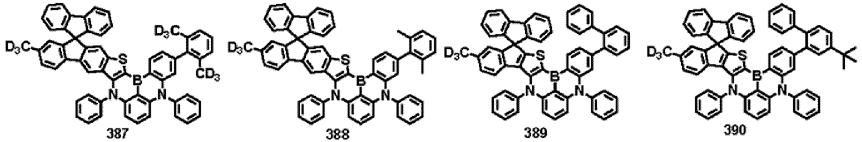

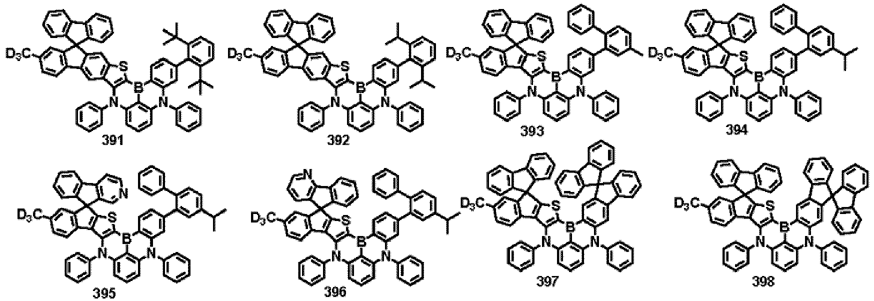

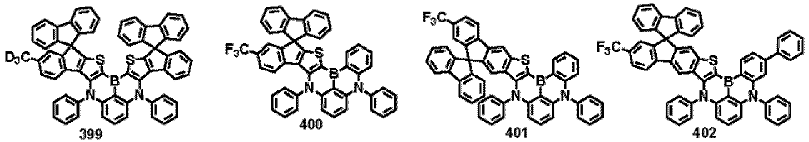

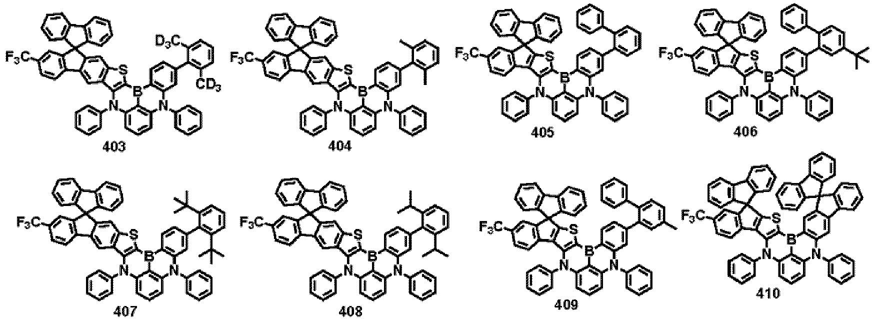

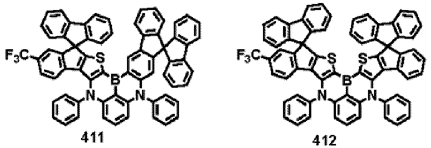

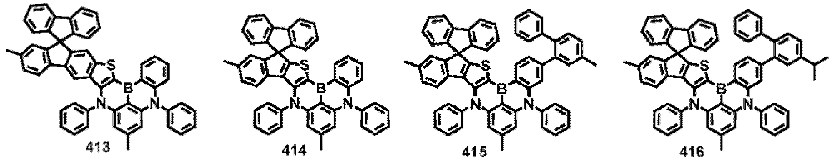

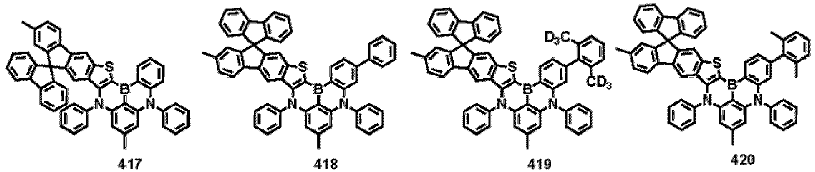

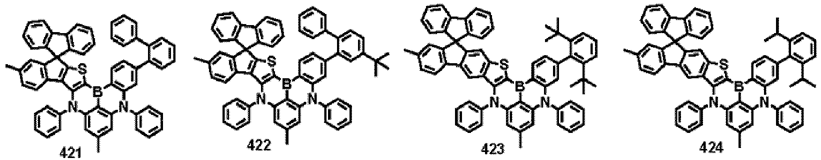

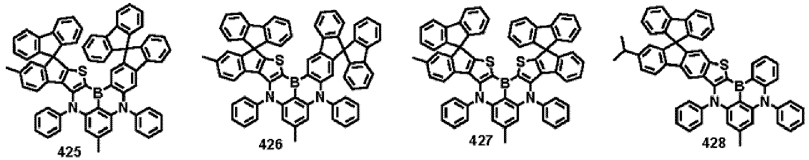

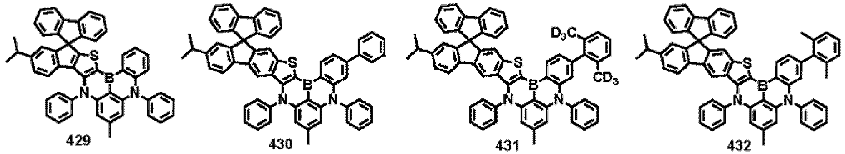

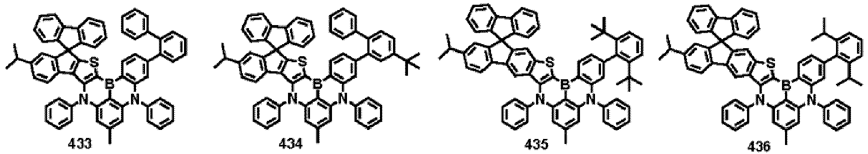

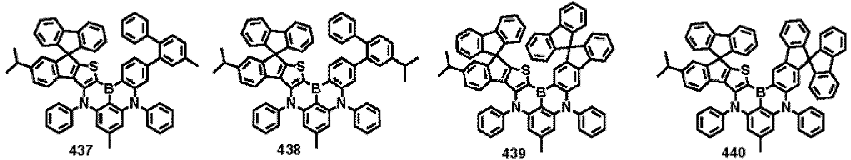

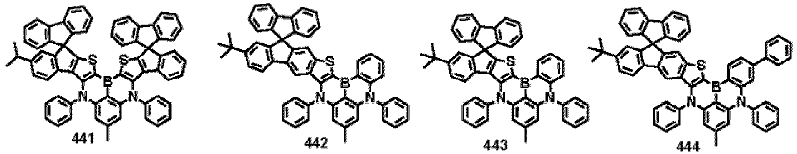

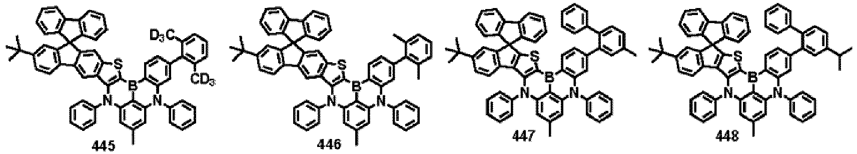

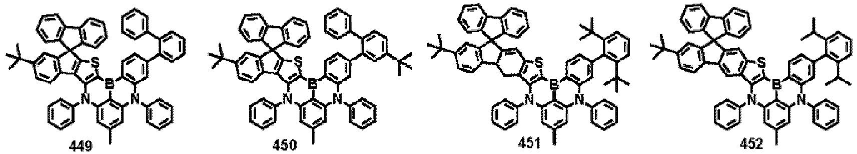

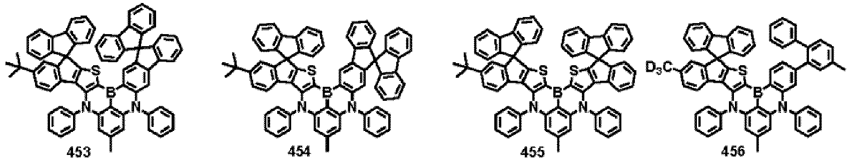

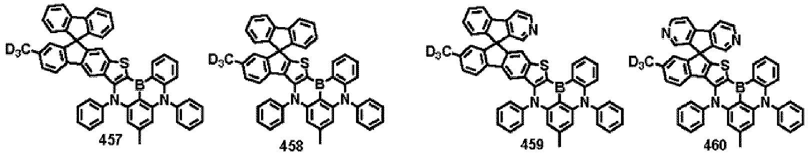

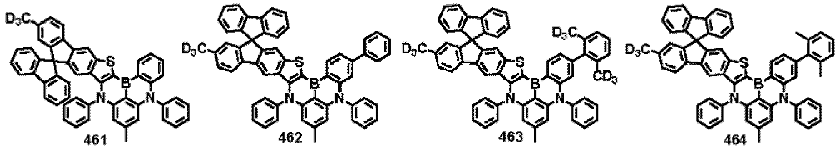

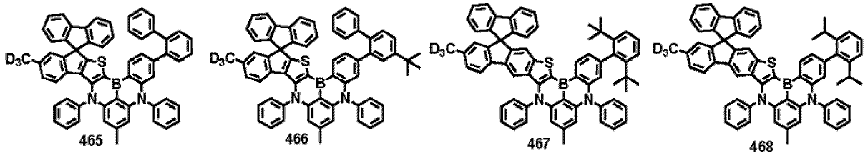

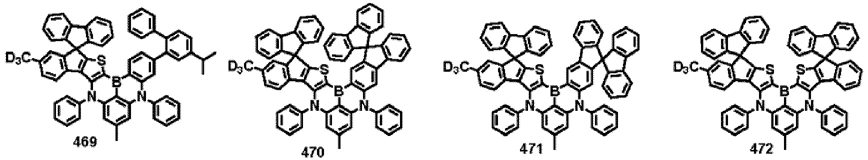

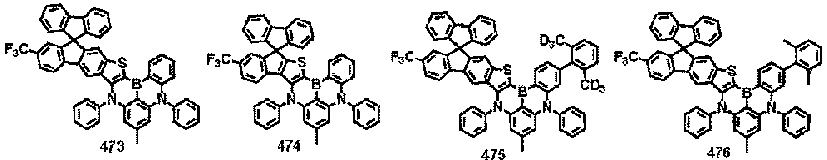

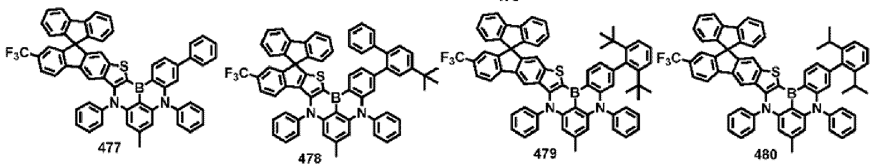

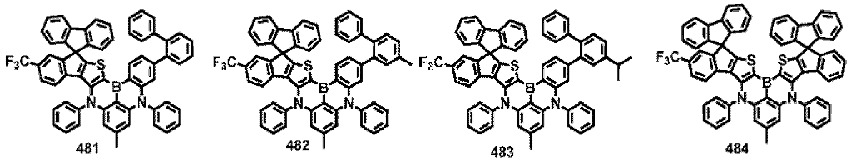

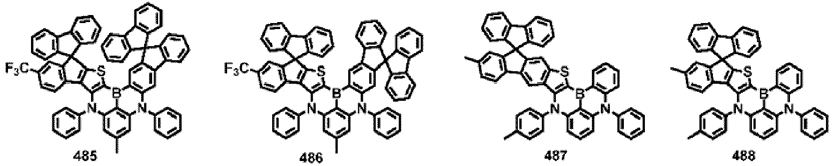

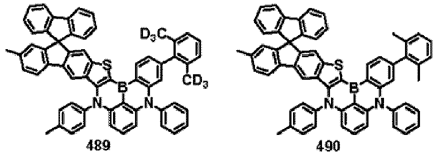

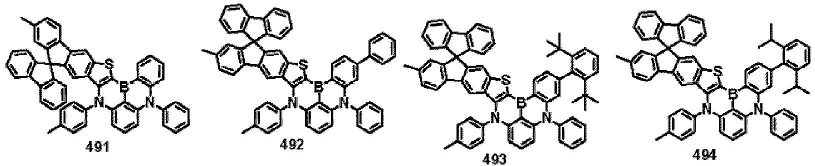

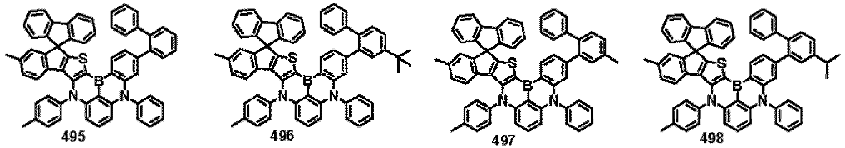

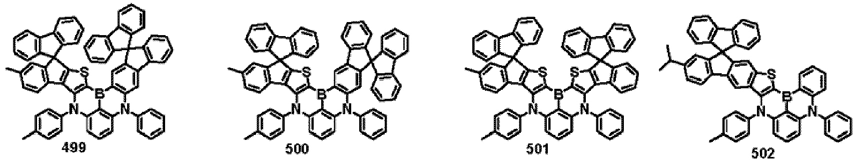

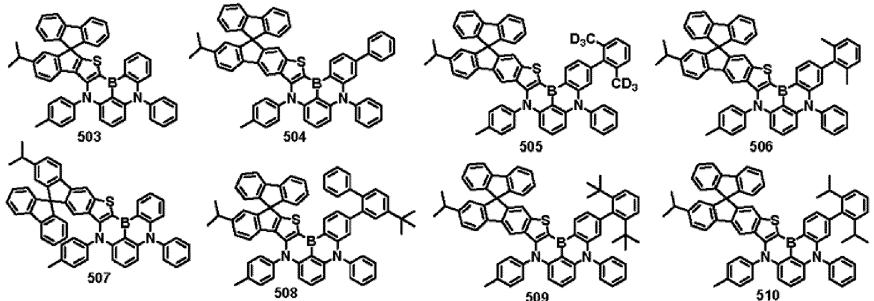

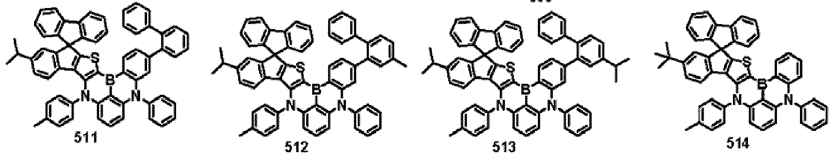

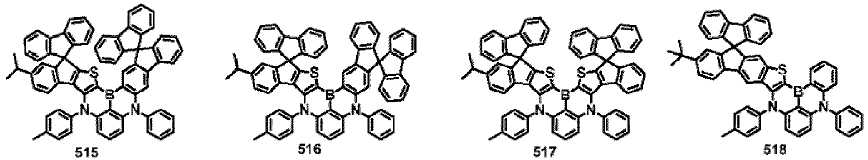

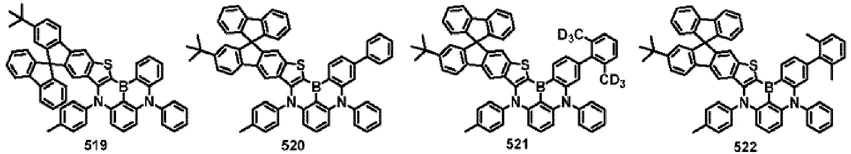

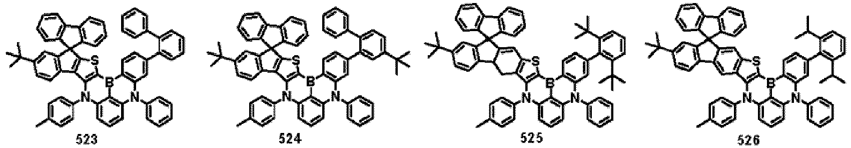

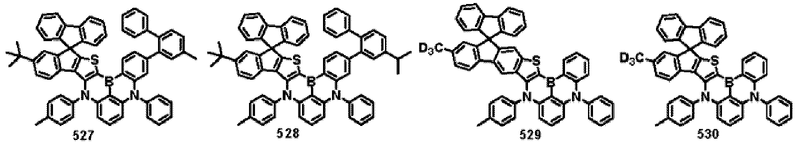

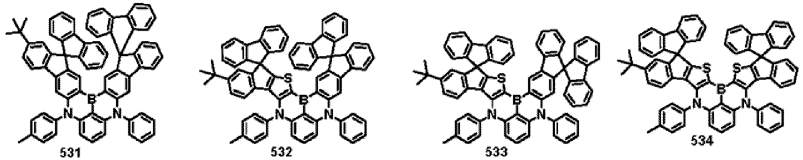

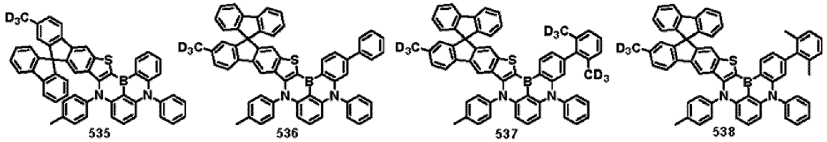

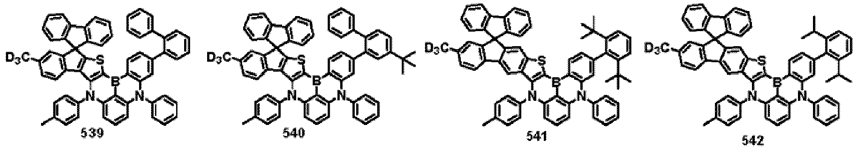

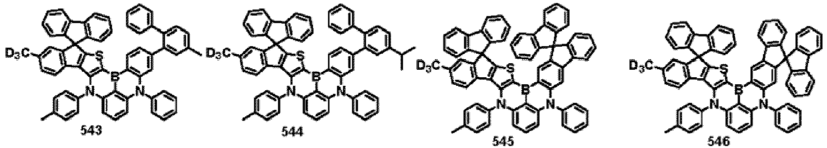

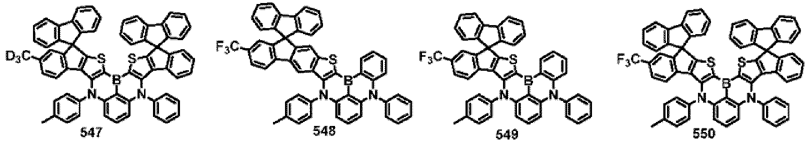

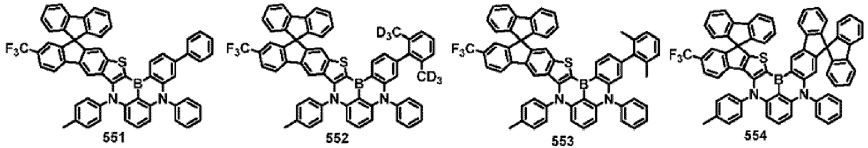

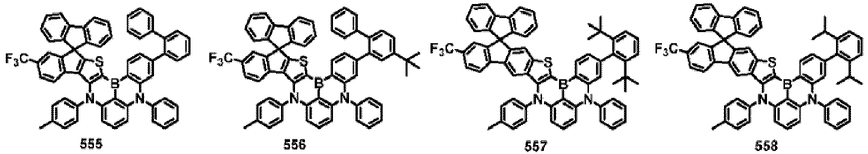

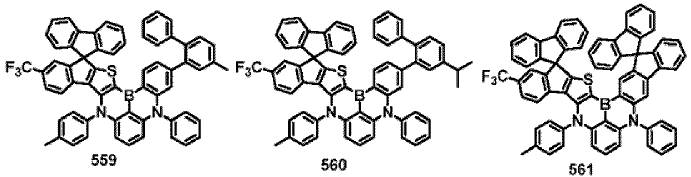

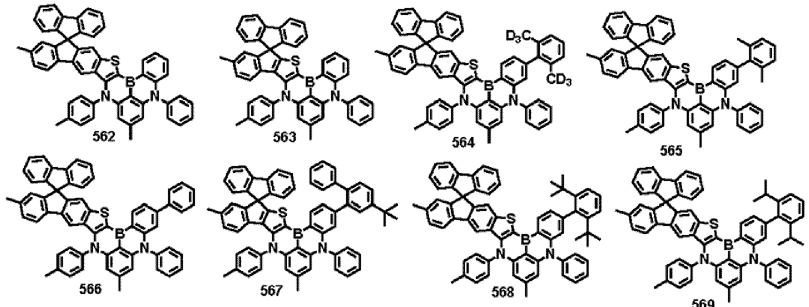

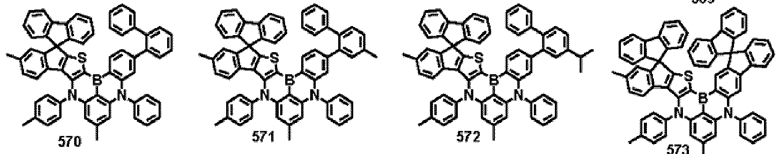

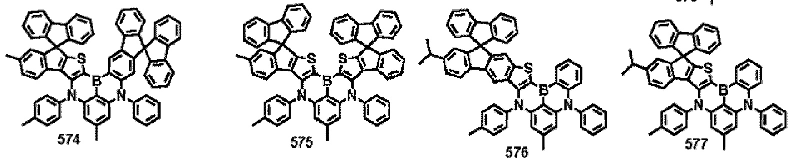

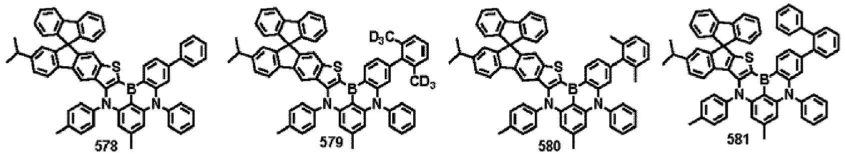

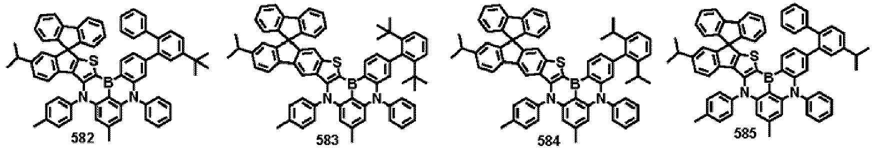

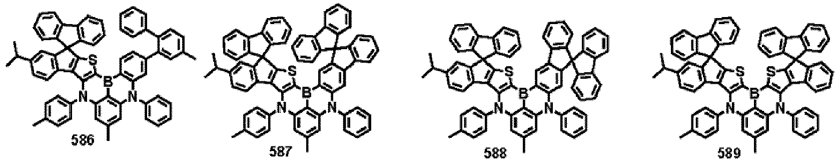

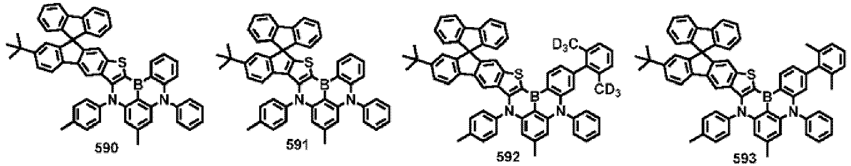

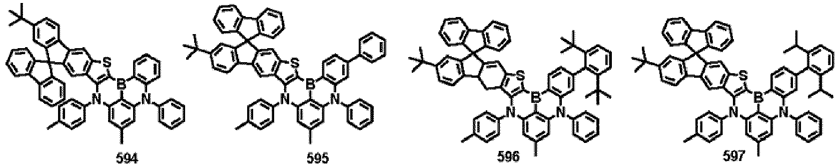

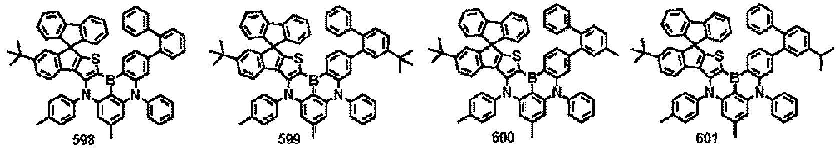

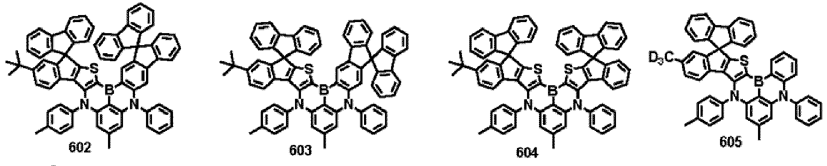

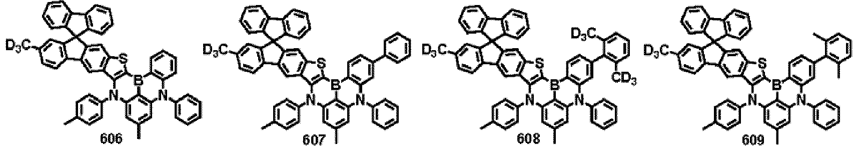

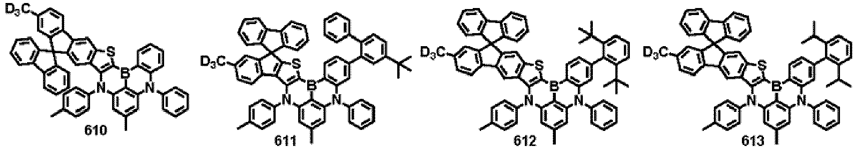

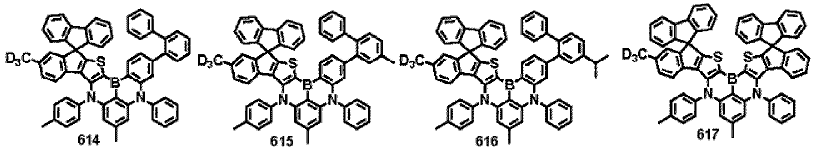

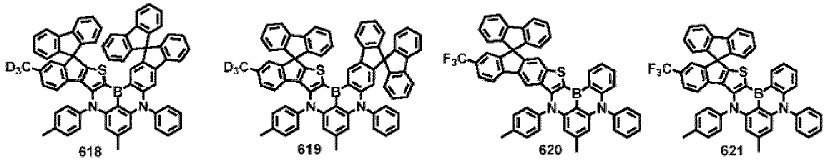

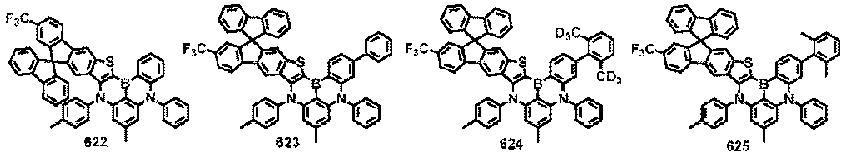

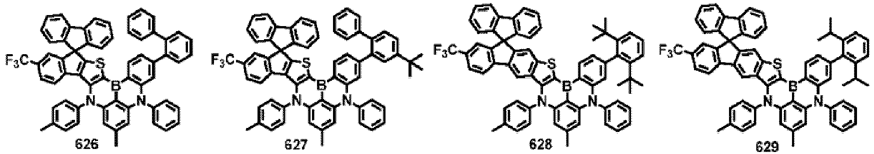

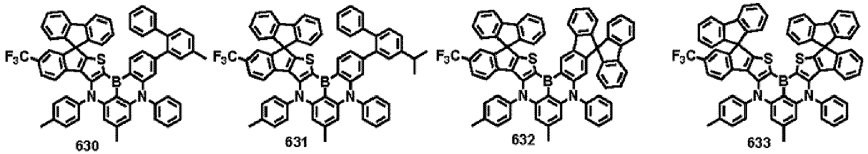

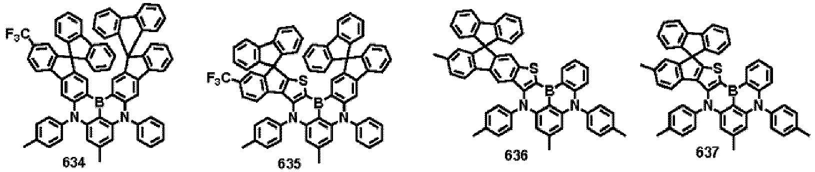

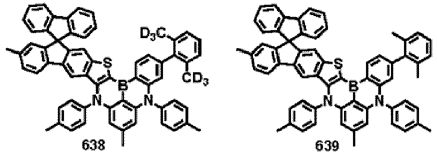

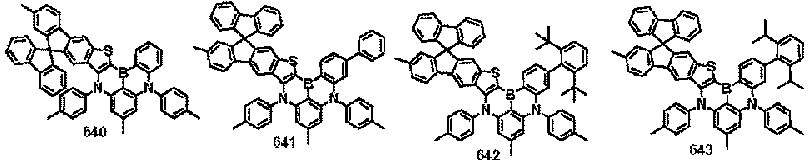

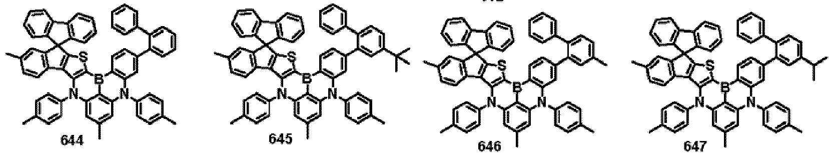

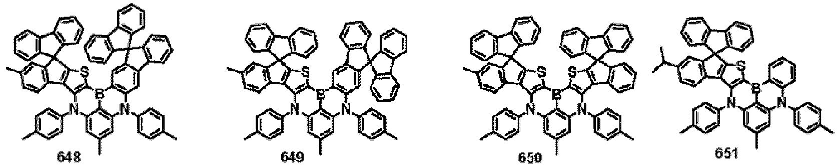

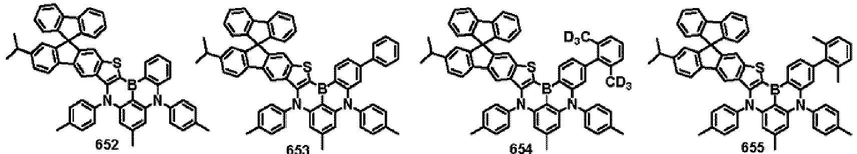

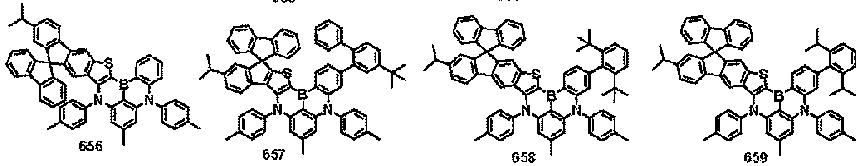

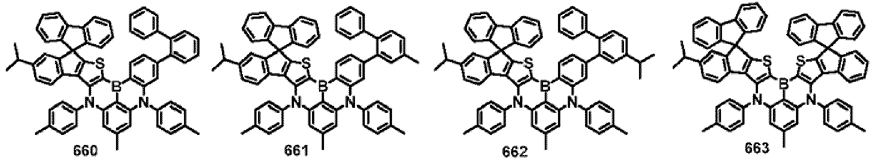

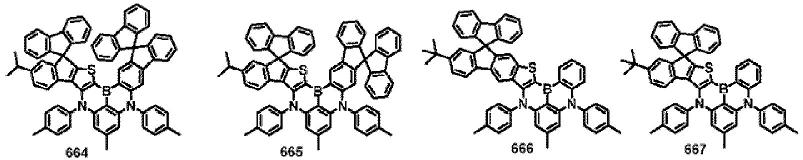

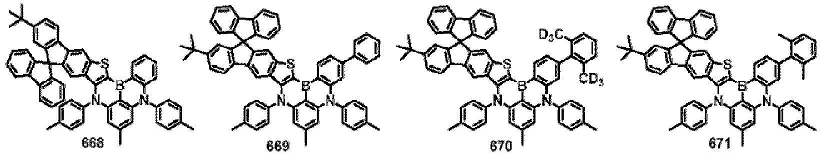

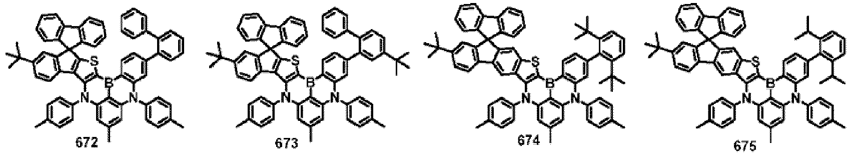

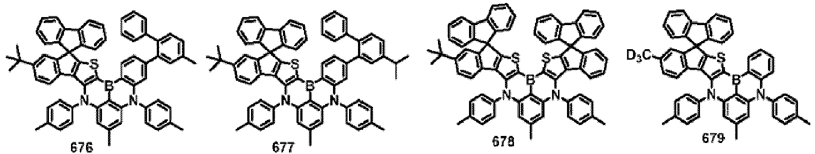

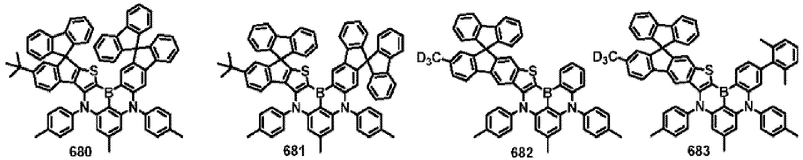

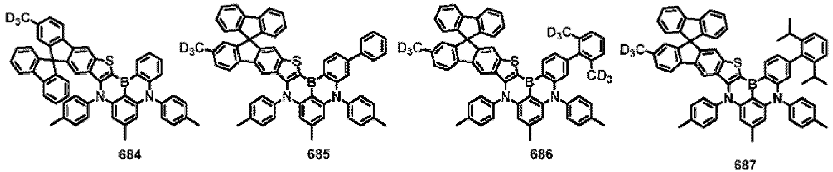

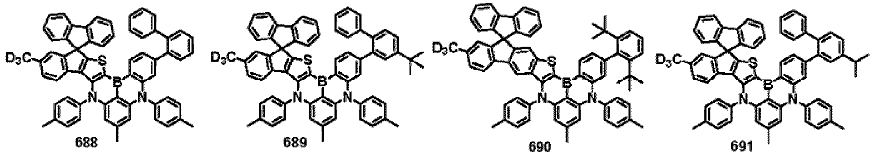

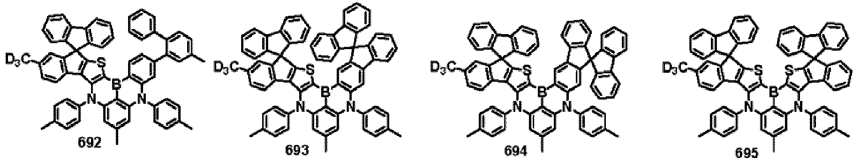

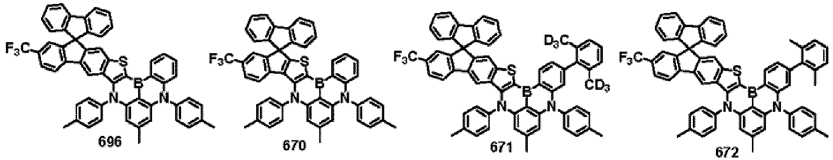

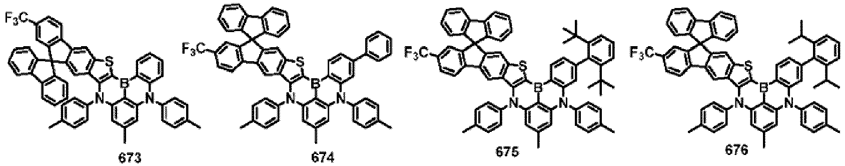

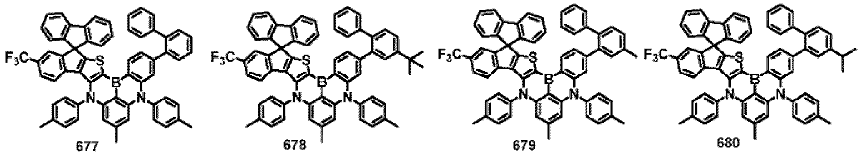

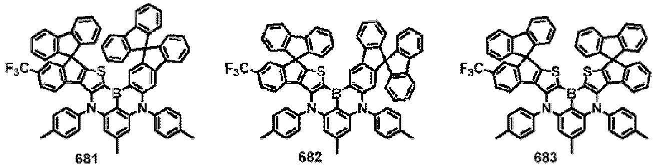

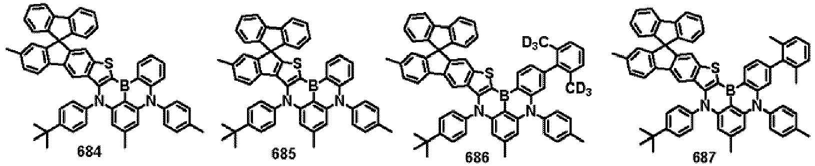

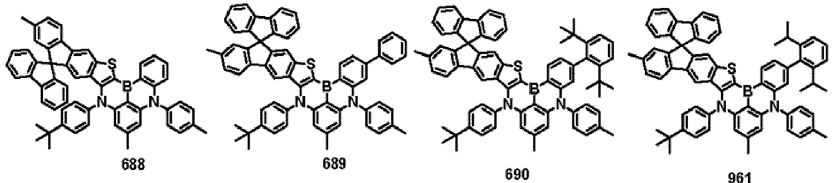

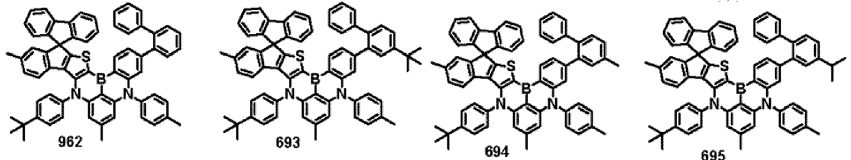

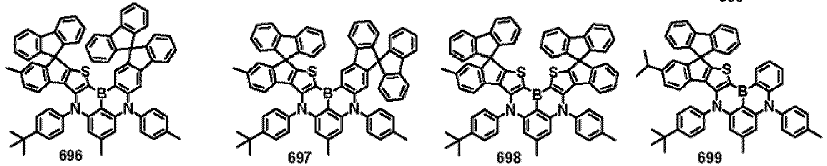

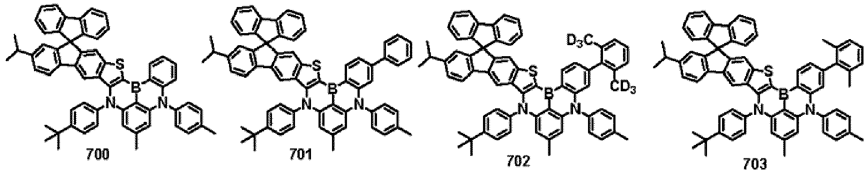

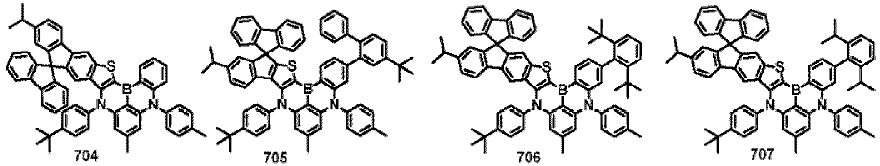

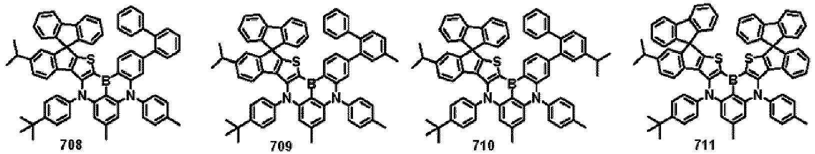

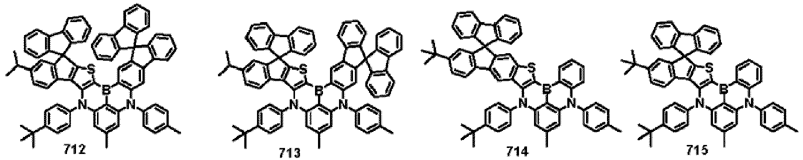

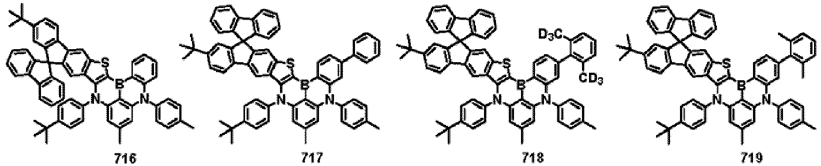

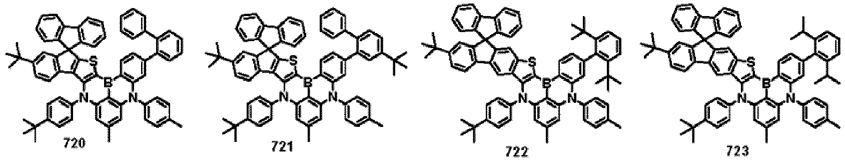

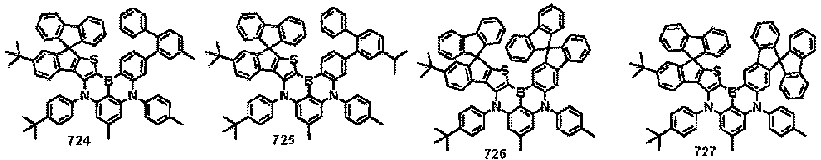

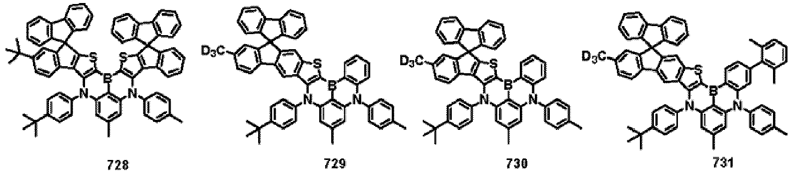

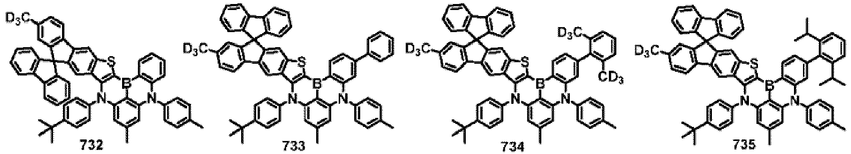

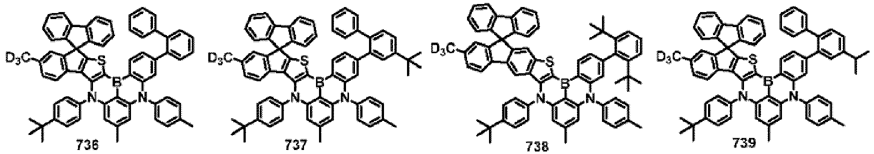

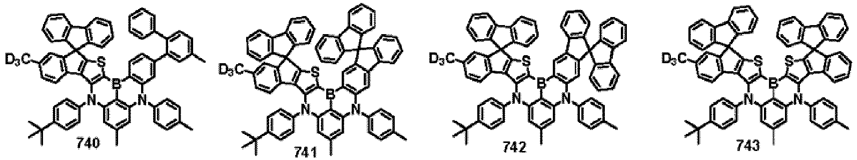

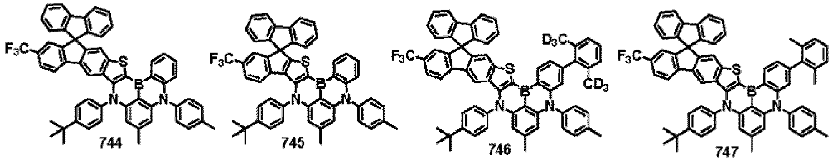

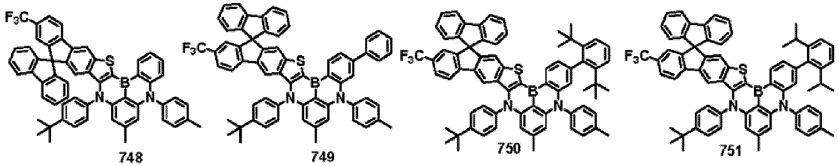

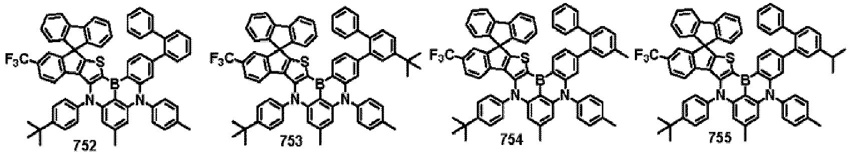

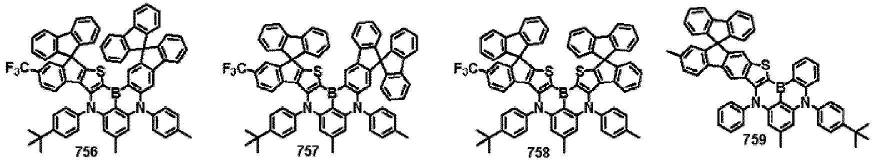

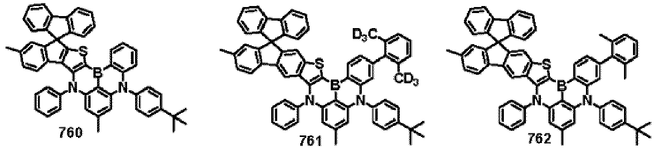

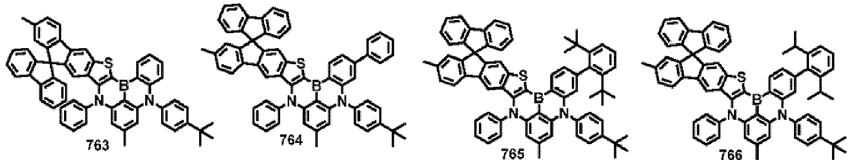

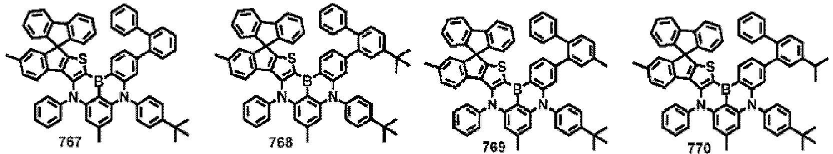

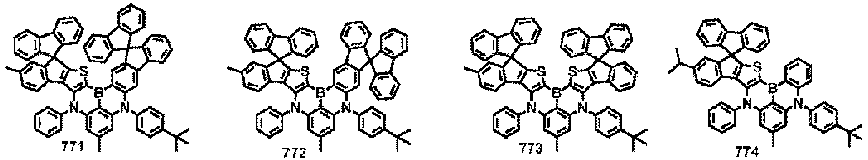

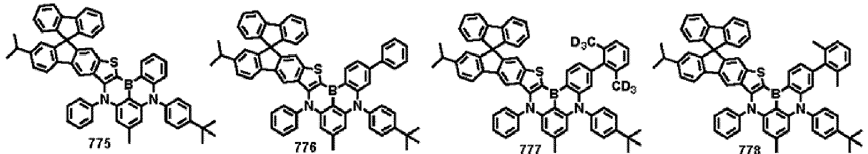

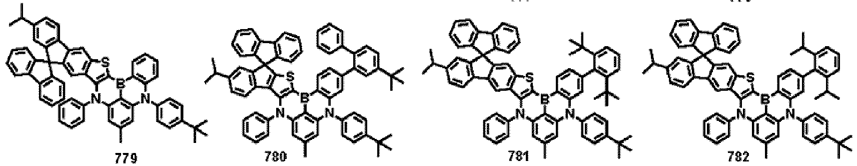

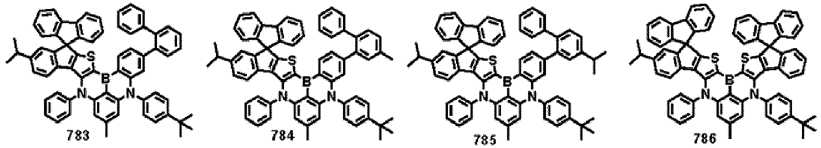

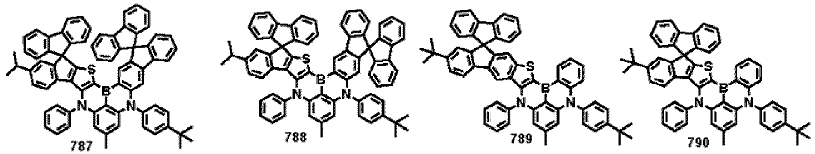

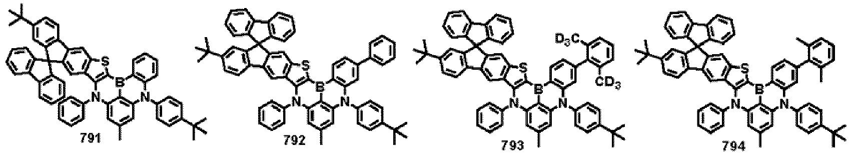

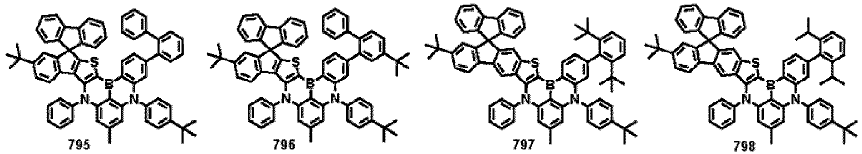

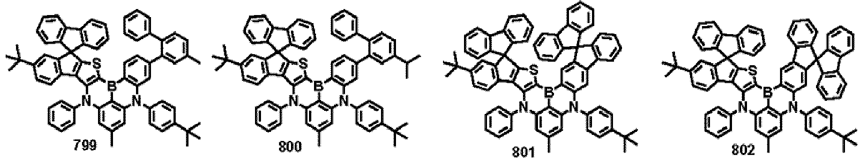

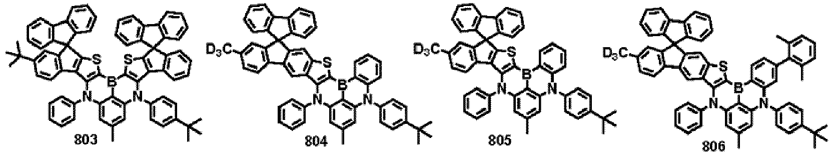

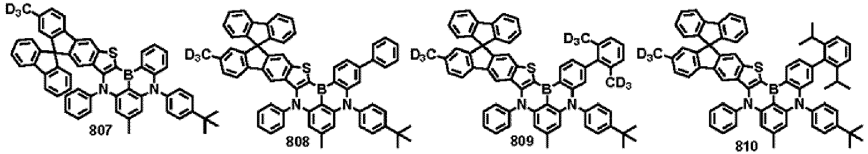

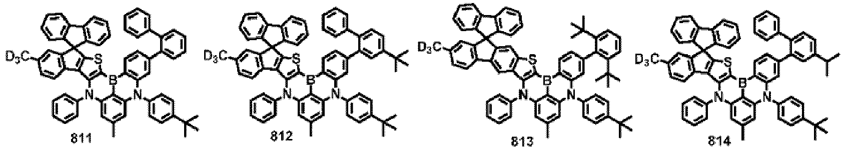

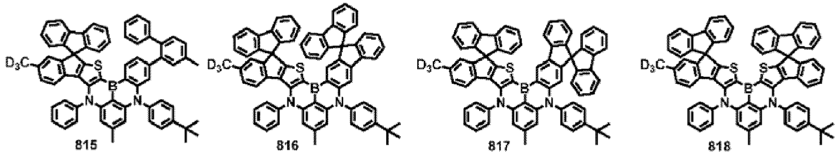

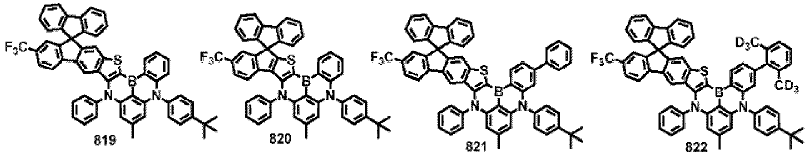

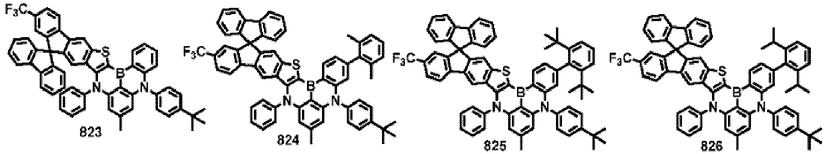

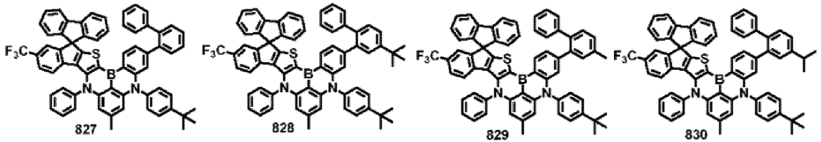

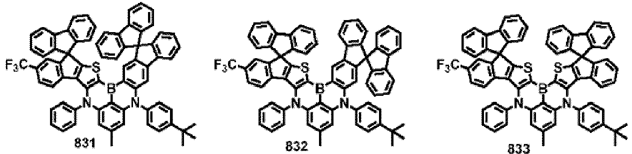

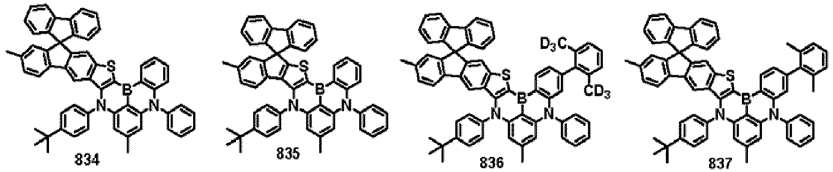

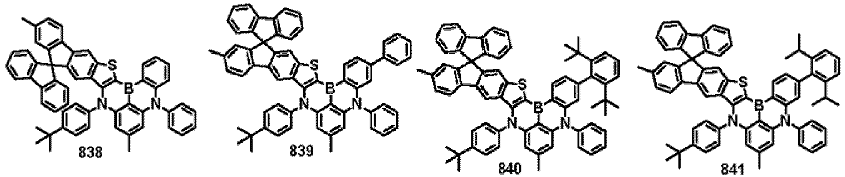

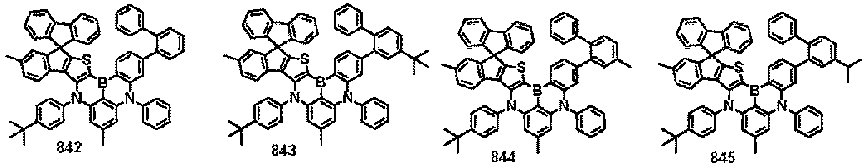

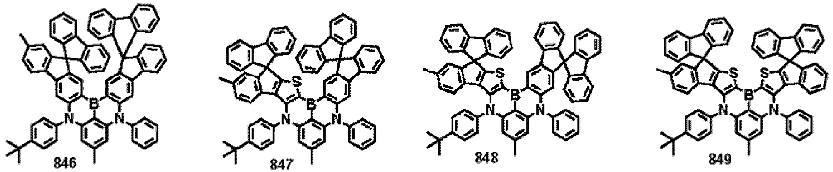

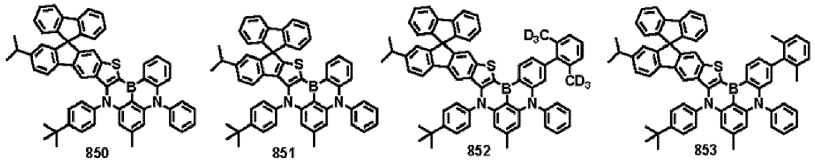

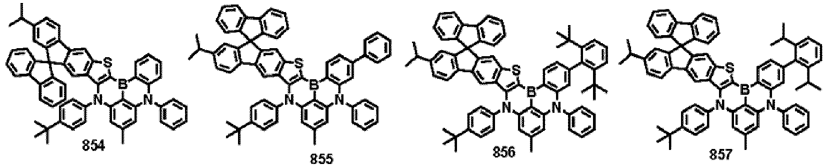

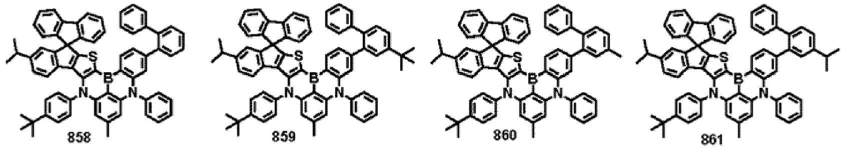

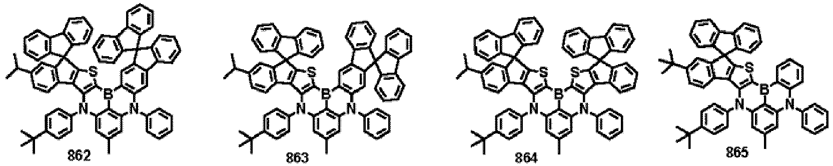

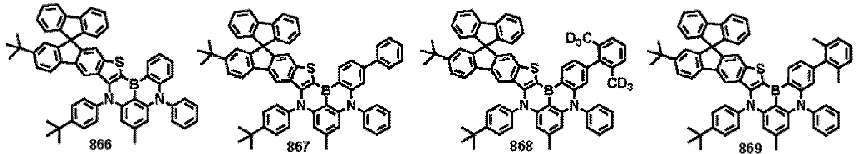

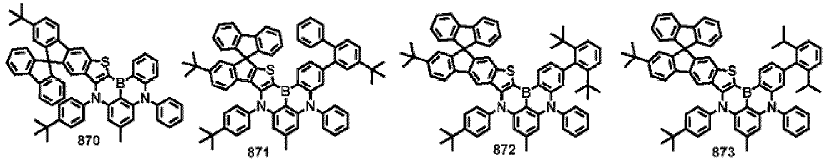

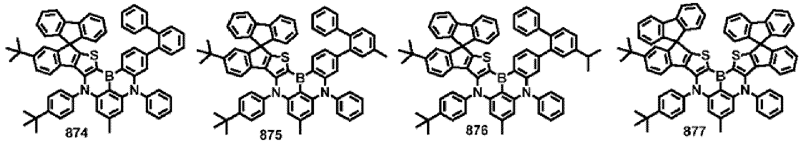

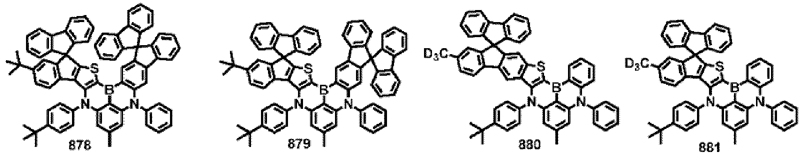

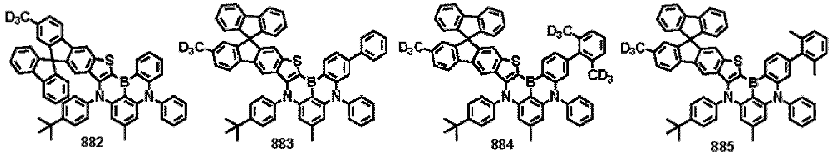

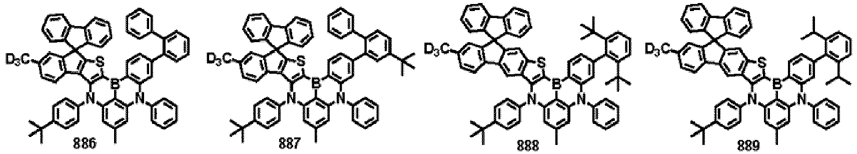

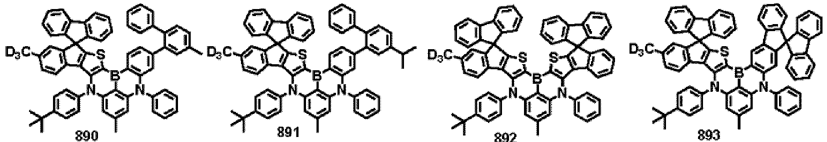

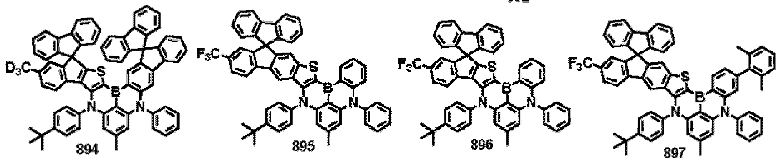

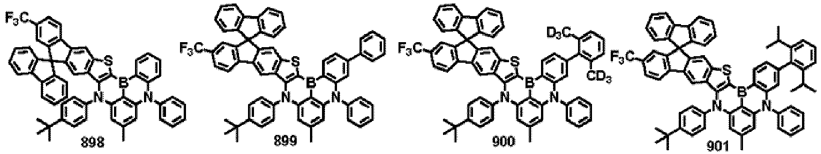

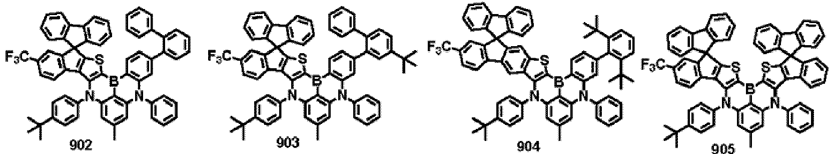

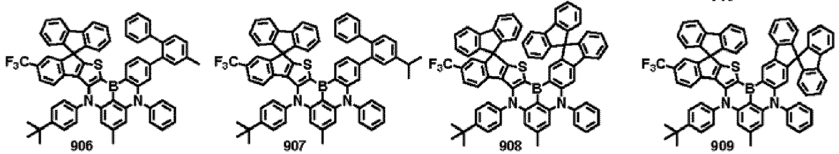

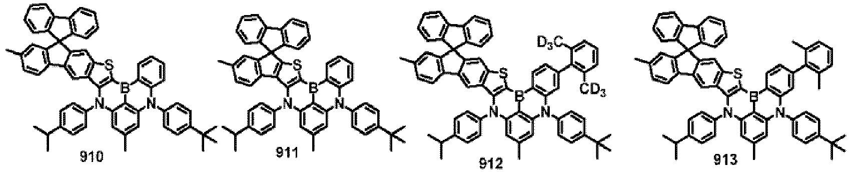

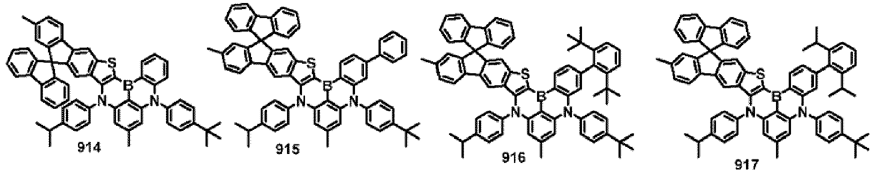

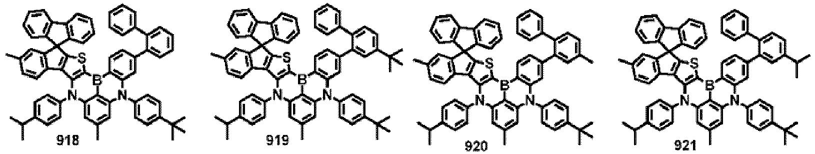

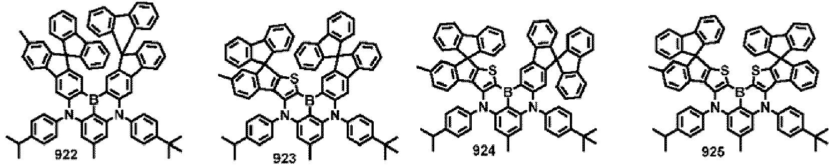

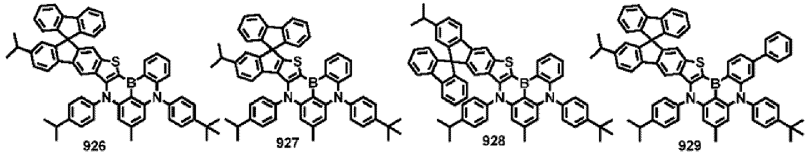

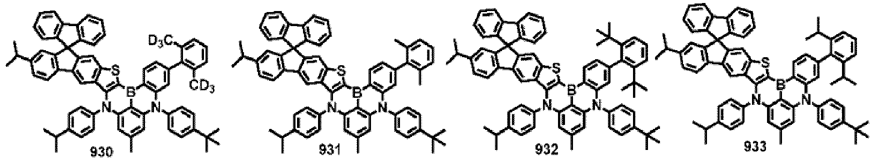

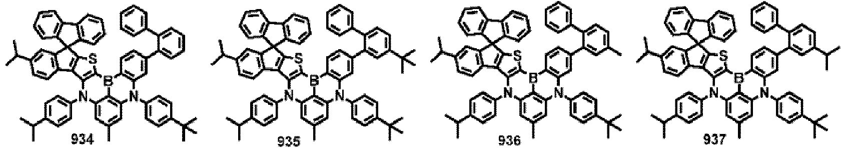

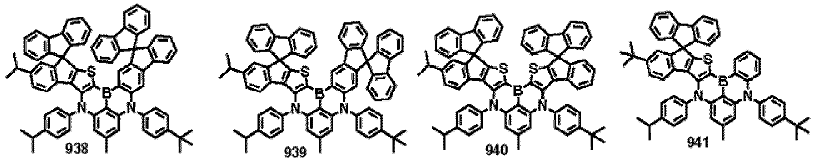

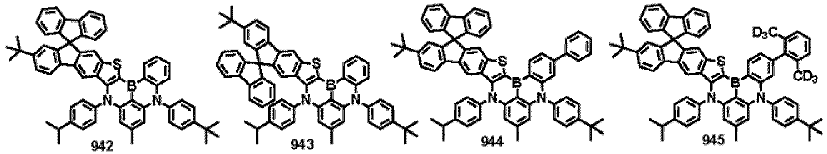

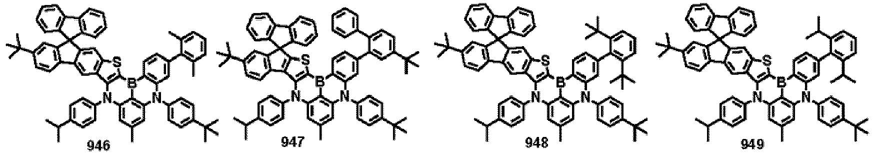

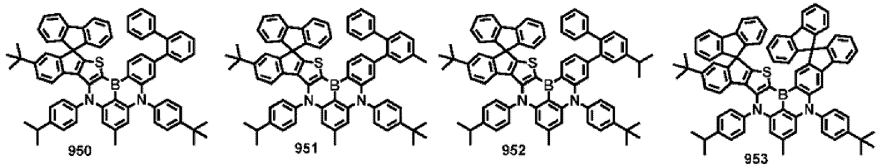

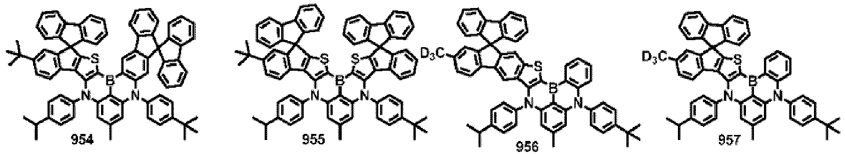

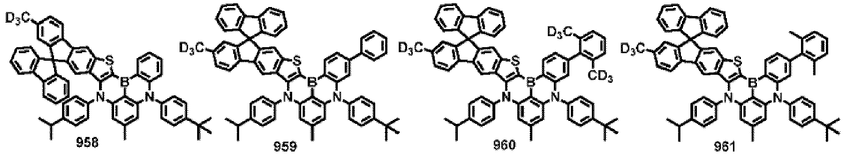

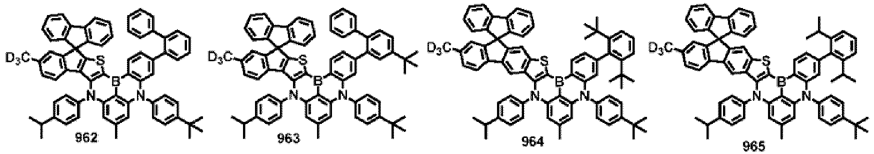

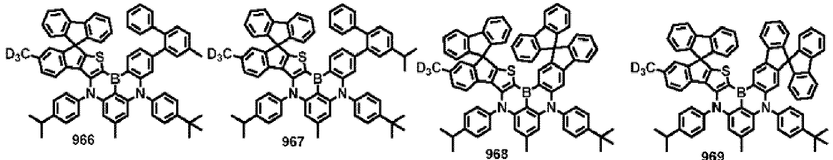

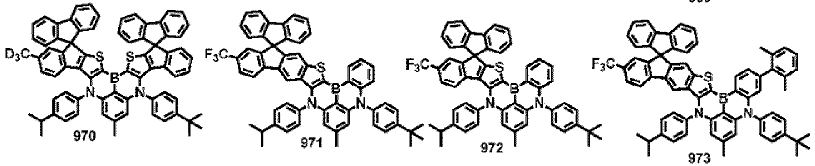

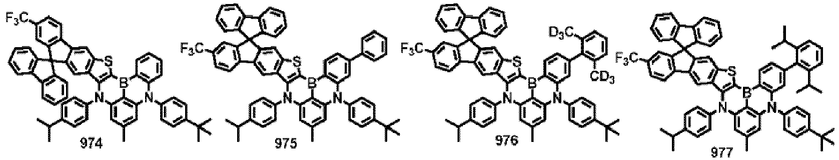

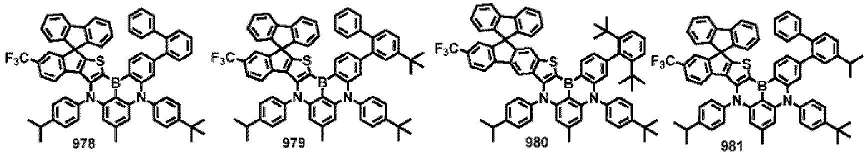

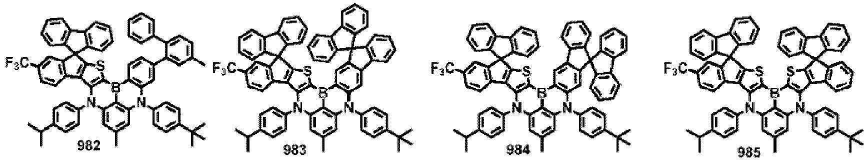

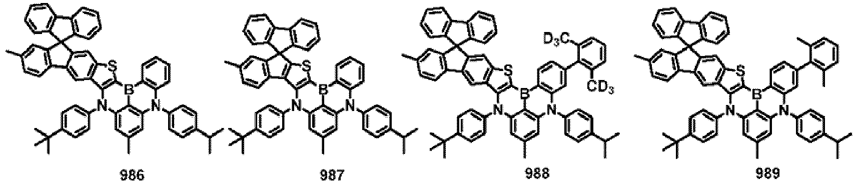

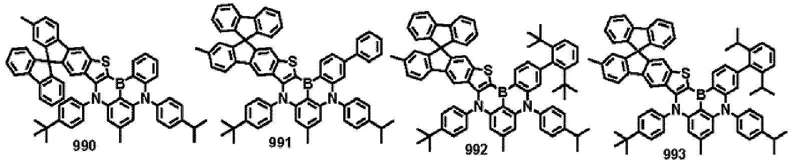

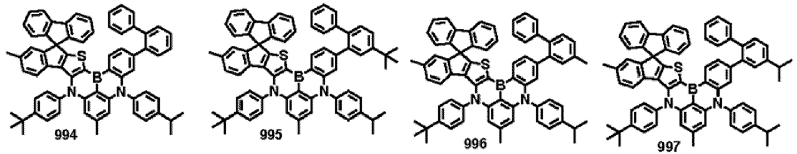

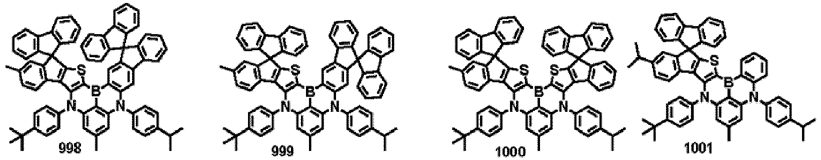

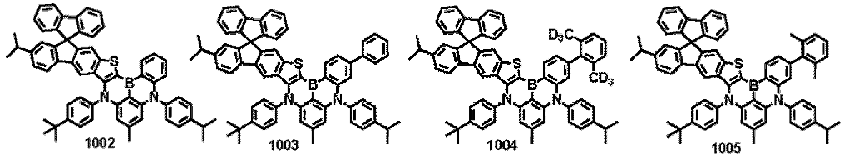

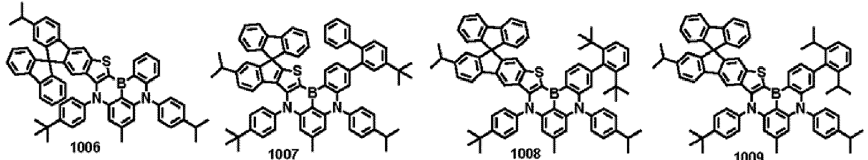

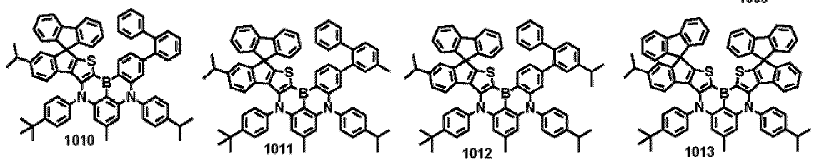

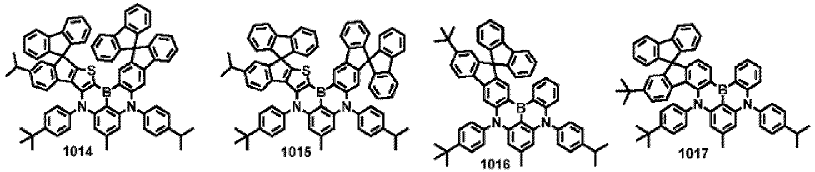

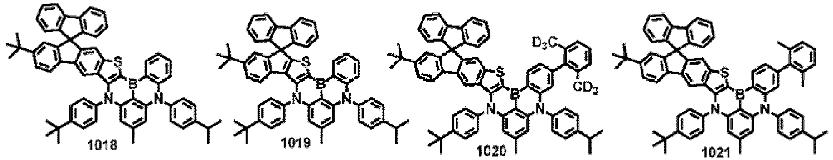

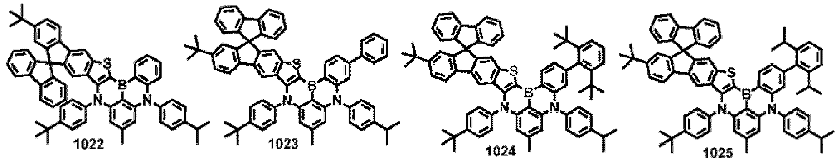

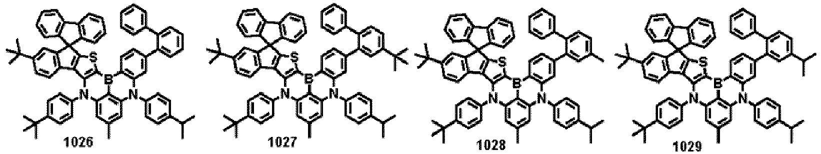

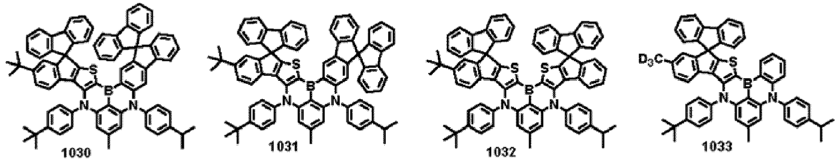

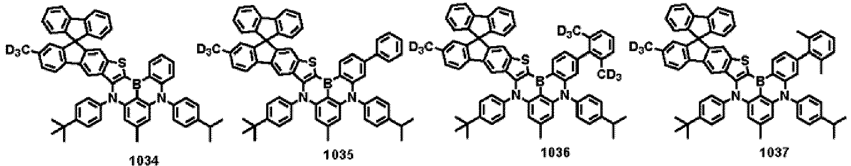

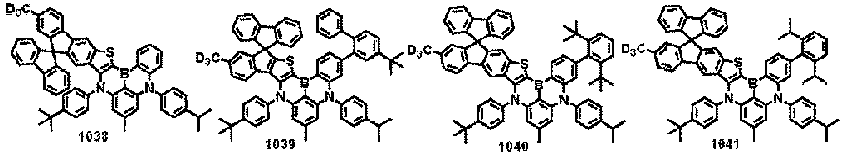

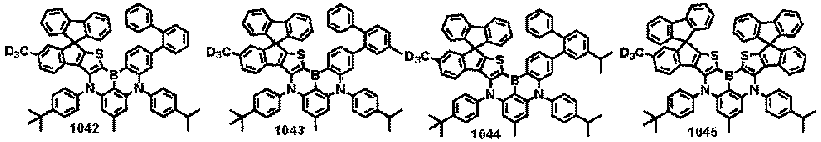

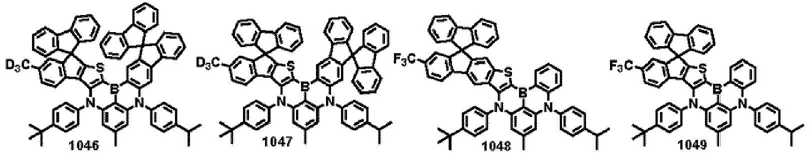

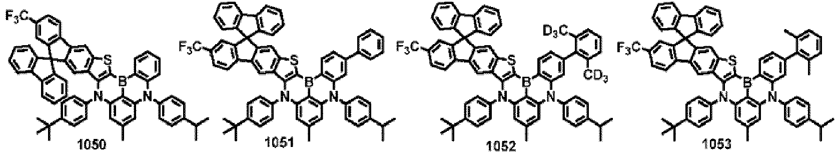

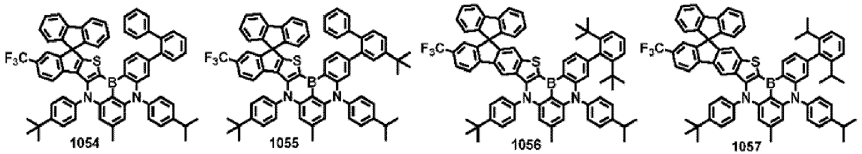

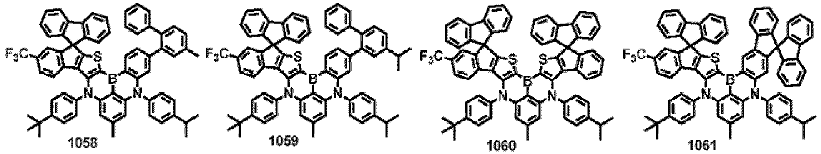

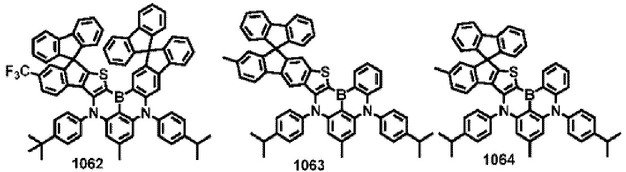

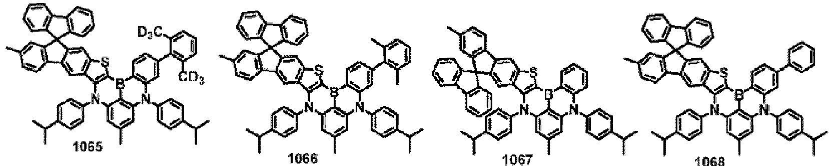

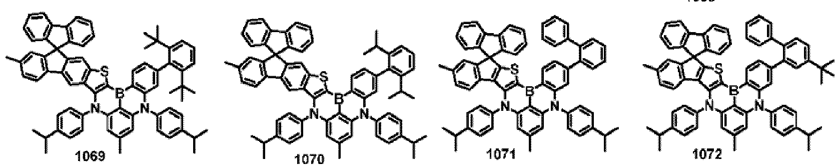

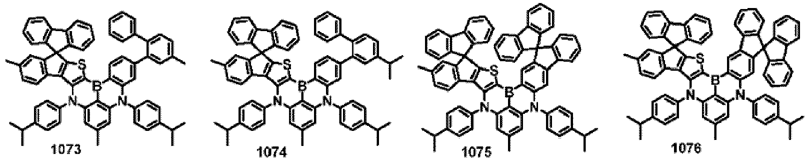

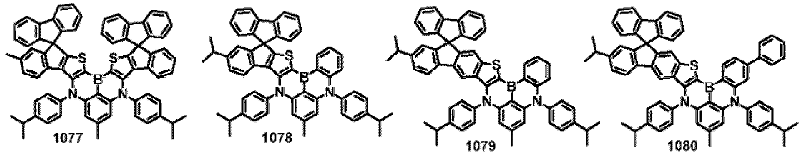

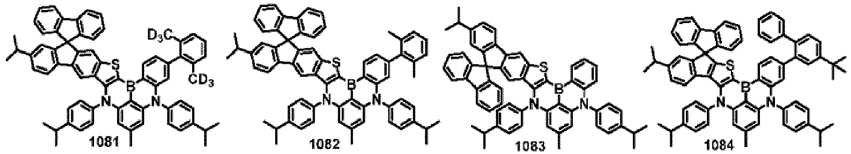

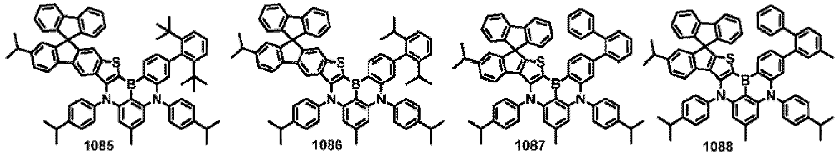

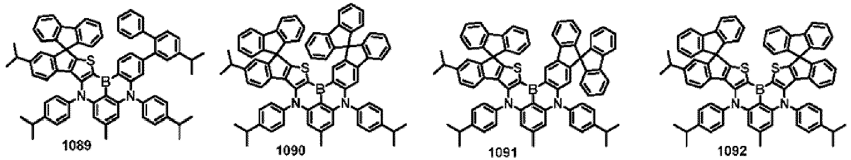

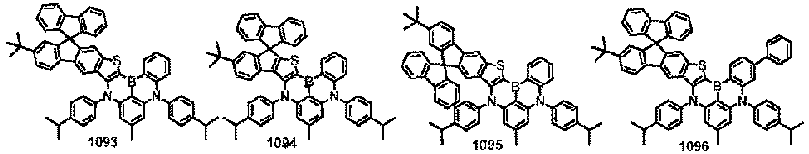

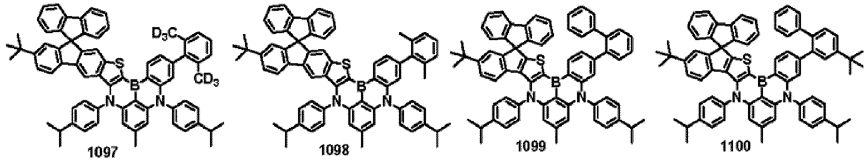

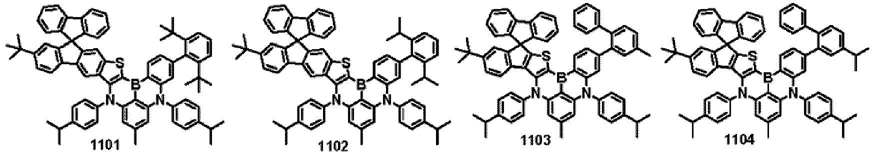

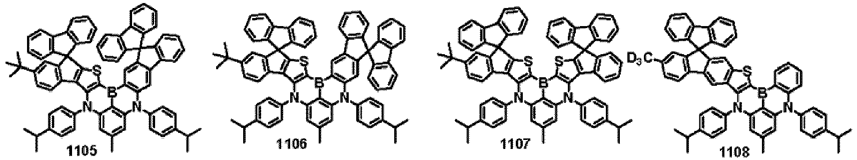

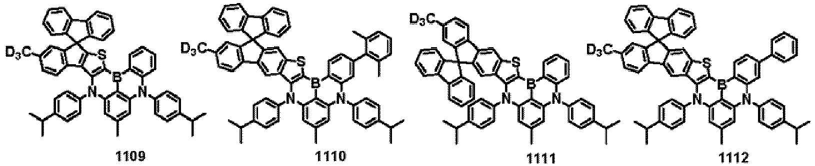

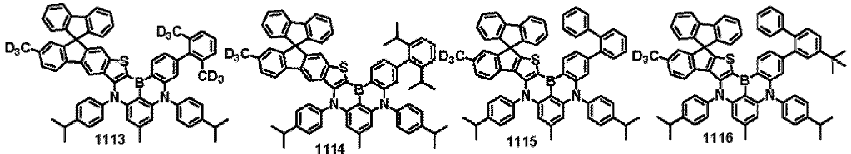

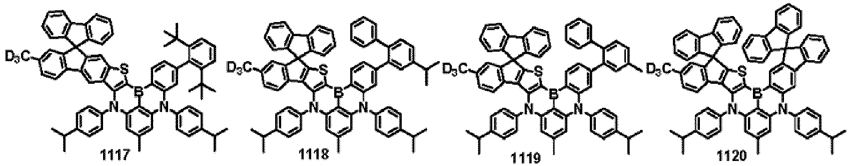

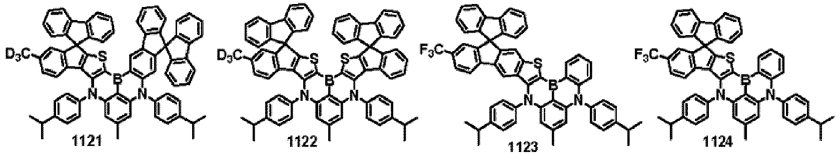

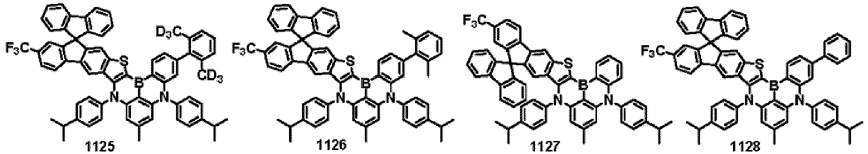

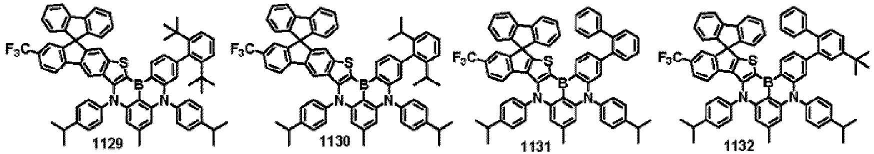

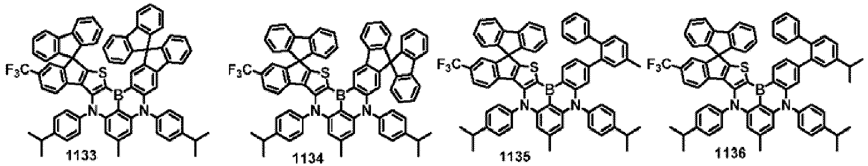

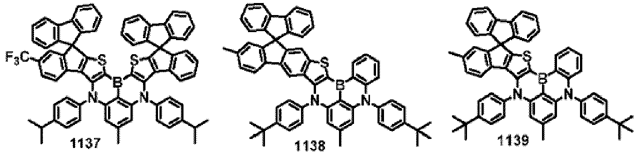

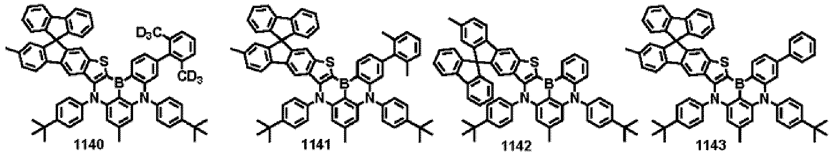

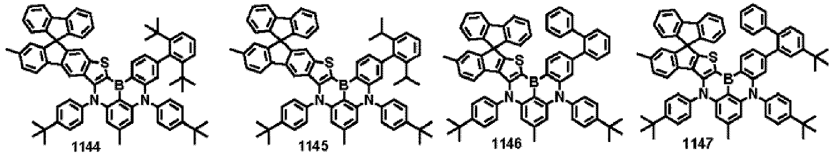

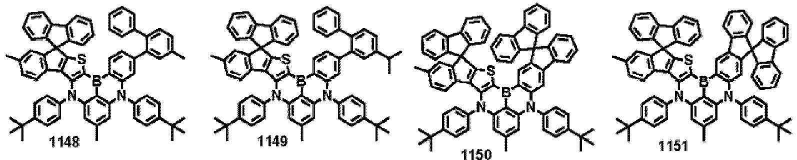

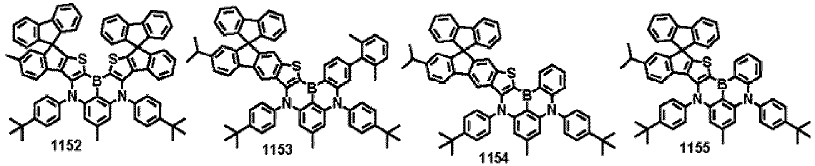

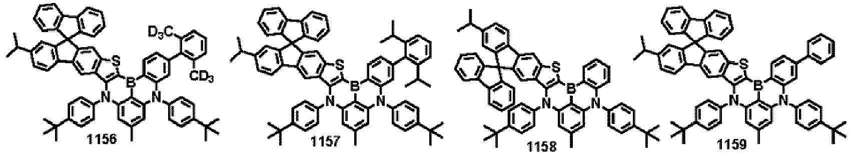

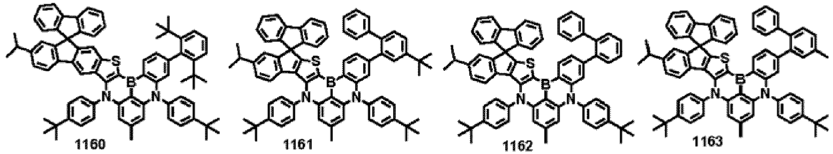

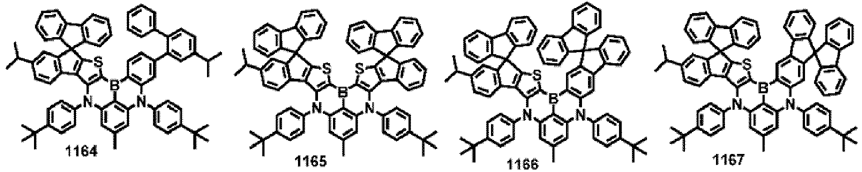

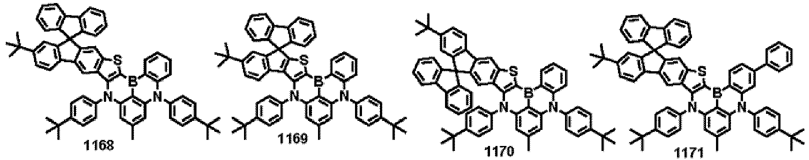

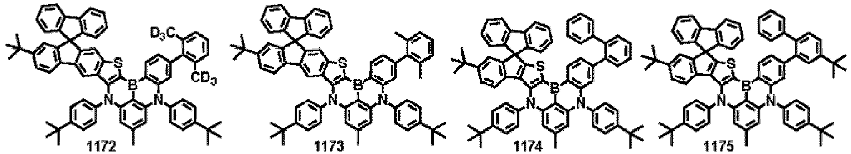

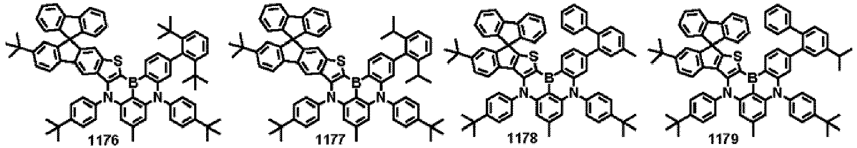

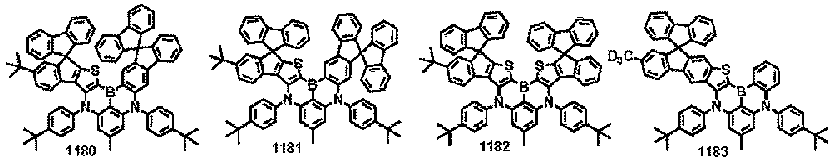

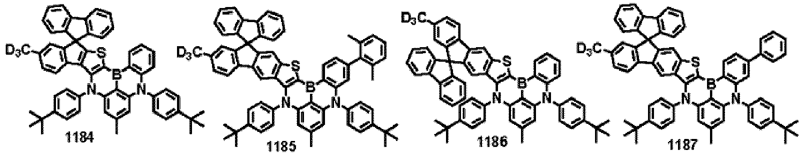

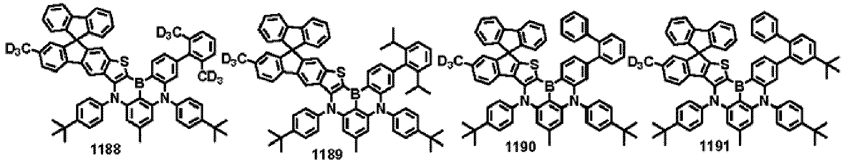

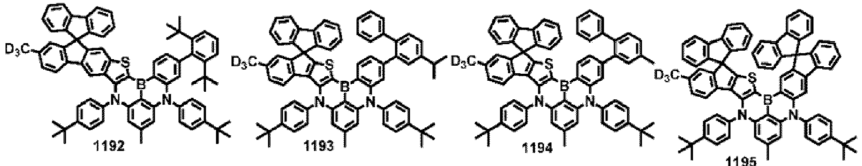

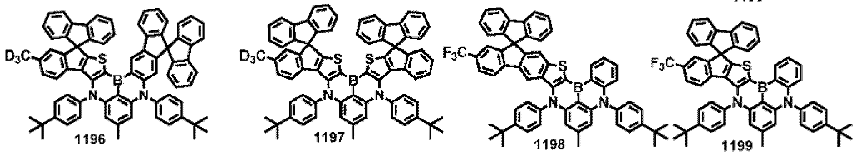

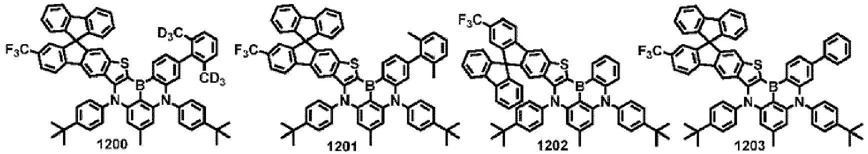

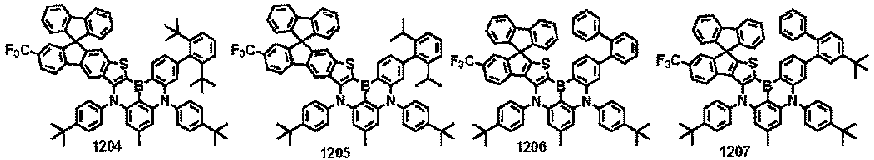

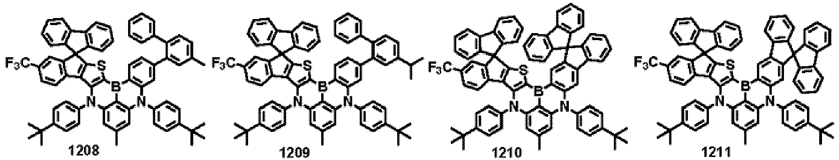

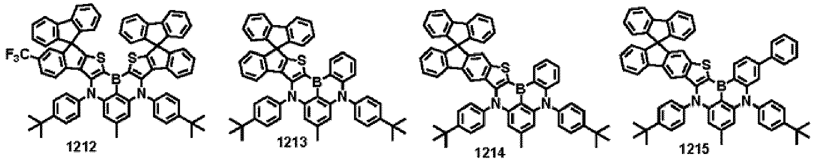

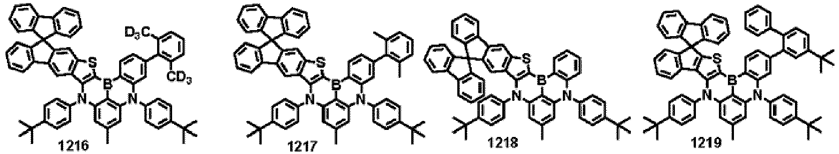

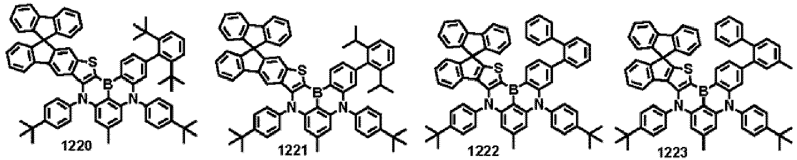

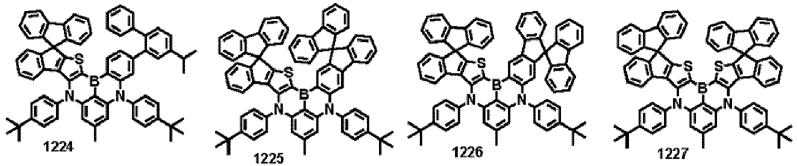

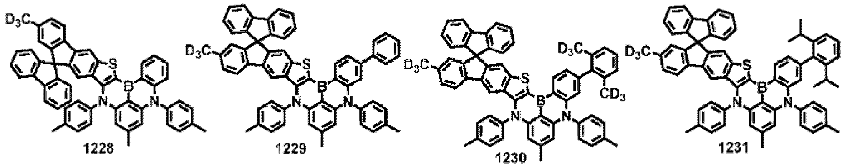

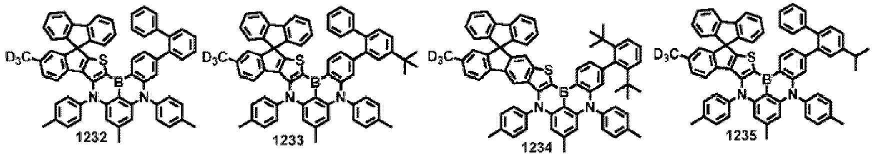

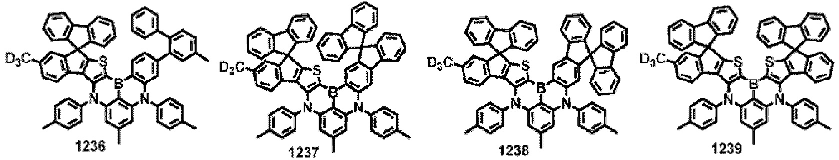

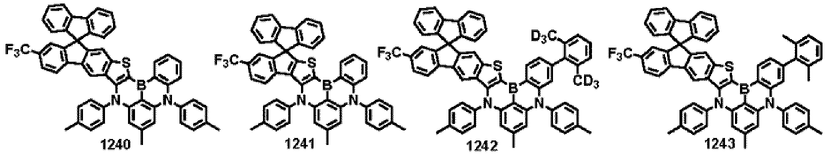

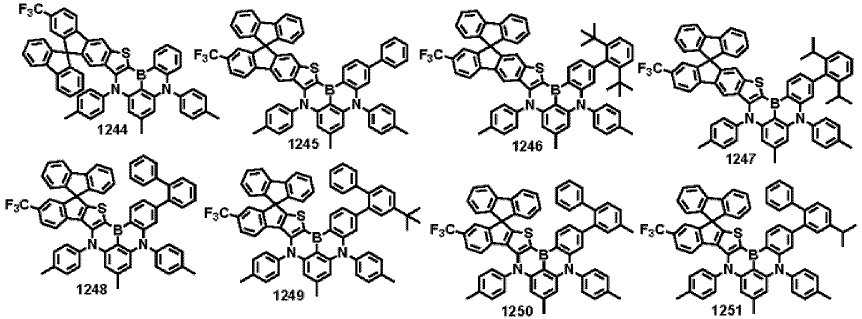

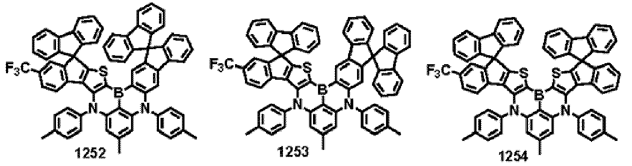

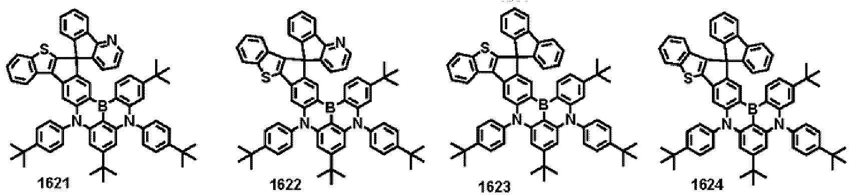

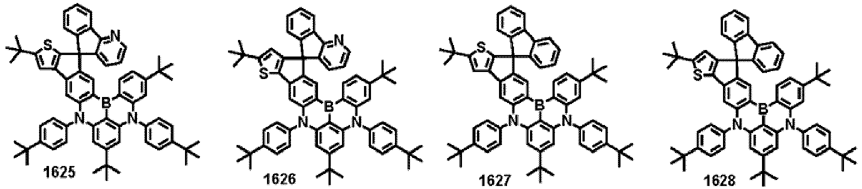

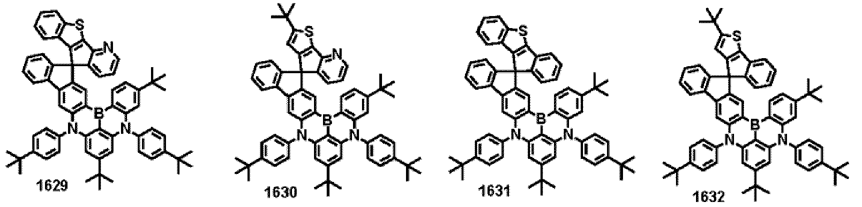

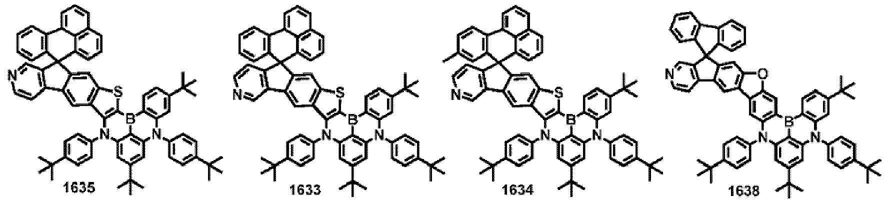

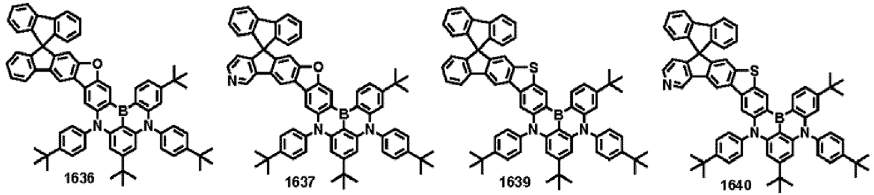

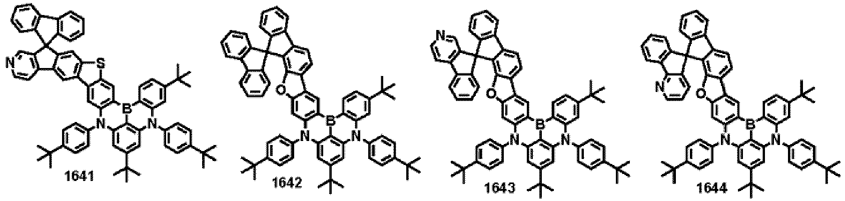

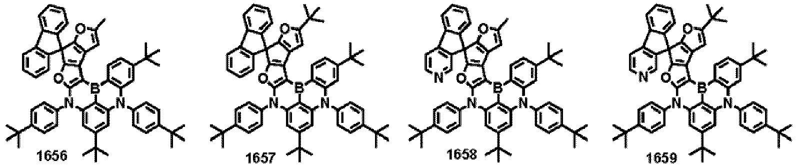

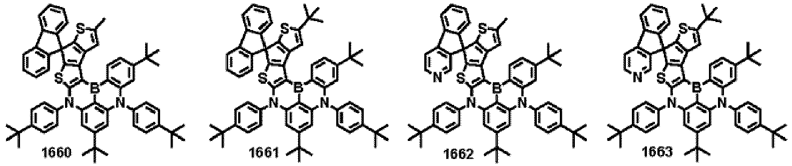

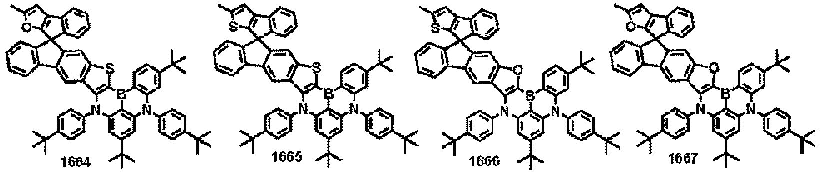

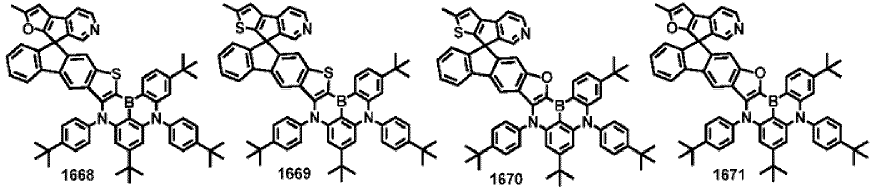

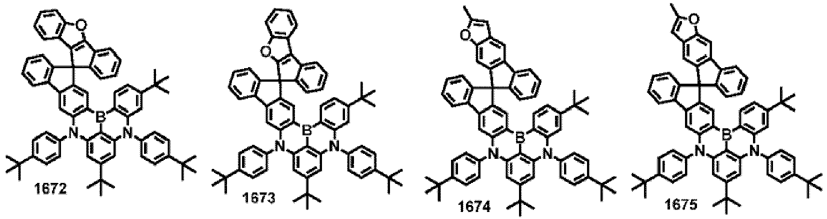

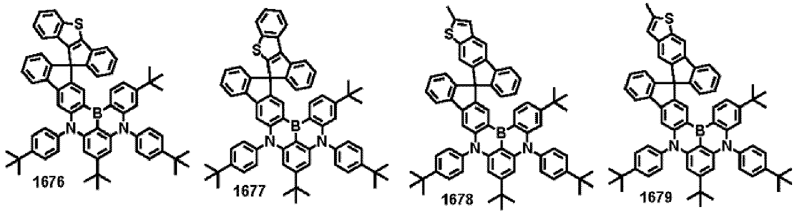

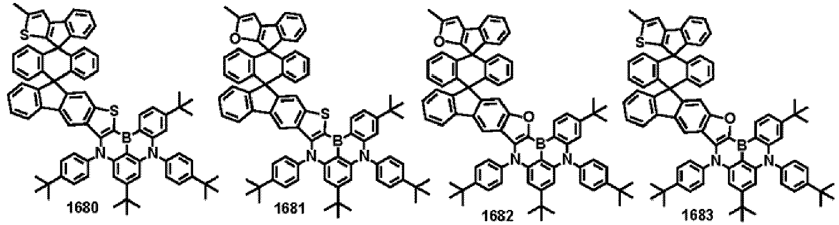

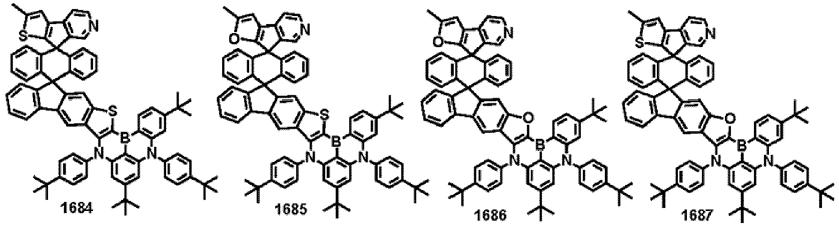

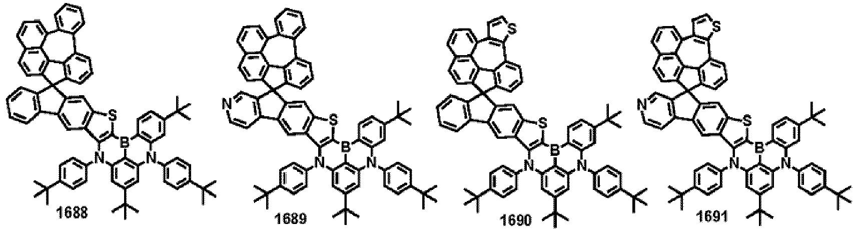

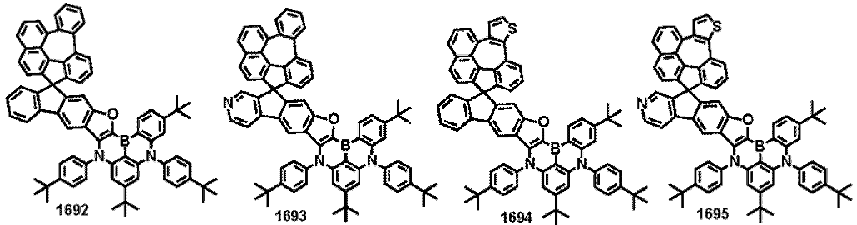

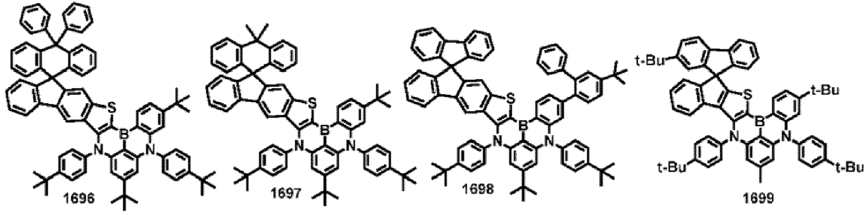

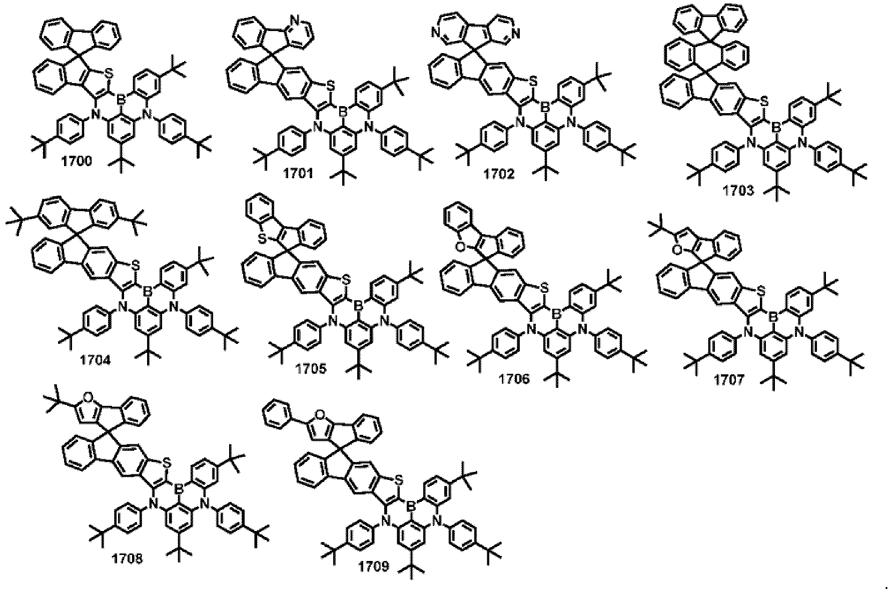

The present disclosure also provides a formulation including the spiro compound and at least one solvent. The solvent is not particularly limited and may use unsaturated hydrocarbon-based solvents commonly known to those skilled in that art (e.g. toluene, xylene, mesitylene, tetrahydronaphthalene, decalin, bicyclohexane, n-butylbenzene, sec-butylbenzene, tert-butyl benzene, etc.), saturated hydrocarbon-based solvents (e.g. carbon tetrachloride, chloroform, dichloromethane, dichloroethane, chlorobutane, bromobutane, chloropentane, bromopentane, chlorohexane, bromohexane, chlorocyclohexane, bromocyclohexane, etc.), unsaturated hydrocarbon-based solvents (e.g. chlorobenzene, dichlorobenzene, trichlorobenzene, etc.), ether-based solvents (e.g. tetrahydrofuran, tetrahydropyran, etc.) and ester-based solvents (benzoic acid alkyl esters, etc.). The formulation is directly used to prepare organic electroluminescent diodes.

The present disclosure further provides an organic photoelectric device including: a first electrode;
a second electrode disposed opposite to the first electrode; and
an organic functional layer sandwiched between the first electrode and the second electrode;
wherein the organic functional layer includes the spiro compound.

The present disclosure further provides an organic photoelectric device including an anode layer, a cathode layer and an organic functional layer, wherein the organic functional layer is at least one of a hole injection layer, a hole transport layer, an emissive layer (an active layer), a hole blocking layer, an electron injection layer and an electron transport layer, and the organic functional layer includes the spiro compound.

Preferably, the organic functional layer is an emissive layer, and the emissive layer further includes a host compound;
wherein the volume ratio of the spiro compound to the host compound is 1:1-1:99; and
the host compound is a compound well-known in the art.

The present disclosure further provides a display or illumination device including the organic electroluminescent diode.

The organic photoelectric element of the present disclosure is an organic photovoltaic device, an organic electroluminescent device (OLED), an organic solar cell (OSC), an electronic paper (e-paper), an organic photo conductor (OPC), an organic field-effect transistor (OTFT) or an organic memory element.

The organic photoelectric element of the present disclosure is prepared in the following method: firstly, metal or conductive oxides and their alloys are evaporated on a substrate by sputtering, electron beam evaporation, vacuum evaporation and the like to form an anode; secondly, a hole injection layer, a hole transport layer, an emissive layer, a hole blocking layer and an electron transport layer are sequentially evaporated on the surface of the prepared anode; finally, a cathode is evaporated. In addition to the above method, a cathode, an organic functional layer and an anode may also be sequentially evaporated on a substrate to prepare the organic photoelectric element, and the organic functional layer is at least one of a hole injection layer, a hole transport layer, an emissive layer, a hole blocking layer and an electron transport layer. The organic functional layer in the present disclosure can also be prepared by polymer material solvent engineering (spin-coating, tape-casting, doctor-blading, screen-printing, inkjet printing or thermal imaging) instead of evaporation, which can reduce the number of device layers.

According to the material used, the organic photoelectric element of the present disclosure can be classified as top-emitting, bottom-emitting or double-sided emitting. The compound of the present disclosure can be applied to electroluminescent devices such as organic solar cells, lighting OLEDs, flexible OLEDs, organic photo conductors or organic thin-film transistors based on the same principle as organic light-emitting devices.

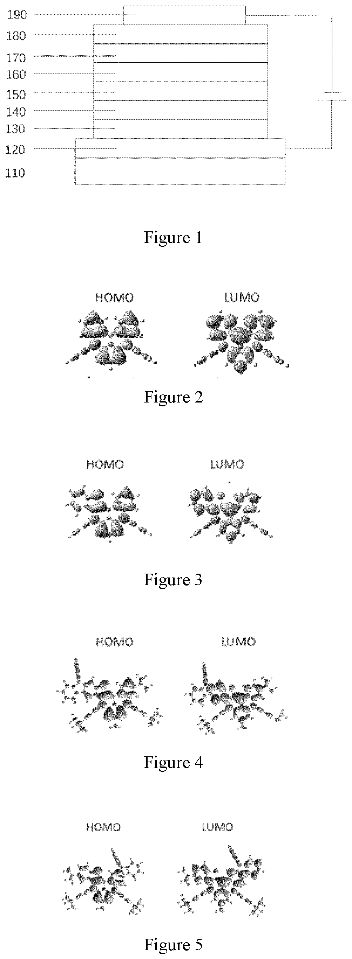

In the present disclosure, the structure of the MR-TADF light-emitting material is changed, and specific large sterically bulky spiro structures, substituents, etc. are introduced. Since the spiro structure introduced in the present disclosure is perpendicular to the MR-TADF planar skeleton (as shown in FIGS. 2 to 5), the close staking of molecules can be inhibited. At the same time, the introduction of the spiro structure does not change the energy level of the compound to a great extent (as shown in Table 1) but reduces the energy level difference of S1-T1, which is beneficial to the reverse intersystem crossing of triplet excitons. In addition, the oscillator strength (f) also increases, which finally improves the luminescence efficiency of the MR-TADF material and improves the thermal stability of the light-emitting material. When this kind of spiro compounds is applied to organic photoelectric devices, especially in organic electroluminescent devices (organic electroluminescent diodes), the current efficiency can be improved, the operating voltage of components can be reduced, and the long-life organic electroluminescent diodes are obtained.

**Table 1**

| Compound | HOMO (eV) | LUMO (eV) | Eg (eV) | S1 (eV) | T1 (eV) | ΔEst (eV) | f |
|---|---|---|---|---|---|---|---|
| BN-1 | -4.742 | -1.078 | 3.664 | 3.188 | 2.693 | 0.495 | 0.2204 |
| BN-2 | -4.656 | -1.156 | 3.5 | 3.085 | 2.459 | 0.626 | 0.2429 |
| BN-3 | -4.359 | -1.090 | 3.269 | 3.0364 | 2.442 | 0.5944 | 0.2898 |
| BN-4 | -4.523 | -1.194 | 3.329 | 2.9120 | 2.394 | 0.518 | 0.3391 |

The beneficial effects of the present disclosure are described below.

The spiro compound of the present disclosure has good thermal stability, and with the introduction of the spiro structure, the interactions between the luminescent molecules can be effectively inhibited, thereby improving the device efficiency. The spiro compound of the present disclosure has a better electron and hole receiving ability and can enhance the energy transfer between the host and the guest, which is embodied in that for the organic electroluminescent devices (organic electroluminescent diodes) prepared with the spiro compound of the present disclosure as the organic functional layer, especially those prepared with the spiro compound of the present disclosure as the emissive layer, the current efficiency is increased, the turn-on voltage is reduced, and the lifetime of the device is greatly improved, indicating that most of the electrons and holes are recombined, the energy is effectively transferred to the spiro compound for luminescence rather than heat generation.

### BRIEF DESCRIPTION OF DRAWINGS

FIG. 1 is a structure diagram of an organic electroluminescent diode according to the present disclosure;
FIG. 2 is a schematic diagram of HOMO (left) and LUMO (right) hybrid orbitals of Compound BN-1;
FIG. 3 is a schematic diagram of HOMO (left) and LUMO (right) hybrid orbitals of Compound BN-2;
FIG. 4 is a schematic diagram of HOMO (left) and LUMO (right) hybrid orbitals of Compound BN-3; and
FIG. 5 is a schematic diagram of HOMO (left) and LUMO (right) hybrid orbitals of Compound BN-4.

### DETAILED DESCRIPTION

The present disclosure is further described in detail in conjunction with embodiments, from which the object, solutions and advantages of the present disclosure are more apparent. It is to be understood that the embodiments described herein are intended to explain and not to limit the present disclosure.

The OLED device of the present disclosure includes a hole transport layer, and the hole transport material may preferably be selected from well-known materials and particularly is preferably selected from the following structures, but it does not mean that the present disclosure is limited to the following structures:

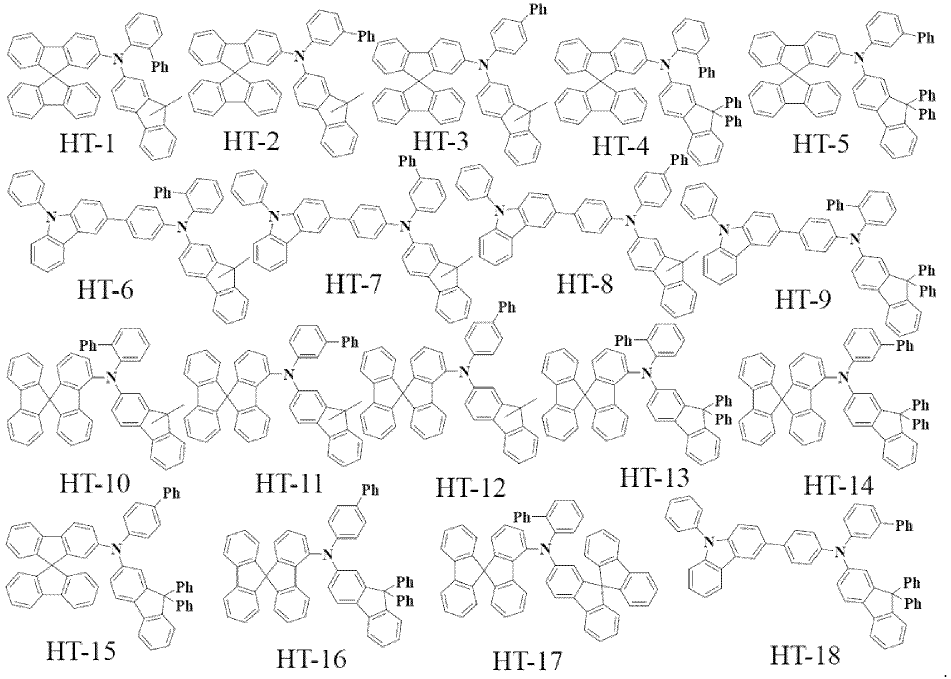

The hole transport layer included in the OLED device of the present disclosure includes one or more p-type dopants. The p-type dopant of the present disclosure preferably has the following structures, but it does not mean that the present disclosure is limited to the following structures:

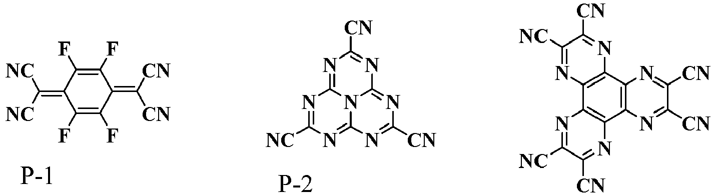

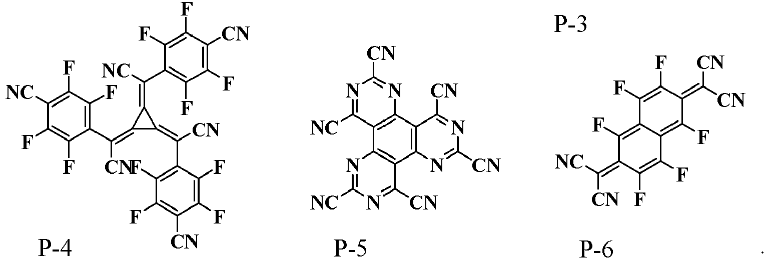

The electron transport layer included in the OLED device of the present disclosure may be selected from at least one of the following compounds, but it does not mean that the present disclosure is limited to the following structures:

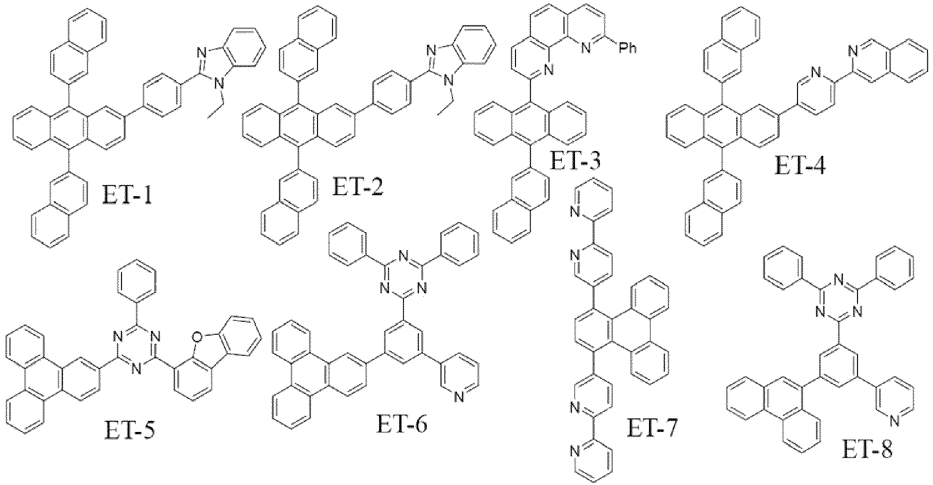

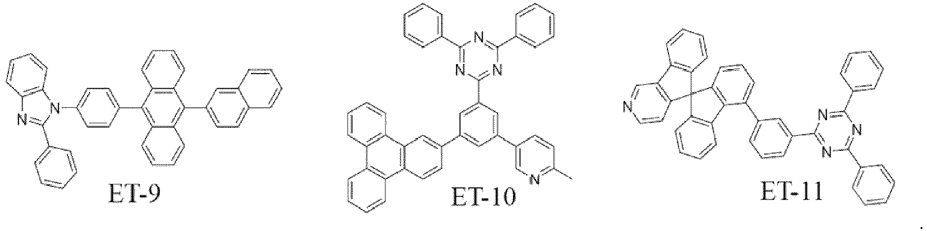

The structures of compounds BN-1 and BN-2 and representative compounds BN-3 and BN-4 of the present disclosure used in the following comparative examples are as follows:

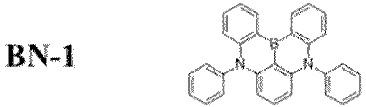

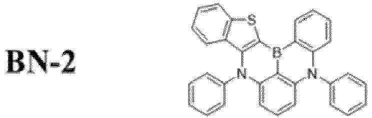

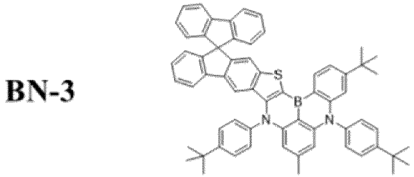

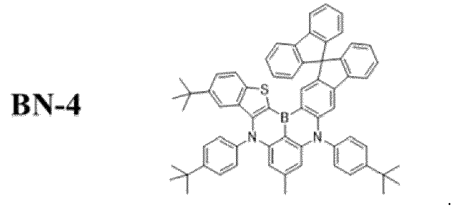

The general synthetic procedure of the compounds (guest compounds) of the present disclosure having the structure represented by Formula (I) is as follows: 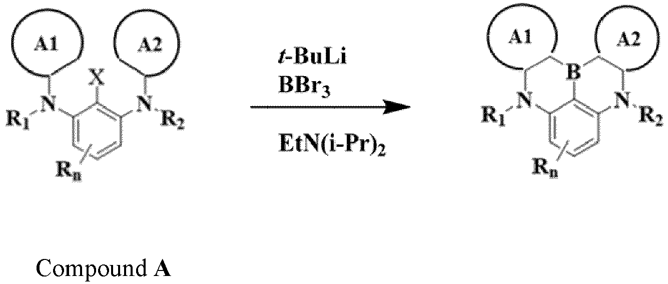 wherein X is Cl, Br or I; and

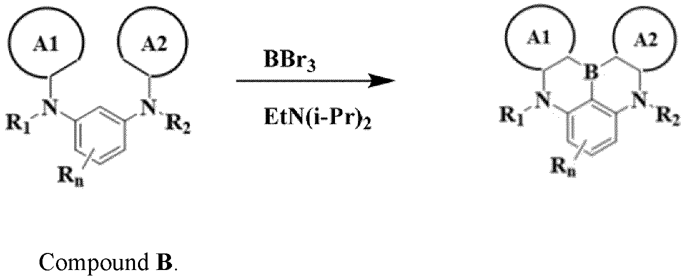

General synthetic procedure:
Under argon protection, a mixture solution of Compound A (0.10 mol), *tert-*butyllithium (0.2 mol) and *tert*-butylbenzene (100 mL) is reacted at -40 °C for 4 h. After the reaction is completed, the solution is heated to 80 °C and then reacted for another 4 h. BBr₃ (0.2 mol) is added dropwise, and after the dropwise addition is completed, the solution is heated to 80 °C and reacted for 4 h. EtN(*i*-Pr)₂ (0.30 mol) is then added dropwise, and after he dropwise addition is completed, the solution is refluxed overnight. The heating is stopped, the solution is cooled to room temperature, an appropriate amount of distilled water is added. The solvent is removed under reduced pressure, and the solid is dissolved in dichloromethane and passed through a short silica gel column to give the final target product with the yield of 21%-58%.

Under argon protection, the mixed solution of Compound **B** (0.10 mol), BBr₃ (0.2 mol), EtN(*i*-Pr)₂ (0.30 mol) and tert-butylbenzene (100 mL) is heated at refluxed for 48 h. The heating is stopped, the solution is cooled to room temperature, an appropriate amount of distilled water is added. The solvent is removed under reduced pressure, and the solid is dissolved in dichloromethane and passed through a short silica gel column to give the final target product with the yield of 20%-51%.

The preparation method of the spiro compound (i.e. guest compound) and the luminescence property of the device are described in detail in conjunction with the following examples, and Compound A and Compound **B** are synthesized by methods known in the art. However, these are only used by way of example to describe embodiments of the present disclosure so the scope of the present disclosure is not limited thereto.

### Example 1: Synthesis of Compound 1696

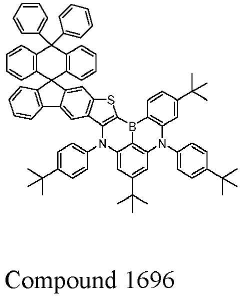

Compound 1696 was synthesized with reference to the above general synthetic procedure, and the yield of the final product was 35%. Mass spectrum m/z, theoretical value: 1104.56, measured value M+H: 1105.6.

### Example 2: Synthesis of Compound 1697

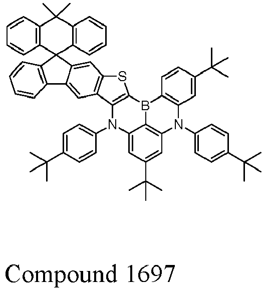

Compound 1697 was synthesized with reference to the above general synthetic procedure, and the yield of the final product was 31%. Mass spectrum m/z, theoretical value: 980.53, measured value M+H: 981.6.

### Example 3: Synthesis of Compound 1698

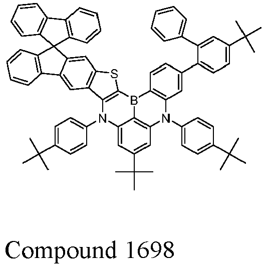

Compound 1698 was synthesized with reference to the above general synthetic procedure, and the yield of the final product was 33%. Mass spectrum m/z, theoretical value: 1090.54, measured value M+H: 1091.6.

### Example 4: Synthesis of Compound 1699

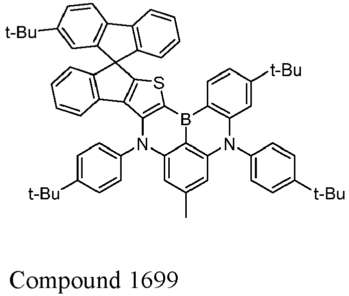

Compound 1699 was synthesized with reference to the above general synthetic procedure, and the yield of the final product was 34%. Mass spectrum m/z, theoretical value: 902.48, measured value M+H: 903.5.

### Example 5: Synthesis of Compound 1700

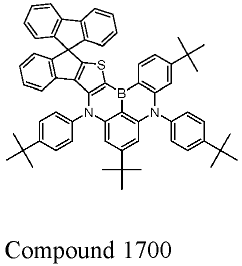

Compound 1700 was synthesized with reference to the above general synthetic procedure, and the yield of the final product was 41%. Mass spectrum m/z, theoretical value: 888.46, measured value M+H: 889.5.

### Example 6: Synthesis of Compound 1701

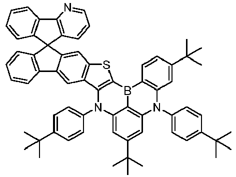

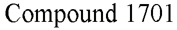

Compound 1701 was synthesized with reference to the above general synthetic procedure, and the yield of the final product was 32%. Mass spectrum m/z, theoretical value: 939.48, measured value M+H: 940.5.

### Example 7: Synthesis of Compound 1702

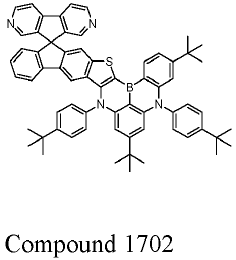

Compound 1702 was synthesized with reference to the above general synthetic procedure, and the yield of the final product was 30%. Mass spectrum m/z, theoretical value: 940.47, measured value M+H: 941.5.

### Example 8: Synthesis of Compound 1703

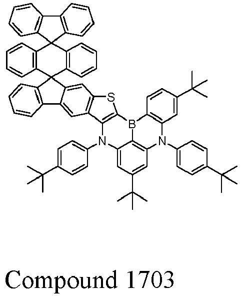

Compound 1703 was synthesized with reference to the above general synthetic procedure, and the yield of the final product was 27%. Mass spectrum m/z, theoretical value: 1103.33, measured value M+H: 1104.4.

### Example 9: Synthesis of Compound 1704

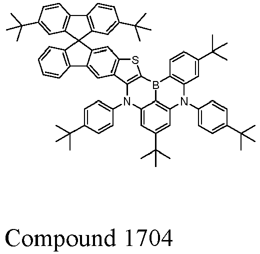

Compound 1704 was synthesized with reference to the above general synthetic procedure, and the yield of the final product was 29%. Mass spectrum m/z, theoretical value: 1050.61, measured value M+H: 1051.7.

### Example 10: Synthesis of Compound 1705

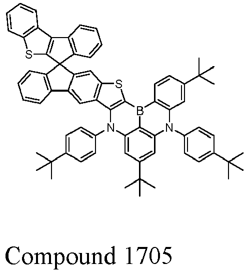

Compound 1705 was synthesized with reference to the above general synthetic procedure, and the yield of the final product was 25%. Mass spectrum m/z, theoretical value: 994.45, measured value M+H: 994.5.

### Example 11: Synthesis of Compound 1706

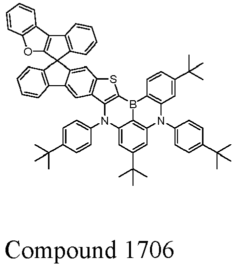

Compound 1706 was synthesized with reference to the above general synthetic procedure, and the yield of the final product was 35%. Mass spectrum m/z, theoretical value: 978.48, measured value M+H: 978.5.

### Example 12: Synthesis of Compound 1707

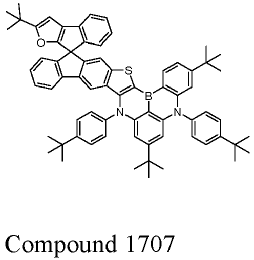

Compound 1703 was synthesized with reference to the above general synthetic procedure, and the yield of the final product was 31%. Mass spectrum m/z, theoretical value: 984.52, measured value M+H: 985.6.

### Example 13: Synthesis of Compound 1708

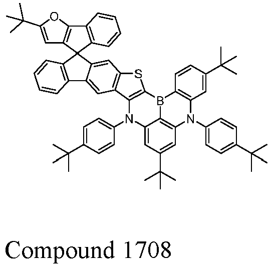

Compound 1708 was synthesized with reference to the above general synthetic procedure, and the yield of the final product was 29%. Mass spectrum m/z, theoretical value: 984.52, measured value M+H: 984.6.

### Example 14: Synthesis of Compound 1709

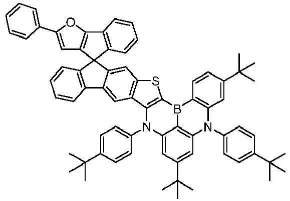

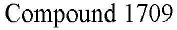

Compound 1709 was synthesized with reference to the above general synthetic procedure, and the yield of the final product was 30%. Mass spectrum m/z, theoretical value: 1004.49, measured value M+H: 1005.5.

### Device Example

As shown in FIG. 1, the organic electroluminescent diode (bottom-emitting OLED device) of the present disclosure included a substrate 110, an anode 120, a hole injection layer 130, a hole transport layer 140, an emissive layer 150, a hole blocking layer 160, an electron transport layer 170, an electron injection layer 180 and a cathode 190. Each layer of the organic electroluminescent diode of the present disclosure can be formed by vacuum evaporation, sputtering, ion plating and the like or by wet film forming such as spin coating, printing, stamping and the like, and the solvent used is not particularly limited.

### Preparation of OLED devices in Examples 1 to 9:

HT-1 and P-3 were co-deposited or HT-1 was deposited on the surface of an ITO glass with a 2 mm × 2 mm light-emitting area or on the anode to form a hole injection layer (HIL) with a thickness of 10 nm (wherein the volume ratio of HT-1 to P-3 was 95:5) and a hole transport layer (HTL) with a thickness of 90 nm. Then HT-8 was deposited on the hole transport layer to form an electron blocking layer (EBL) with a thickness of 10 nm, and a host material known in the art (e.g., BH-1) and the spiro compound (Compound 1-11) (guest compound) of the present disclosure were co-deposited on the electron blocking layer to form an emissive layer (EML) with a thickness of 35 nm (wherein the volume ratio of the spiro compound to the host compound was 3:97). Finally, ET-13 and LiQ were co-deposited to form an electron transport layer (ETL) with a thickness of 35 nm (wherein the volume ratio of ET-13 to LiQ was 1:1), and the cathode Al with a thickness of 70 nm was deposited to prepare the organic electroluminescent diode.

### Preparation of OLED devices in Comparative Examples 1 to 2:

The preparation of the OLED device in Comparative Examples 1 to 2 was similar to that in Examples 1 to 9, and the difference lied in that the spiro compound of the present disclosure was replaced with BN-1 to BN-2 (as the guest material of the emissive layer) in Comparative Examples 1 to 2.

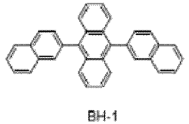

The organic electroluminescent diodes of Examples 1 to 9 and Comparative Examples 1 to 2 were characterized by the same standard method as is well-known in the art.

Characteristics such as the current efficiency, voltage and lifetime in the above-described examples and comparative examples are shown in Table 2 below.

**Table 2**

| Example | Spiro compound | Drive voltage (V) | Current efficiency (cd/A) | LT95 (h) |
|---|---|---|---|---|
| Example 1 | Compound 1696 | 3.8 | 9.8 | 97 |
| Example 2 | Compound 1697 | 3.7 | 10.3 | 97 |
| Example 3 | Compound 1698 | 3.7 | 10.7 | 102 |
| Example 4 | Compound 1699 | 3.8 | 9.9 | 106 |
| Example 5 | Compound 1700 | 3.8 | 9.8 | 101 |
| Example 6 | Compound 1701 | 3.8 | 9.5 | 85 |
| Example 7 | Compound 1702 | 3.8 | 9.6 | 112 |
| Example 8 | Compound 1703 | 3.8 | 9.7 | 102 |
| Example 9 | Compound 1704 | 3.8 | 9.3 | 92 |
| Comparative Example 1 | BN-1 | 3.9 | 7.7 | 35 |
| Comparative Example 2 | BN-2 | 3.9 | 7.4 | 33 |

As can be seen from Table 1, with the incorporation of the fused ring into the ligand structure, Examples 1 to 5 show good device performance, which indicates that the spiro compound of the present disclosure has certain application values.

The above are only the preferred embodiments of the present disclosure and are not intended to limit the protection scope of the present disclosure. Any equivalent modifications or alterations made by those familiar with the art according to the technical solutions of the present disclosure and the inventive concept thereof within the technical scope disclosed by the present disclosure shall fall within the protection scope of the present disclosure.

## Claims

1. A spiro compound, wherein a structure of the spiro compound is represented by Formula (I): 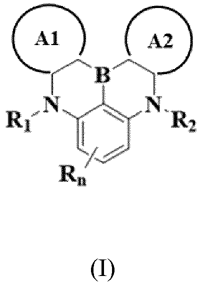
wherein A₁ and A₂ are each independently selected from the group consisting of: 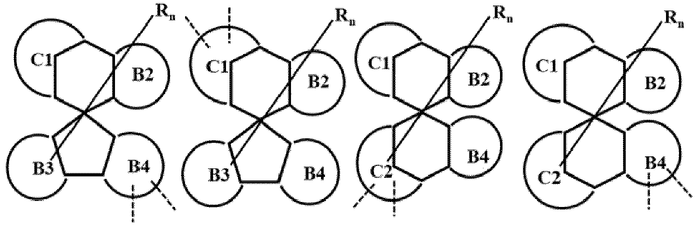 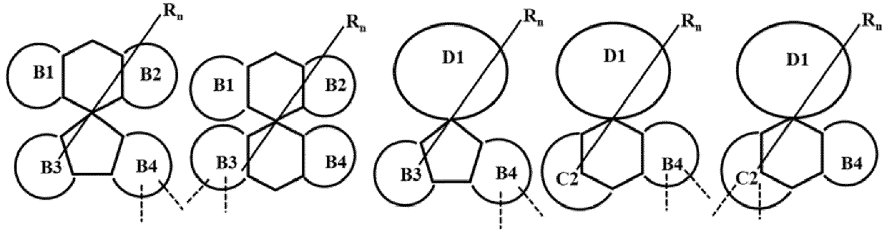 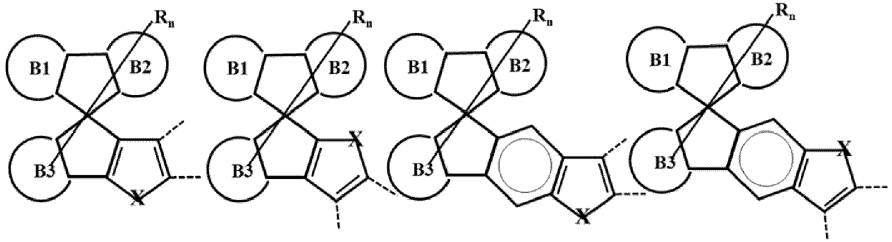 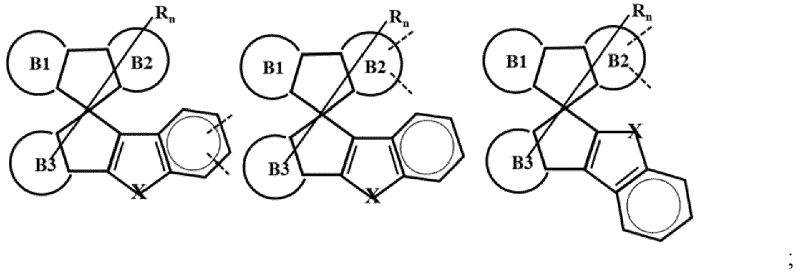
wherein B1, B2, B3, B4, C1, C2 and D1 are each independently selected from C6-C60 aryl or C1-C60 heteroaryl; B1, B2, B3, B4, C1, C2 and D1 can be mono-substituted or multi-substituted;
X is selected from C, O, N, S or Se;
the dashed line represents attachment to the N atom and the B atom in Formula (I) to form chemical bonds;
R₁, R and R₂ are each independently selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, a C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10; and
undeuterated groups in the above structures can be partially or fully deuterated.

2. The spiro compound according to claim 1, wherein B1, B2, B3 and B4 are each independently selected from the group consisting of: 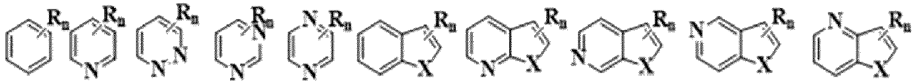 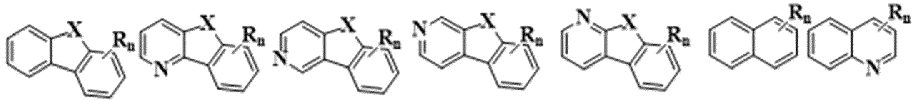 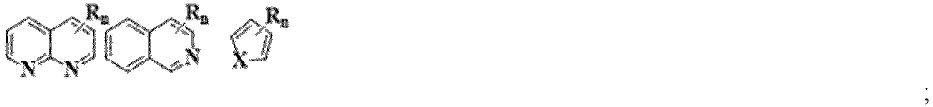
wherein R is independently selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se; and
undeuterated groups in the above structures can be partially or fully deuterated.

3. The spiro compound according to claim 1 or 2, wherein C1 and C2 are each independently selected from the following structures: 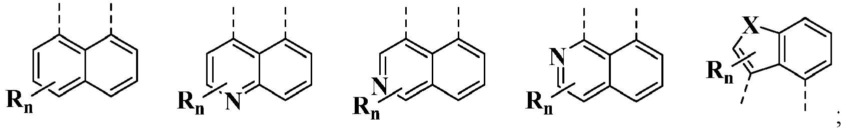
wherein R is selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se;
the dashed line represents attachment to the six-membered ring in claim 2 to form chemical bonds; and
undeuterated groups in the above structures can be partially or fully deuterated.

4. The spiro compound according to claim 1 or 2, wherein D1 is selected from the following structures: 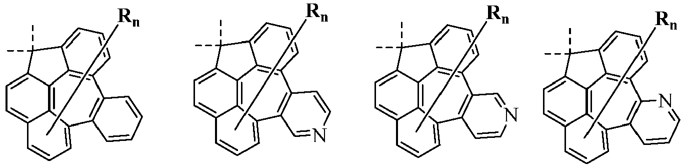 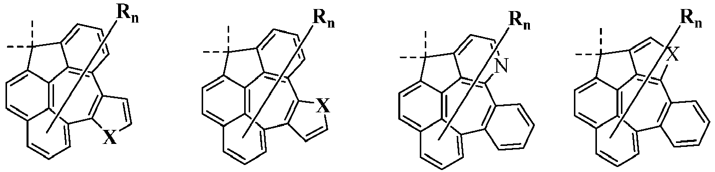
wherein R is selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se; and
undeuterated groups in the above structures can be partially or fully deuterated.

5. The spiro compound according to claim 1, wherein A₁ and A₂ are each independently selected from the group consisting of: 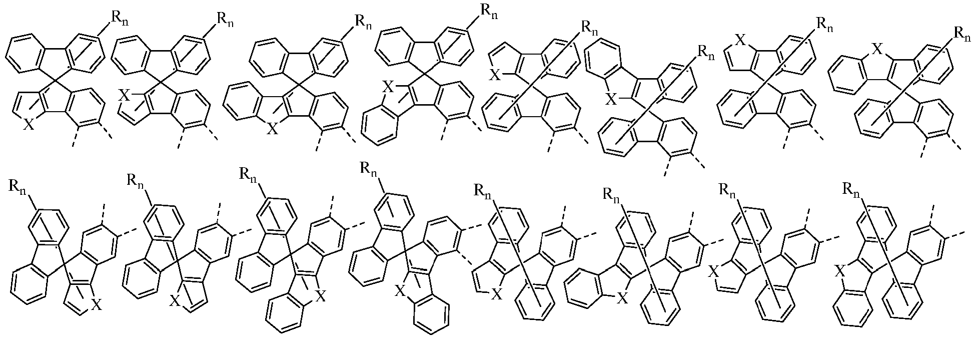 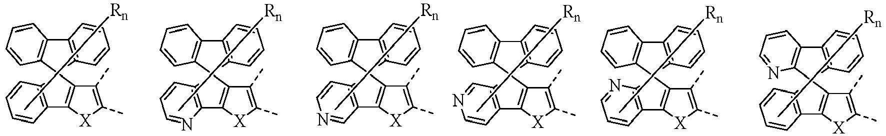 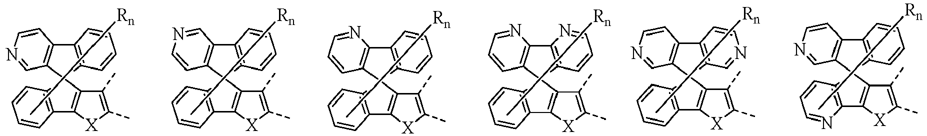 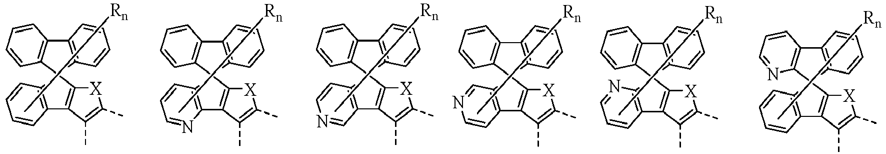 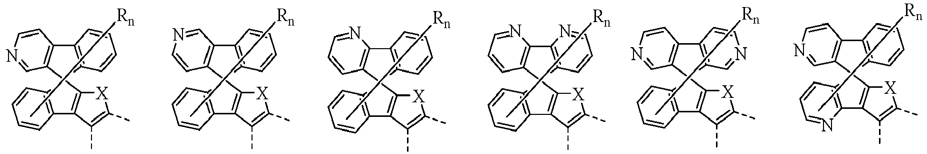 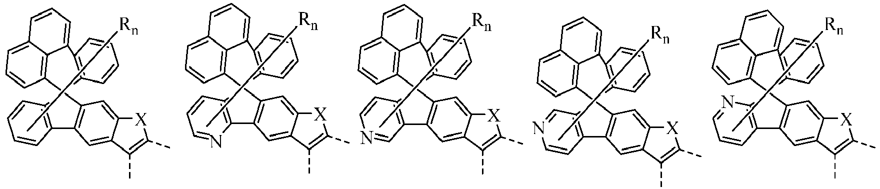 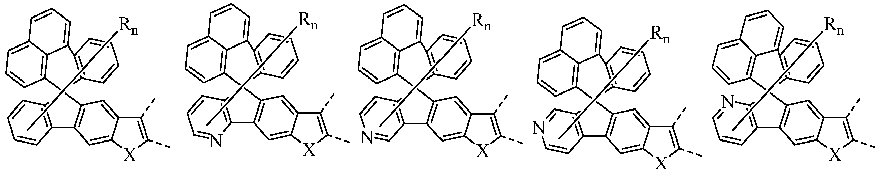 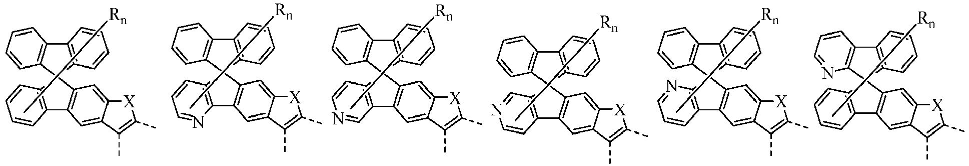 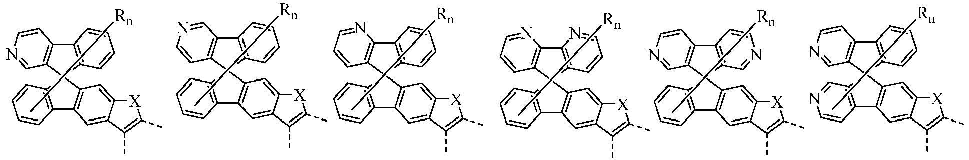 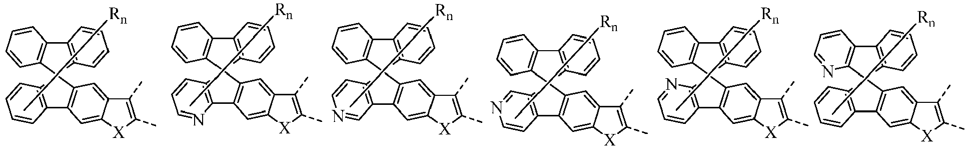 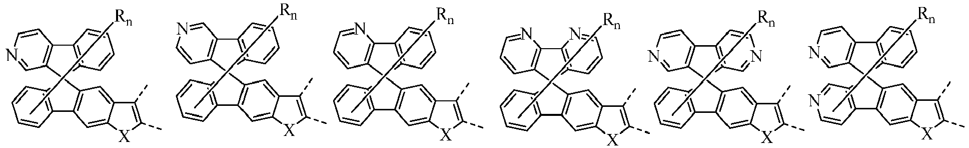 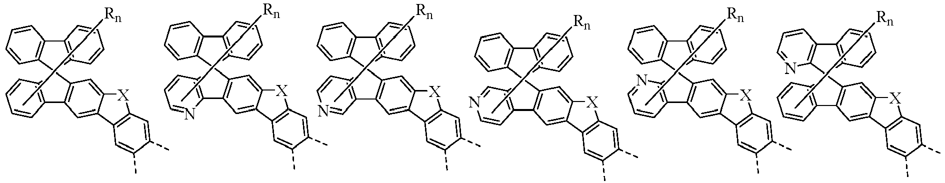 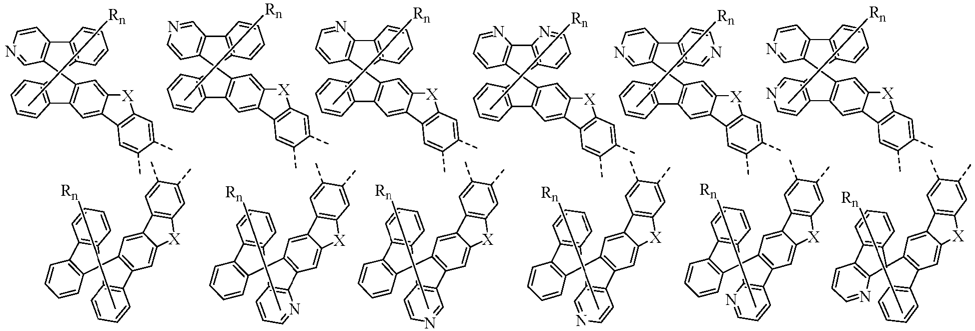 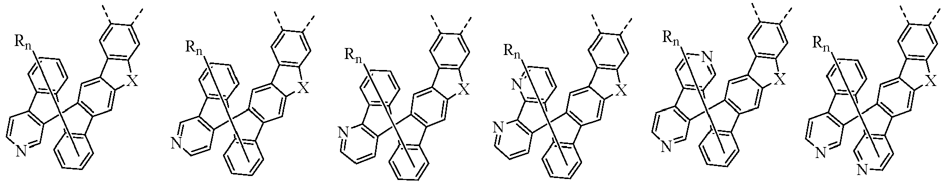 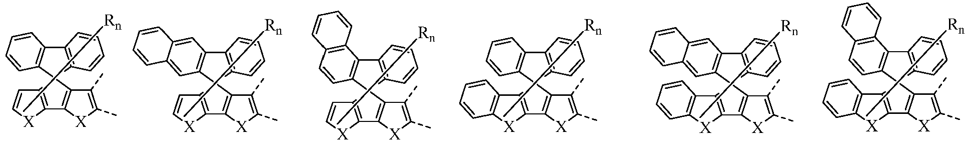 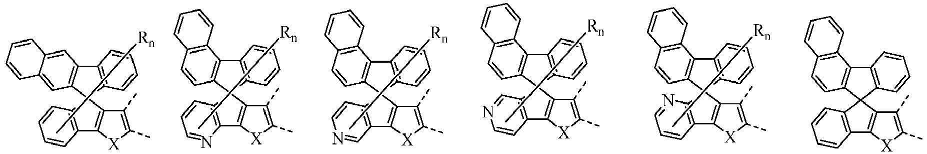 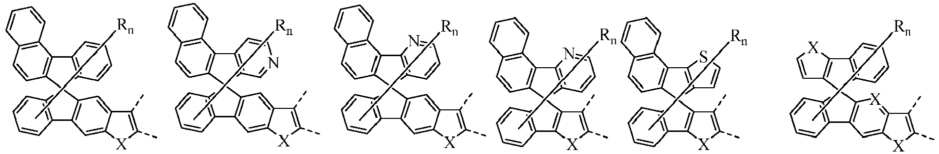 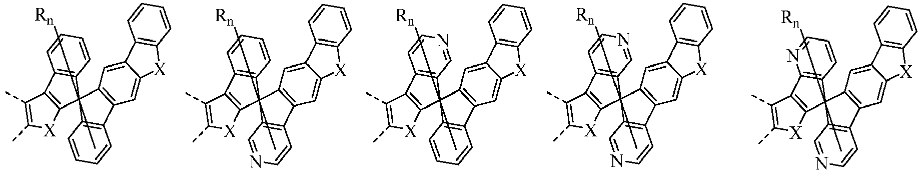 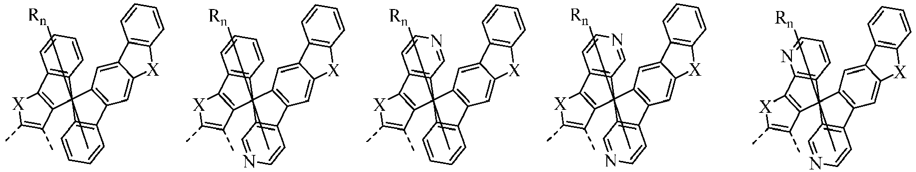 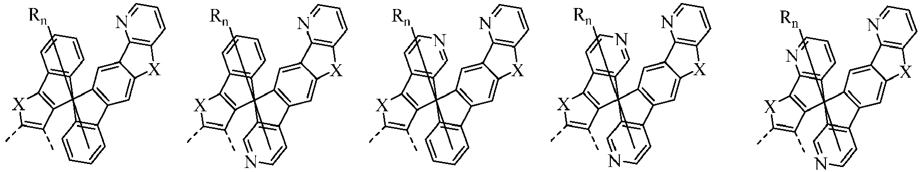 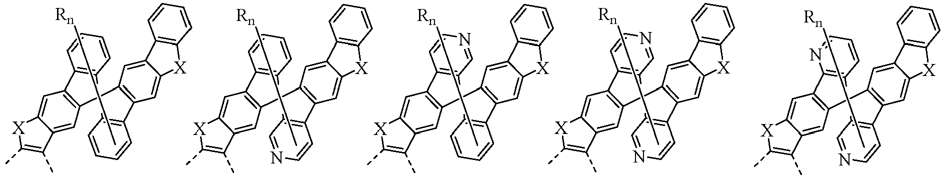 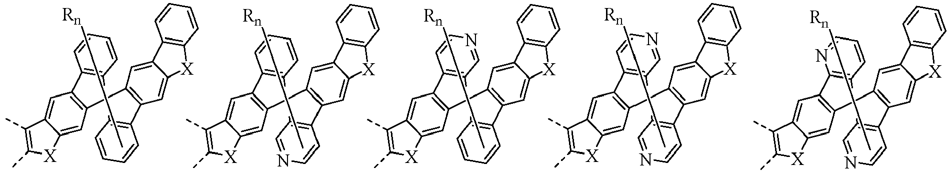 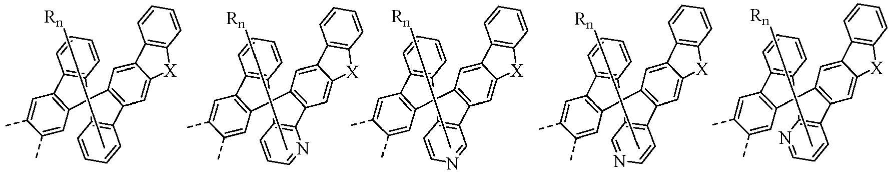 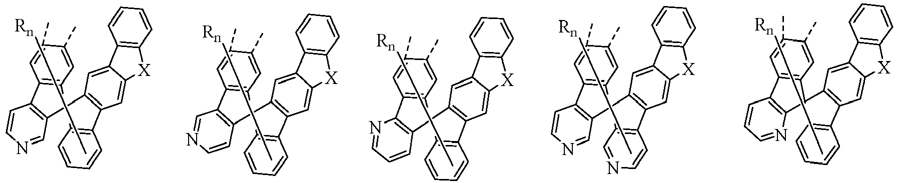 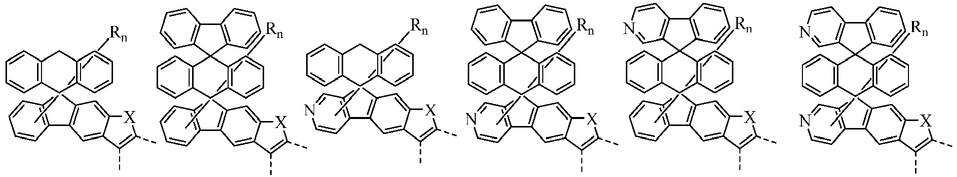 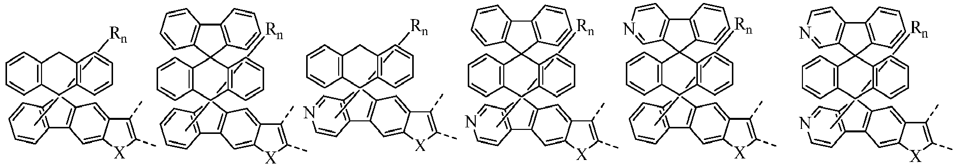 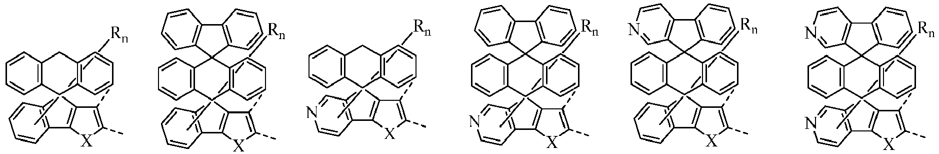 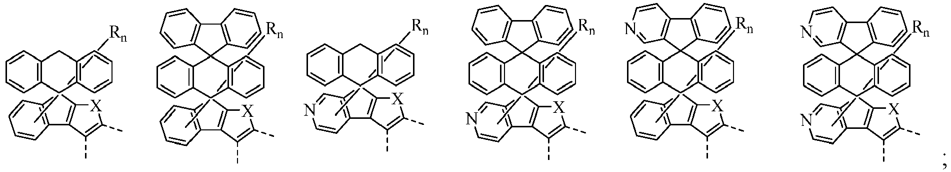
wherein R is selected from hydrogen, deuterium, halogen, C1-C18 alkyl, C1-C18 alkoxy, C1-C18 alkylsilyl, C1-C18 alkoxysilyl, substituted or unsubstituted C6-C40 aryl, C1-C40 heteroaryl, a substituted or unsubstituted C1-C60 heterospirocyclic ring, a substituted or unsubstituted C1-C60 spiro ring, a substituted or unsubstituted aryl ether group, a substituted or unsubstituted heteroaryl ether group, a substituted or unsubstituted arylamine group, a substituted or unsubstituted heteroarylamine group, substituted or unsubstituted arylsilyl, substituted or unsubstituted heteroarylsilyl, substituted or unsubstituted aryoxysilyl, substituted or unsubstituted arylacyl, substituted or unsubstituted heteroaryl acyl or substituted or unsubstituted phosphinyl, wherein n is an integer from 0 to 10;
X is selected from C, O, N, S or Se;
the dashed line represents attachment to the N atom and the B atom in Formula (I) to form chemical bonds; and
undeuterated groups in the above structures can be partially or fully deuterated.

6. The spiro compound according to claim 1 or 2, wherein the spiro compound is selected from the group consisting of:

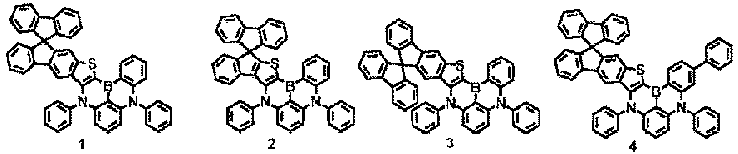

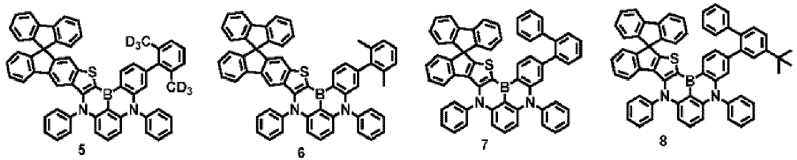

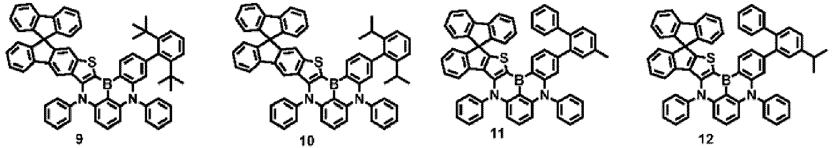

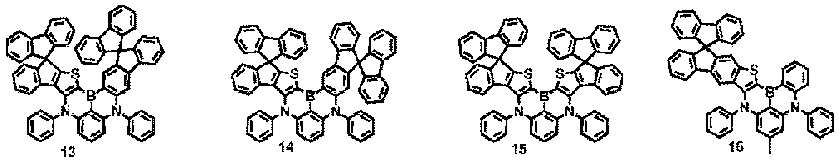

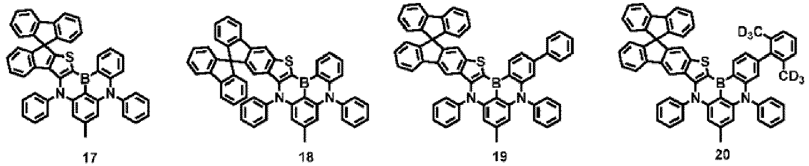

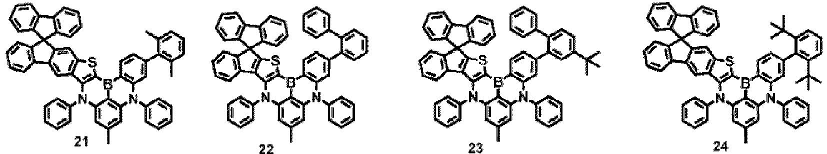

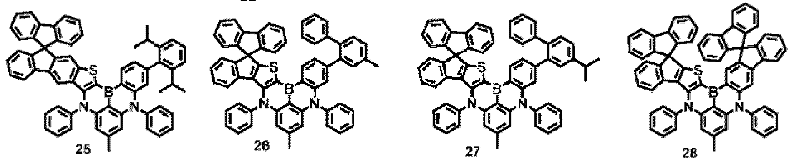

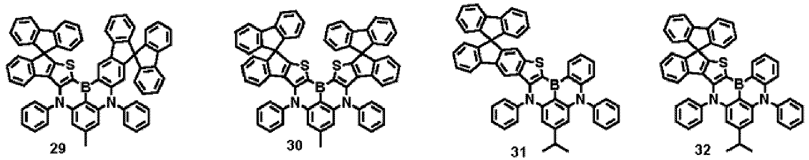

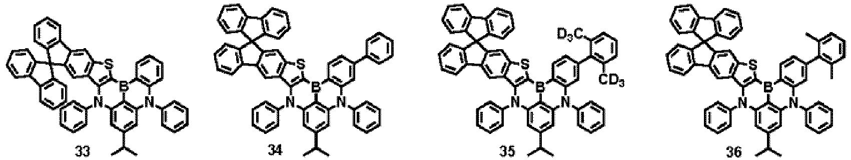

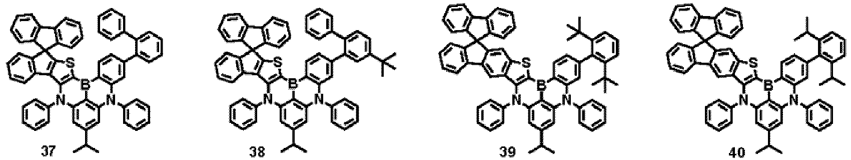

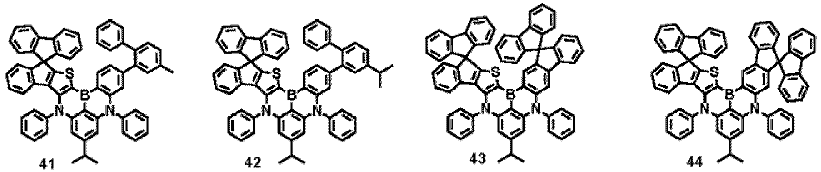

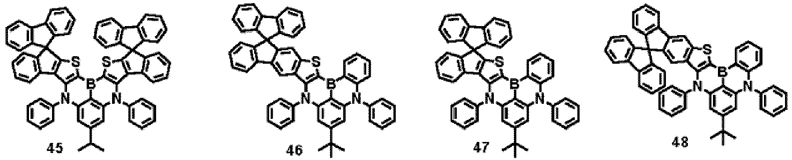

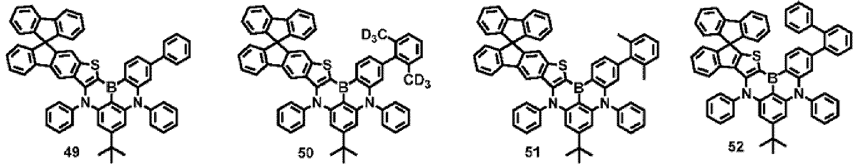

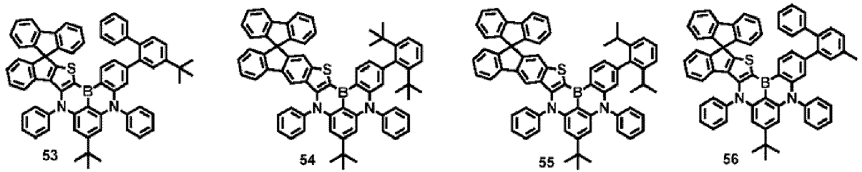

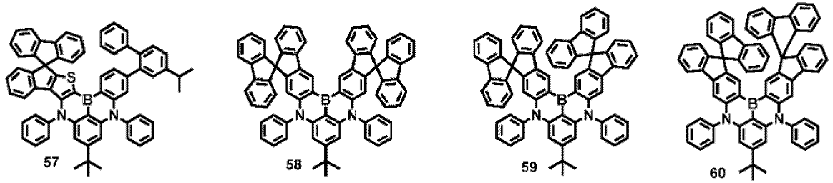

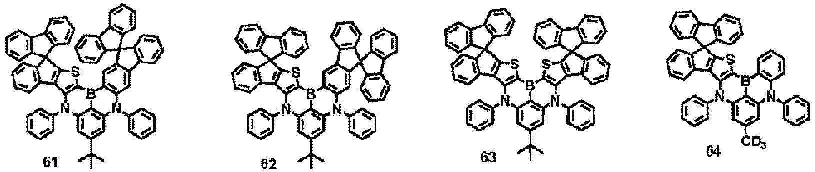

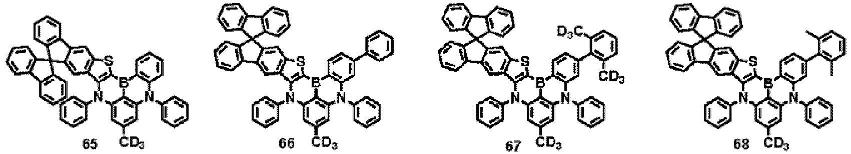

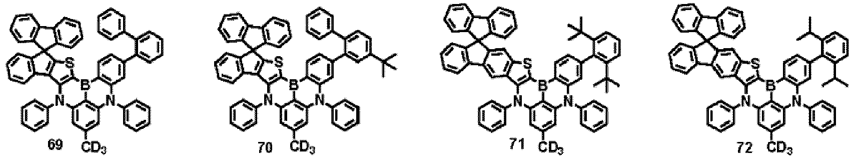

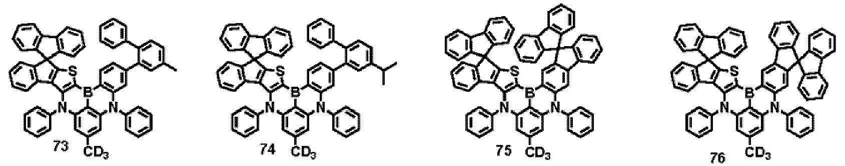

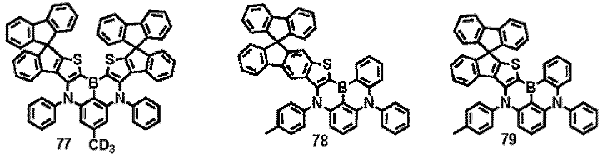

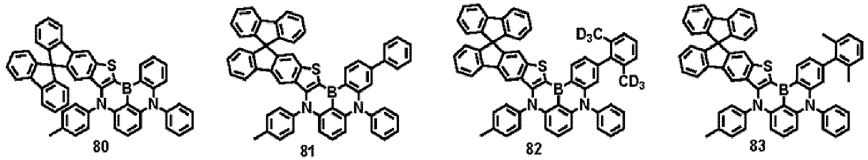

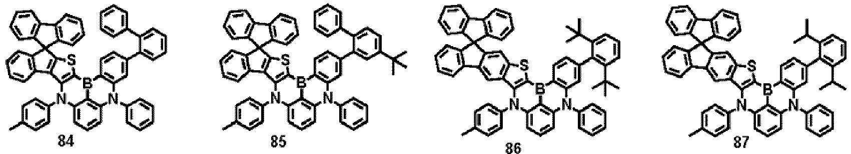

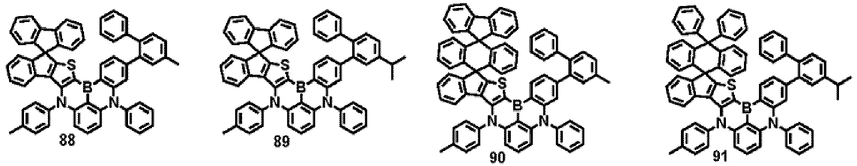

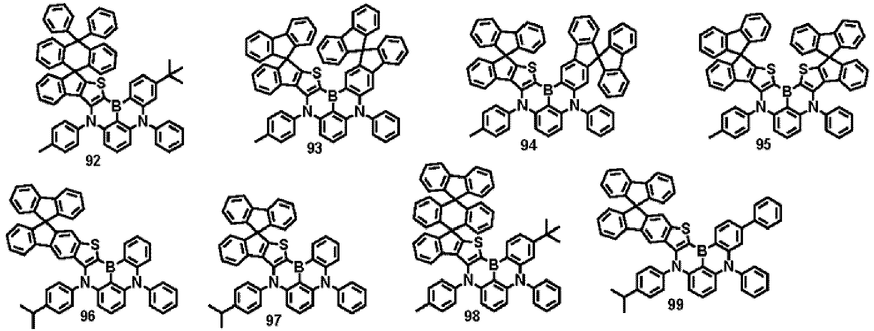

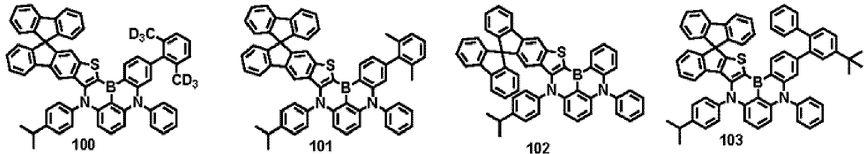

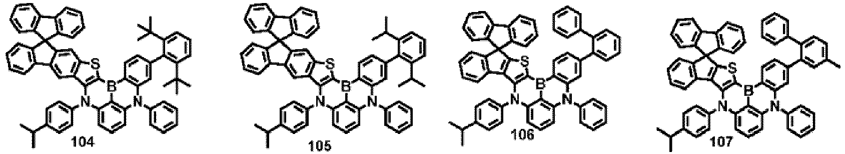

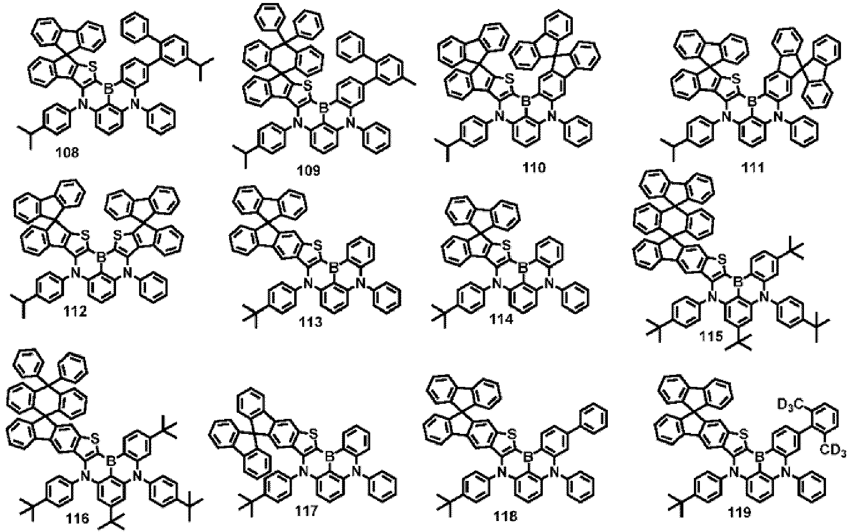

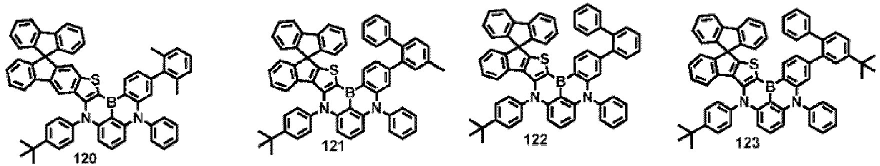

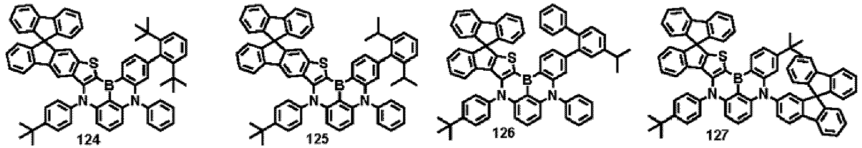

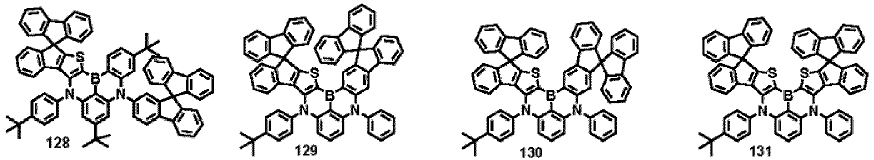

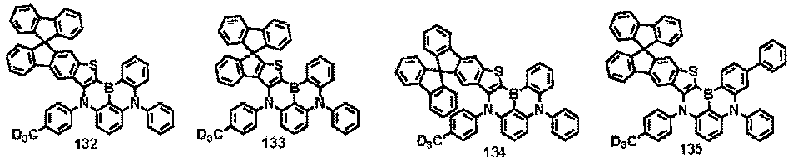

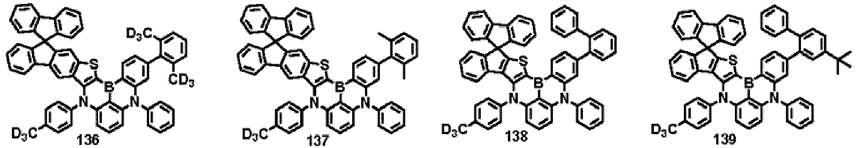

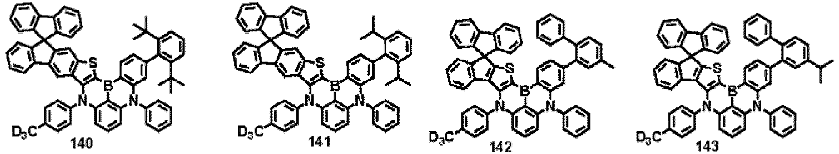

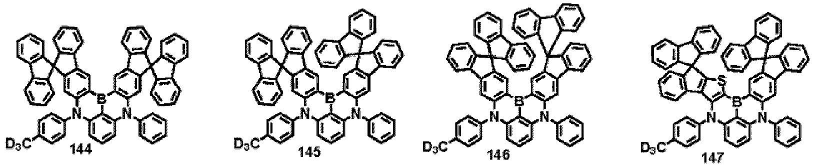

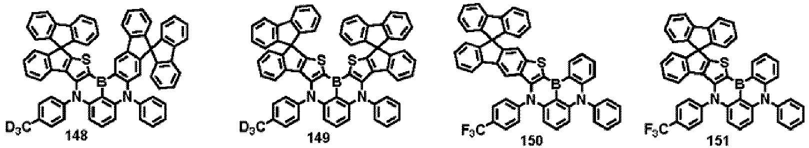

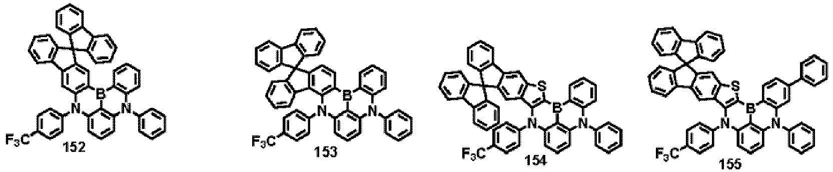

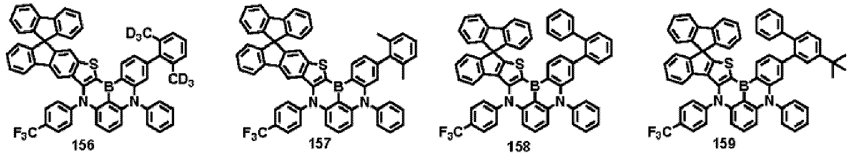

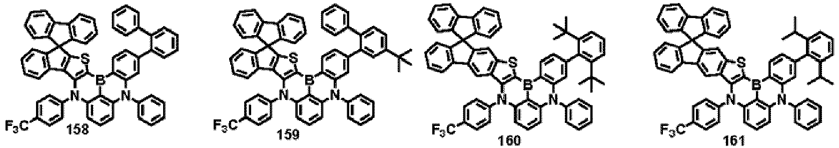

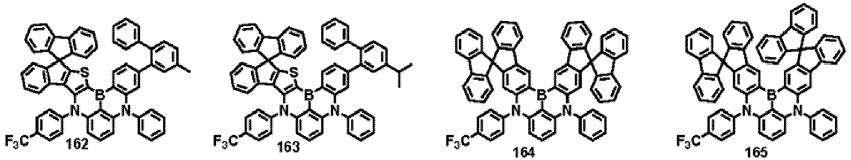

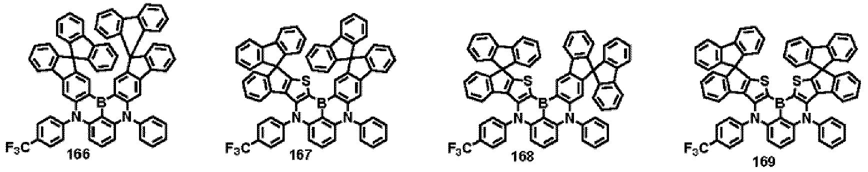

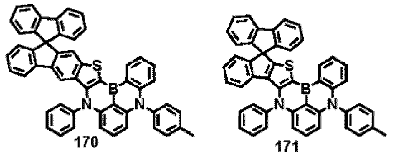

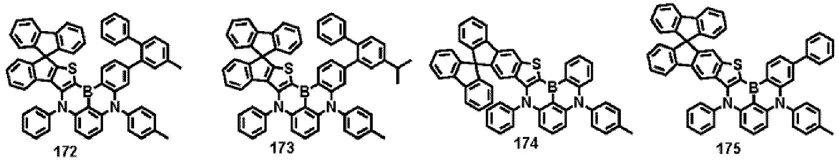

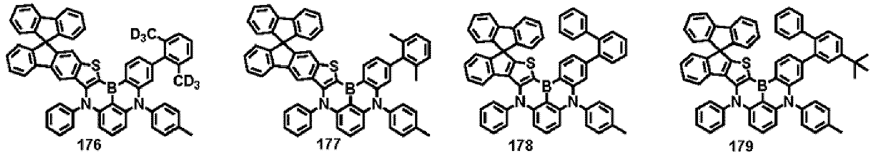

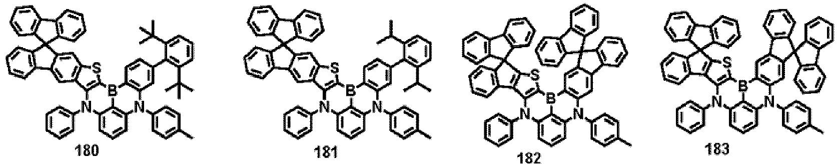

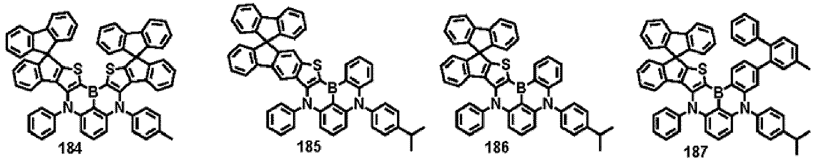

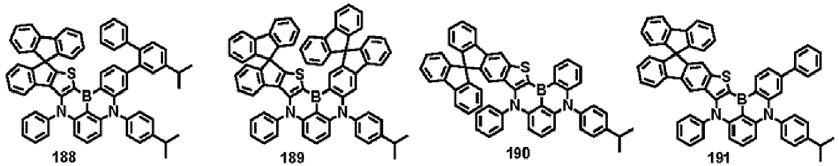

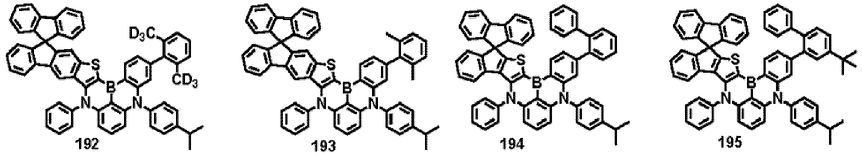

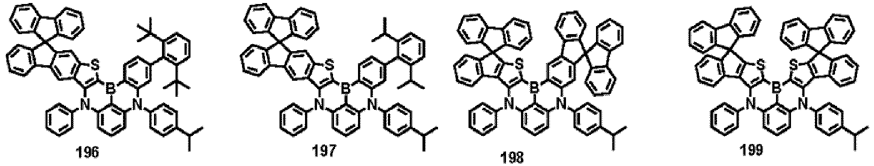

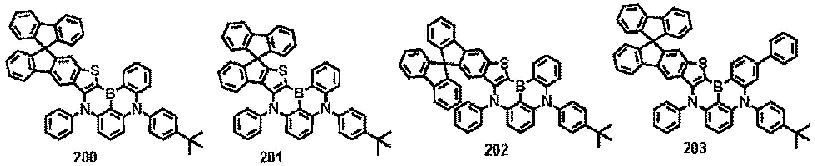

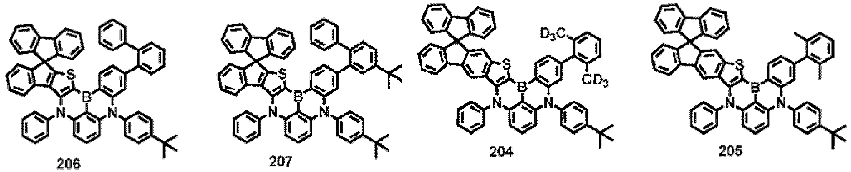

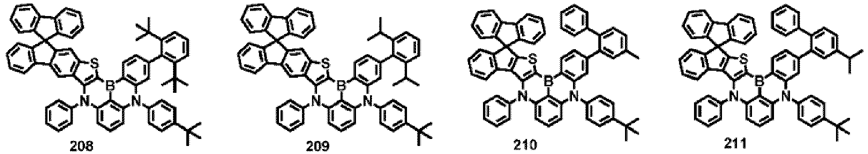

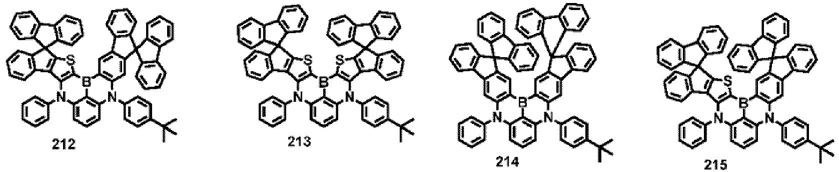

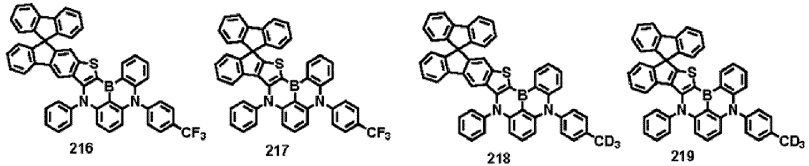

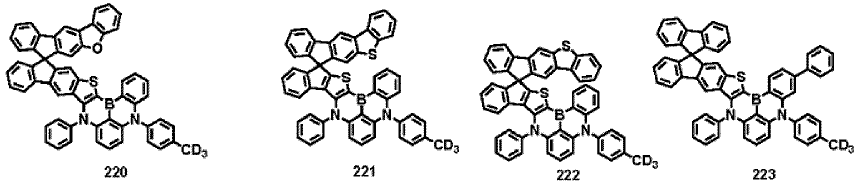

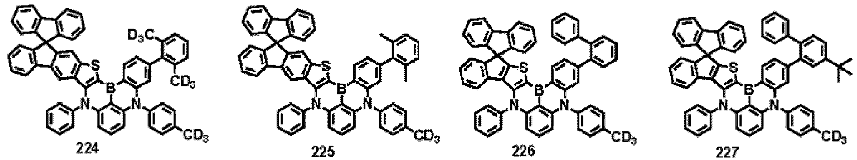

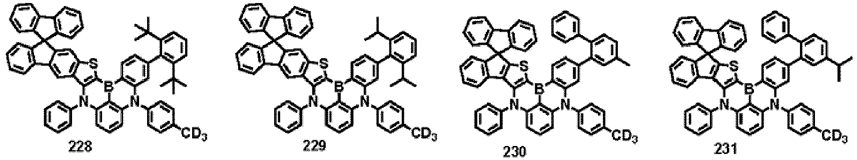

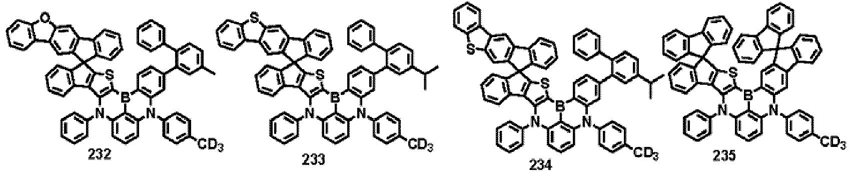

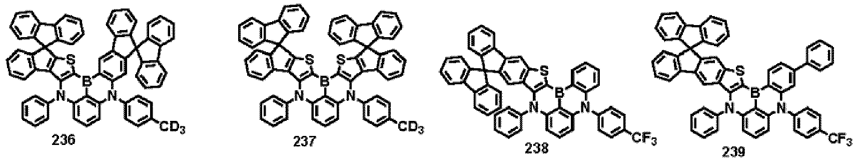

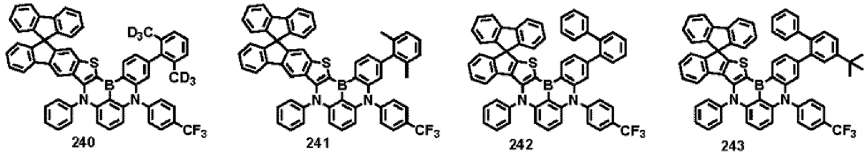

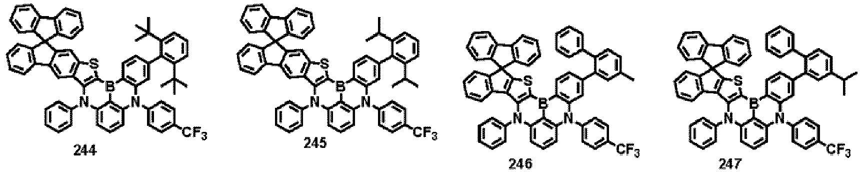

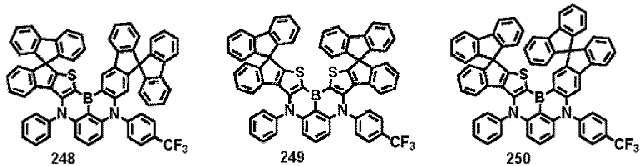

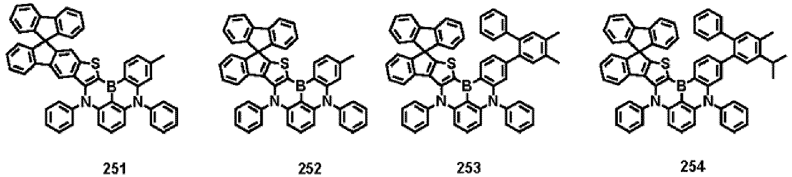

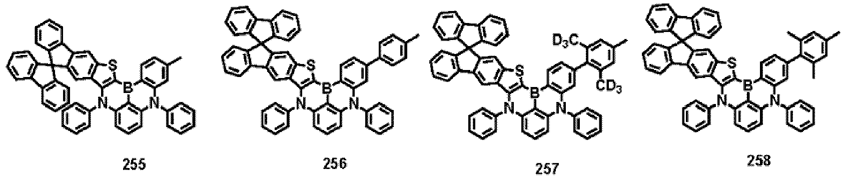

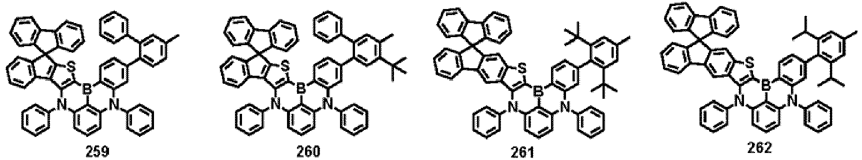

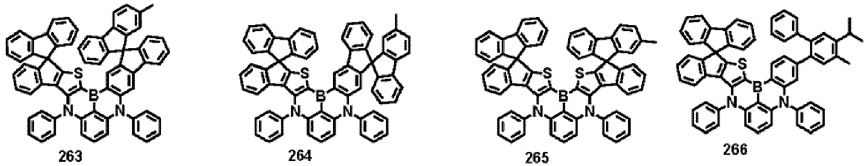

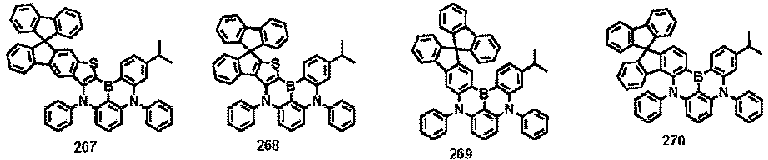

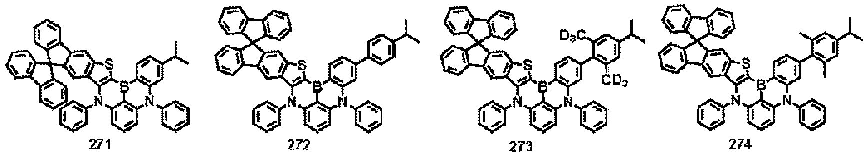

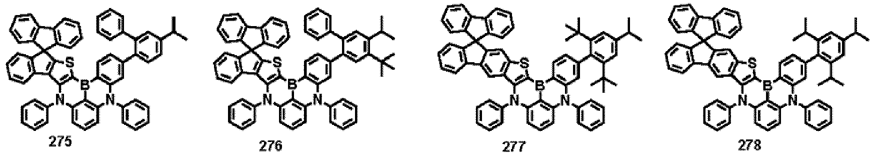

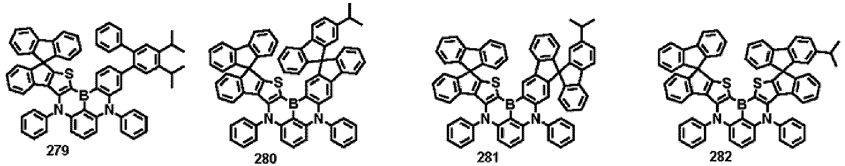

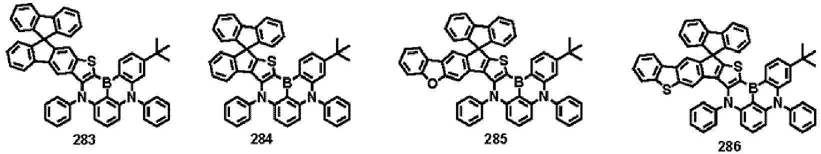

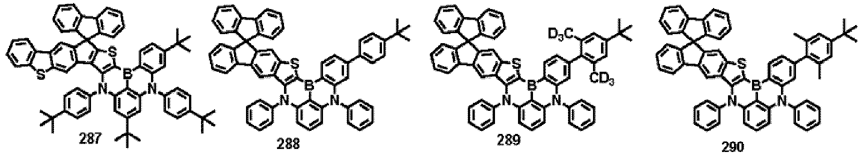

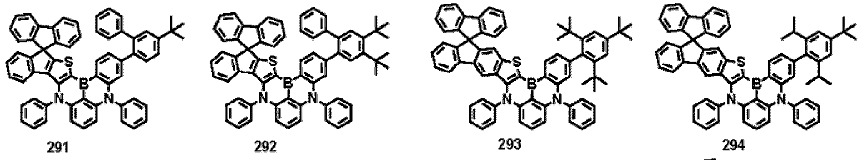

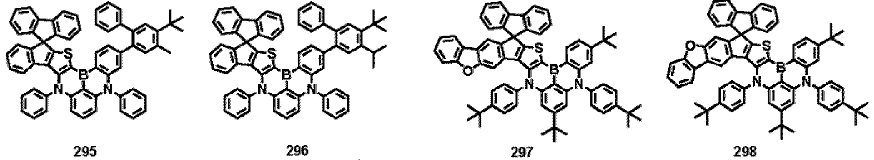

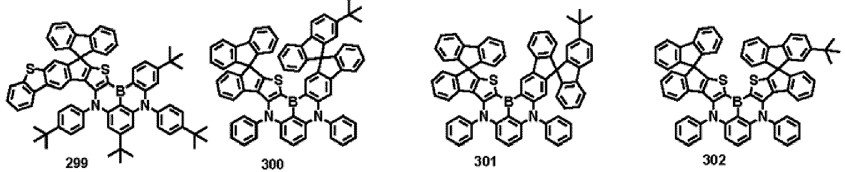

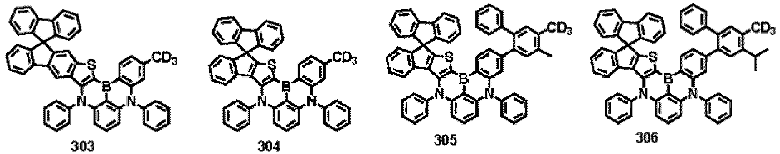

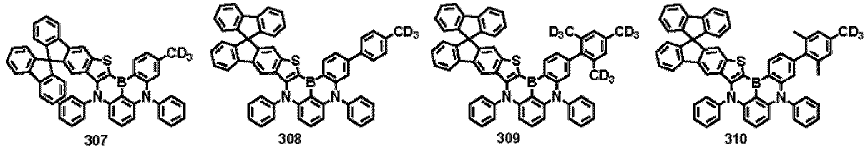

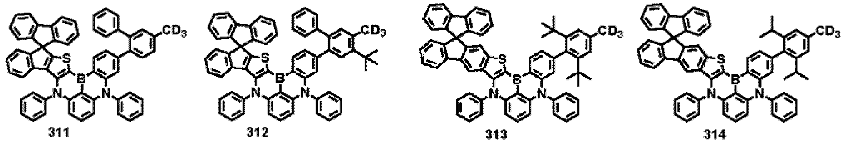

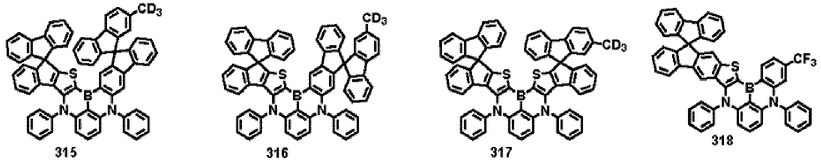

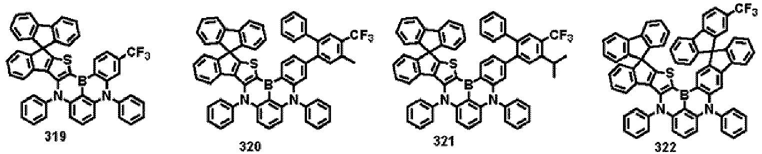

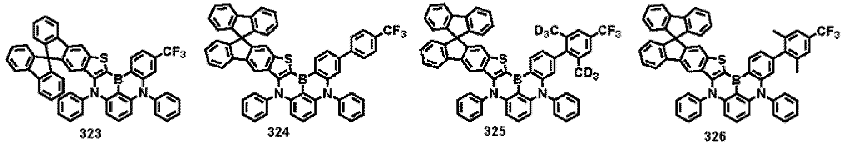

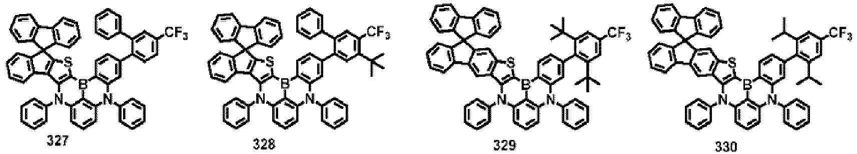

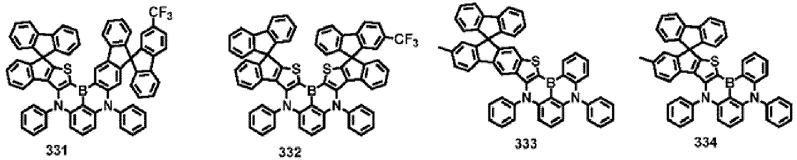

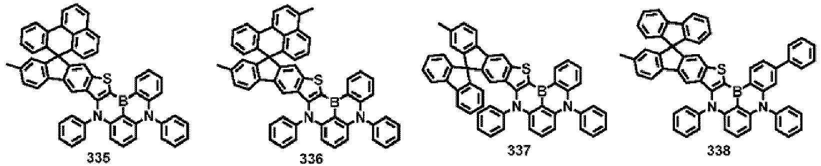

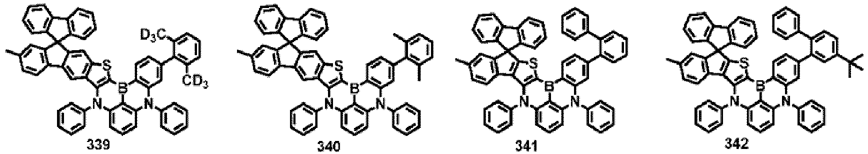

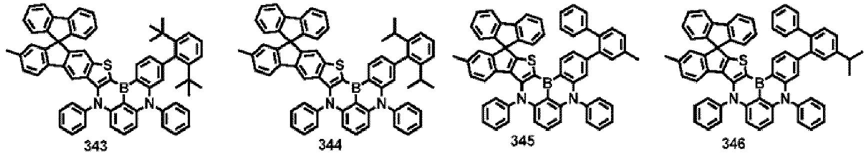

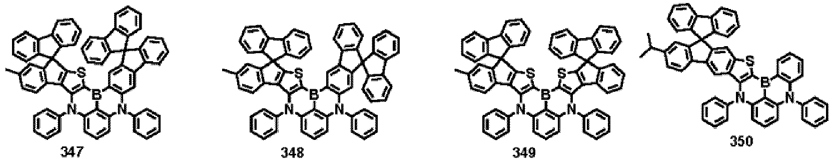

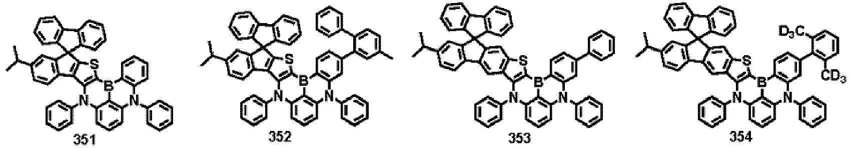

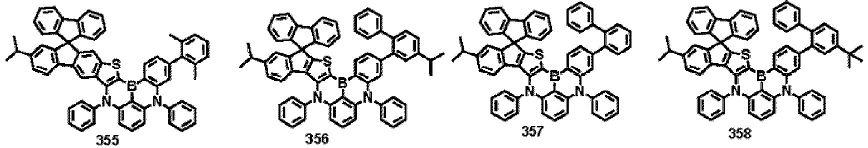

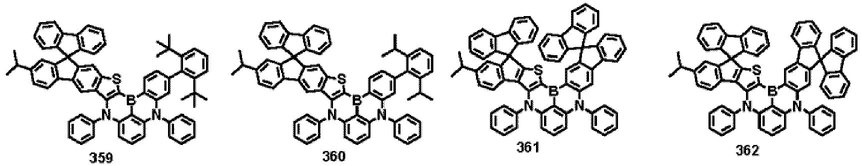

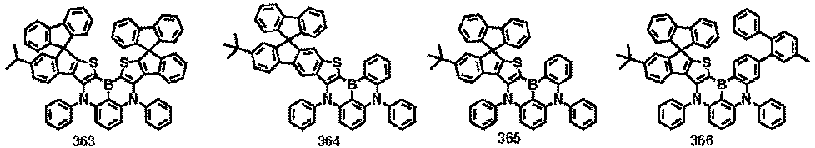

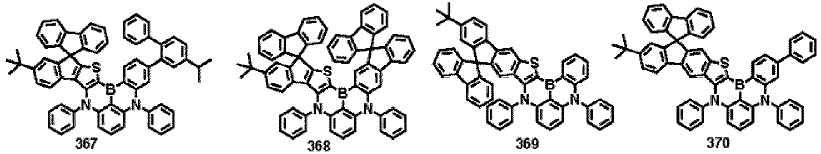

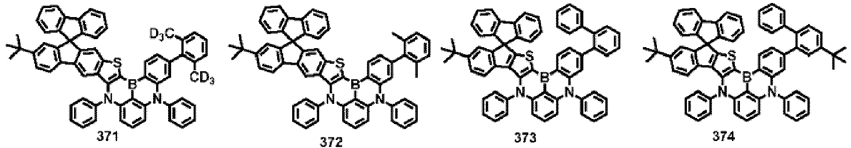

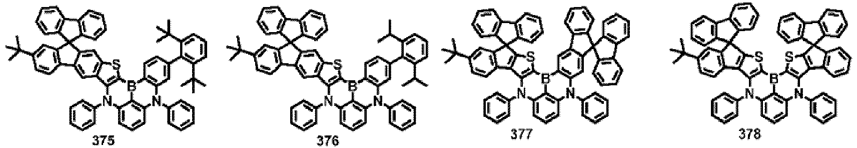

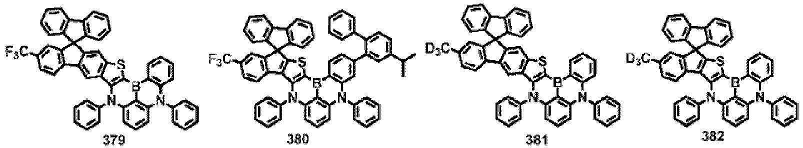

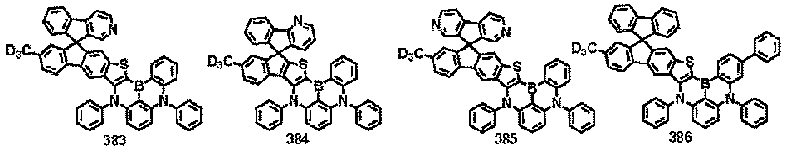

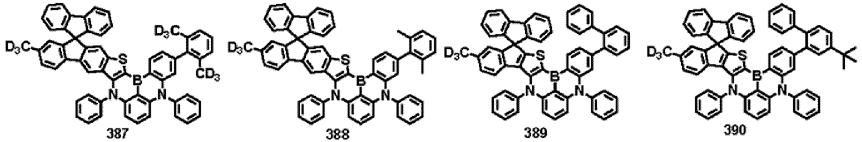

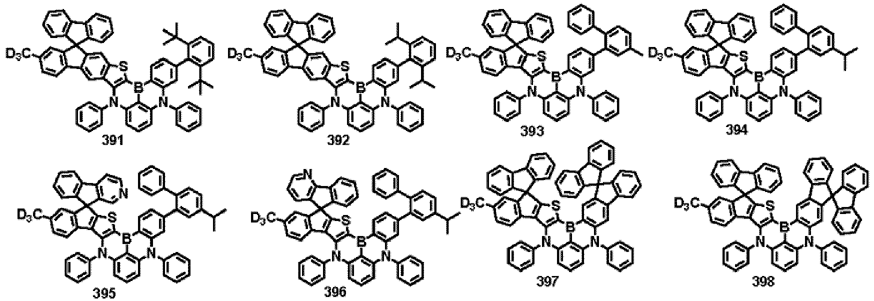

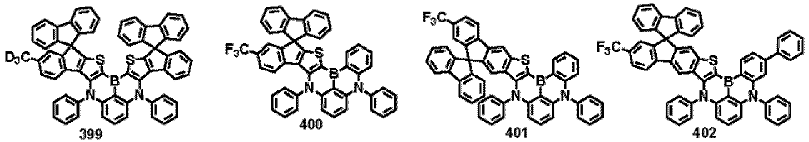

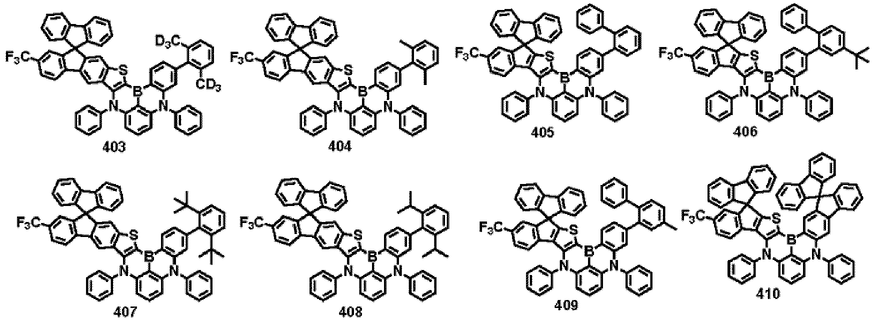

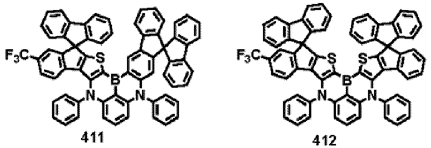

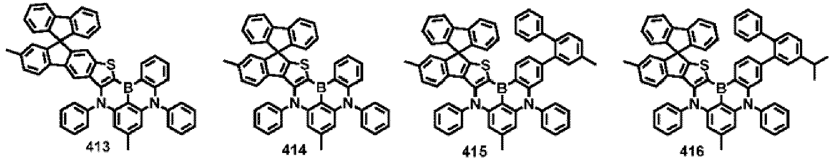

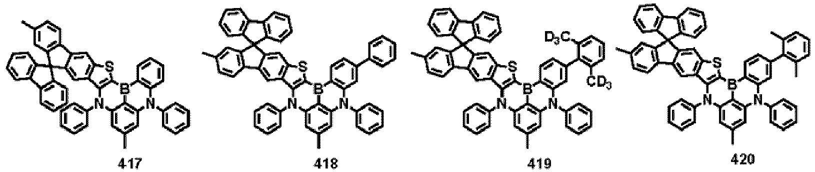

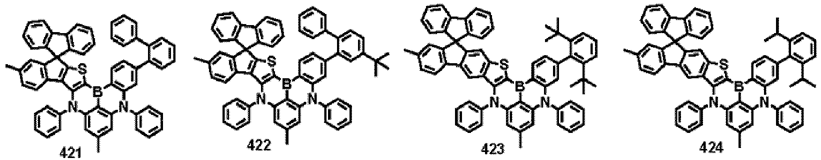

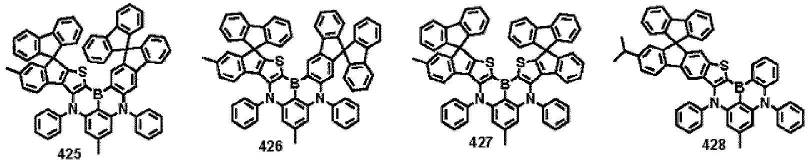

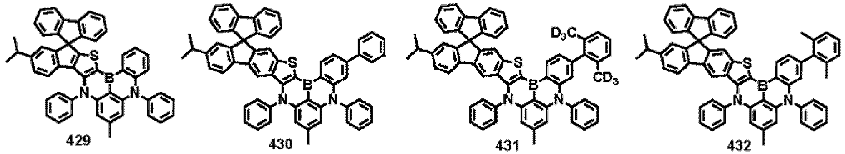

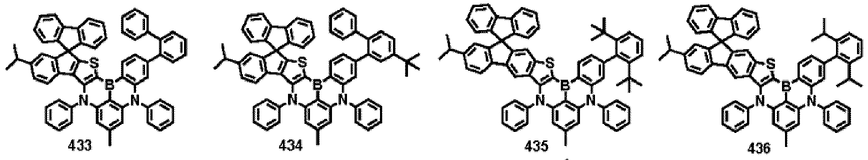

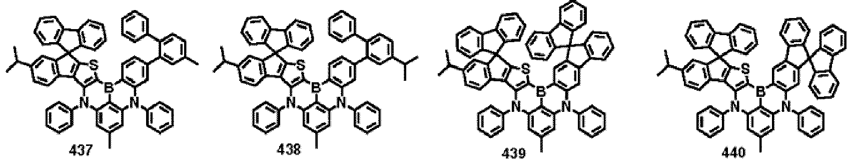

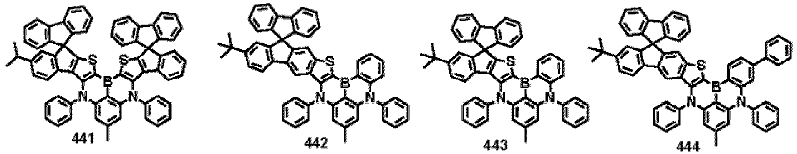

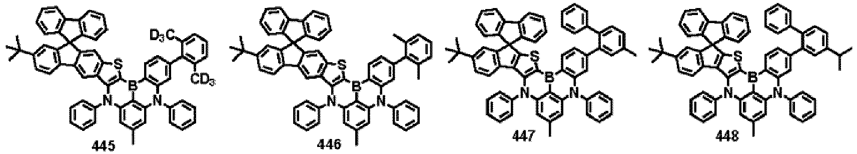

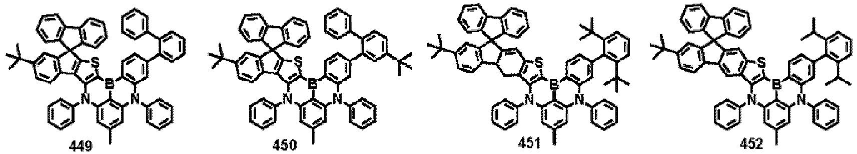

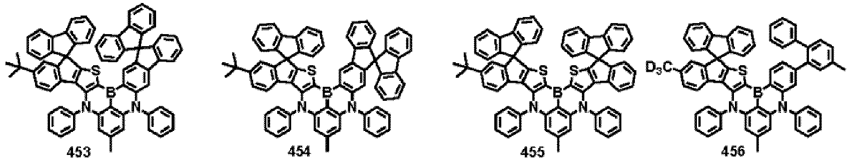

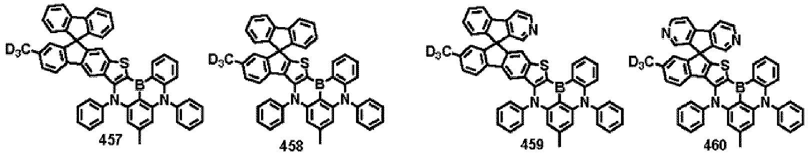

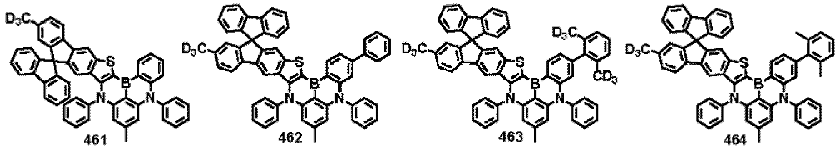

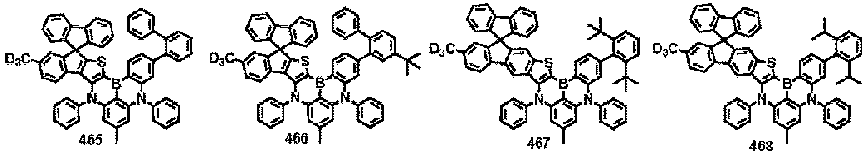

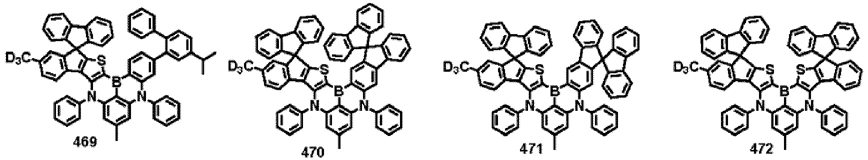

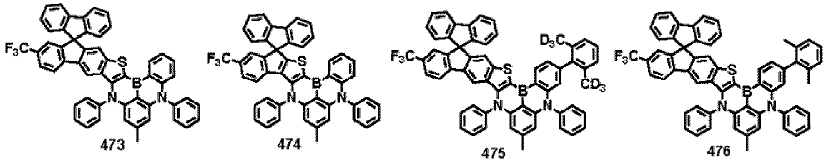

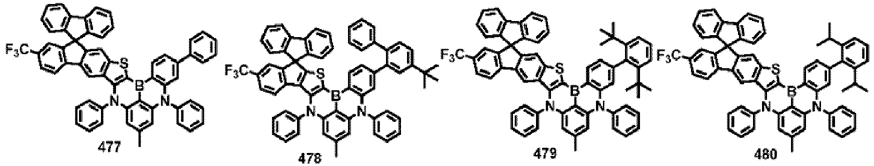

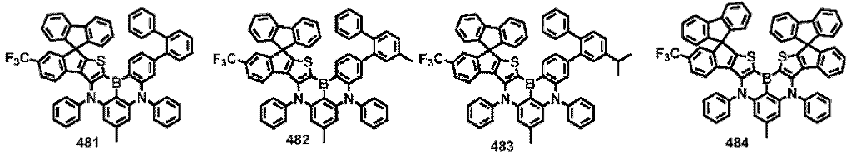

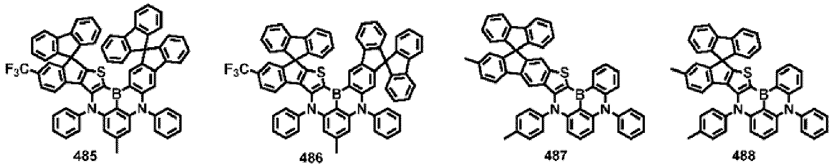

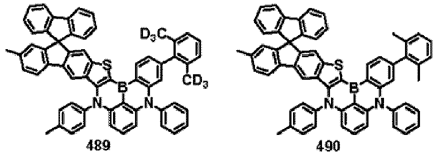

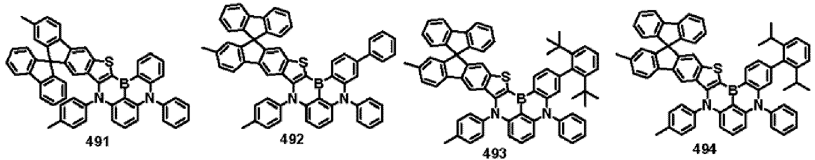

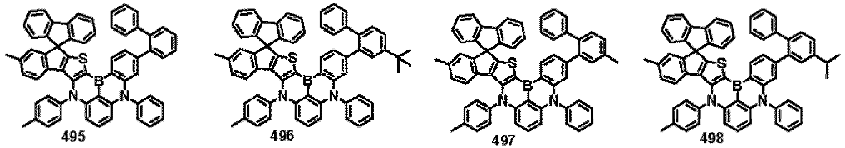

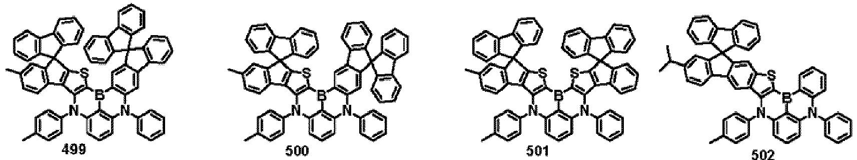

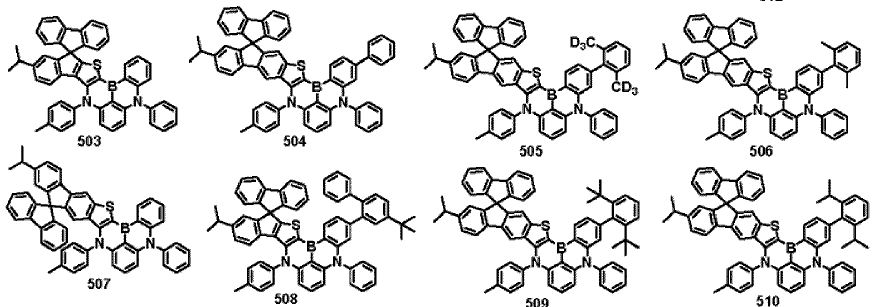

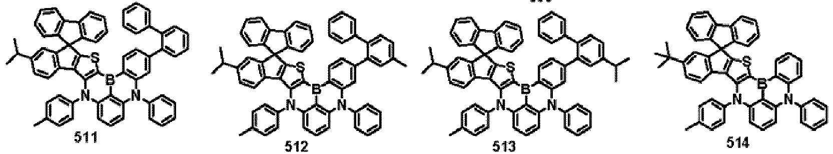

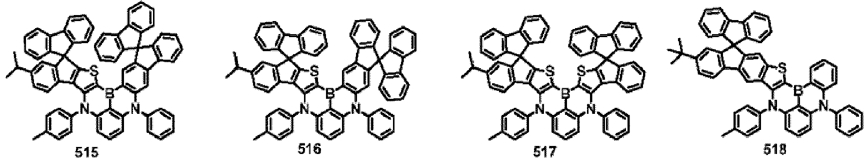

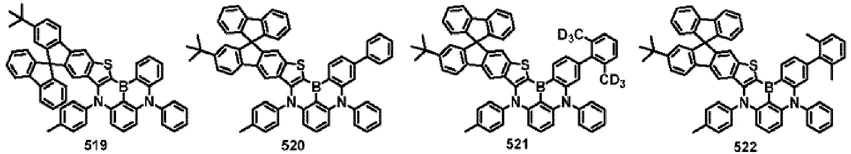

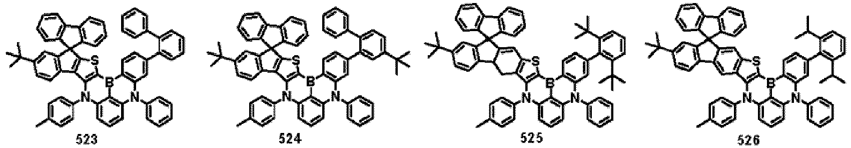

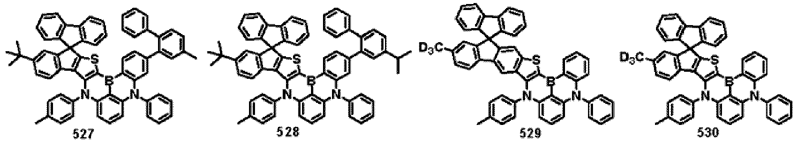

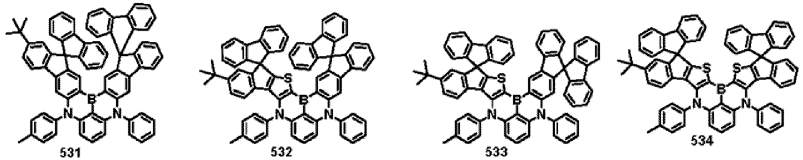

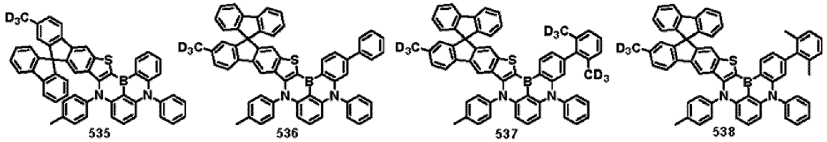

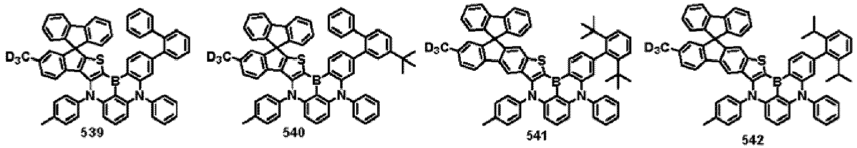

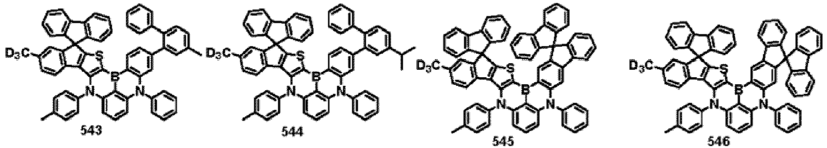

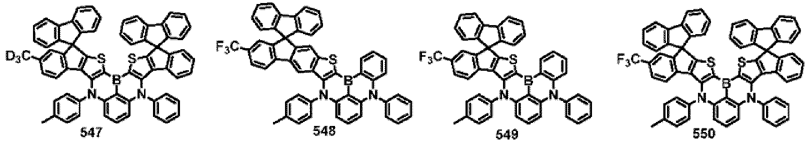

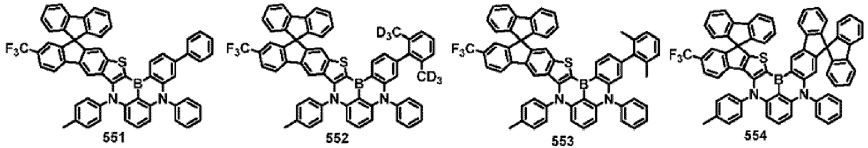

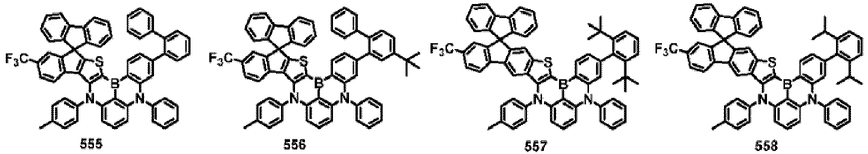

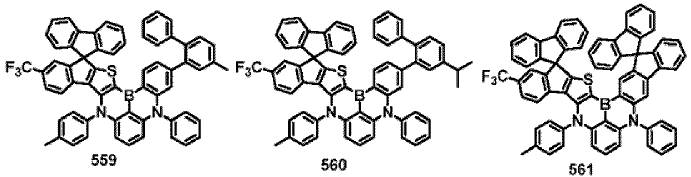

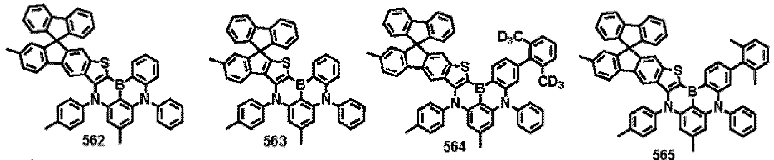

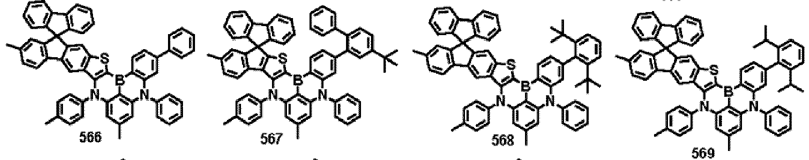

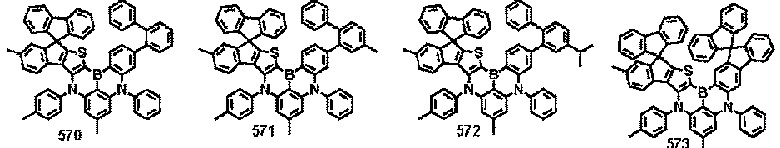

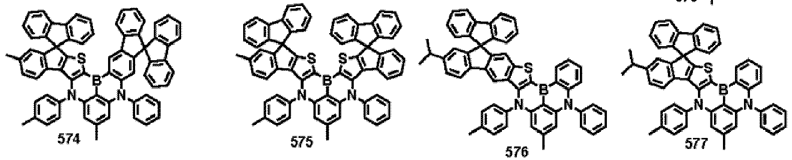

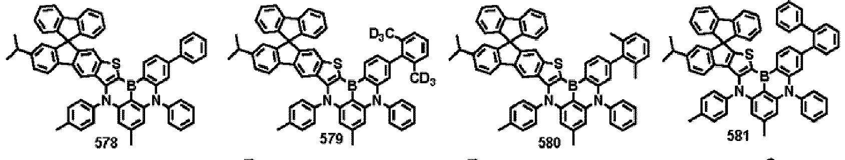

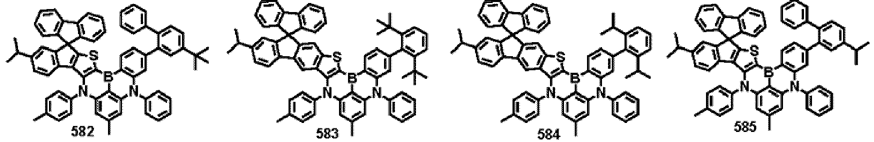

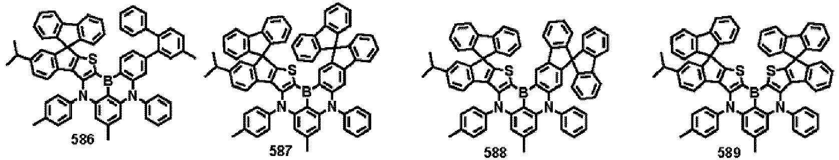

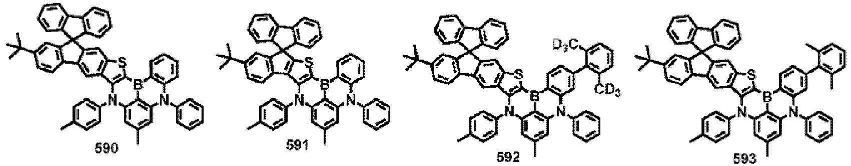

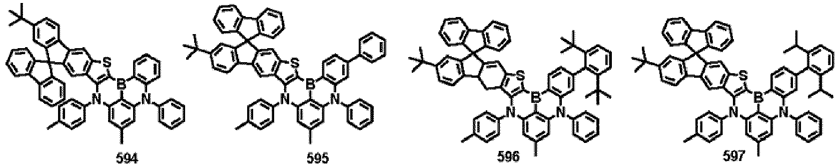

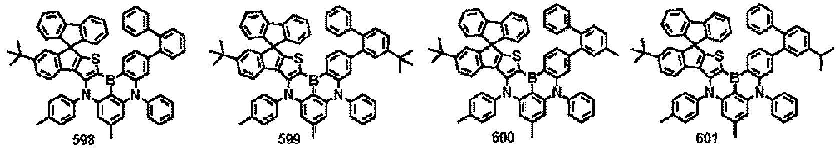

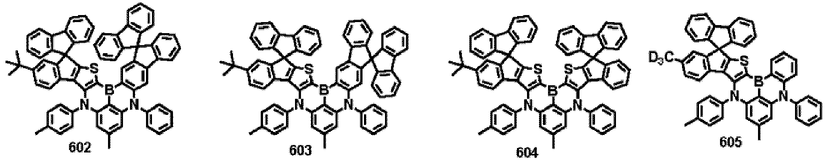

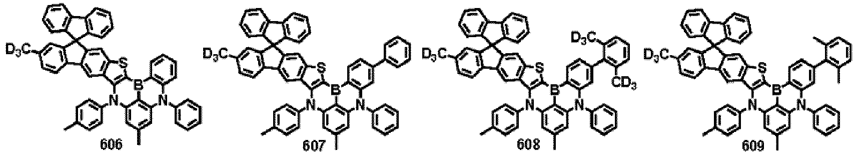

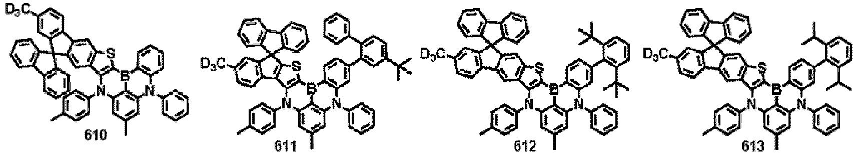

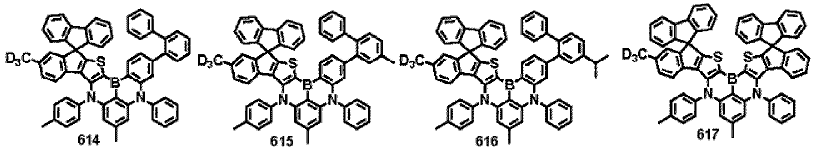

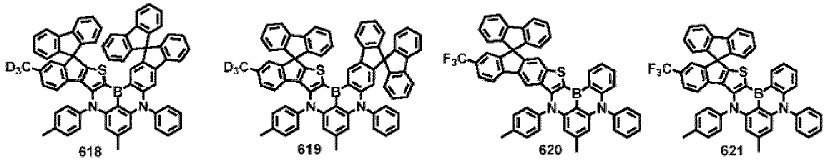

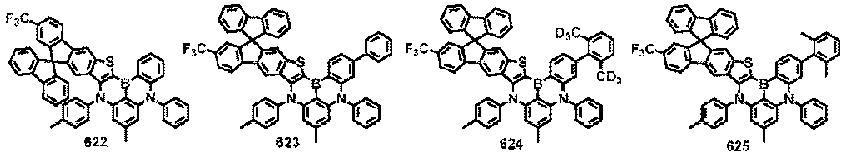

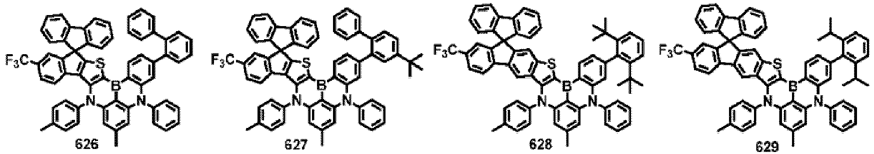

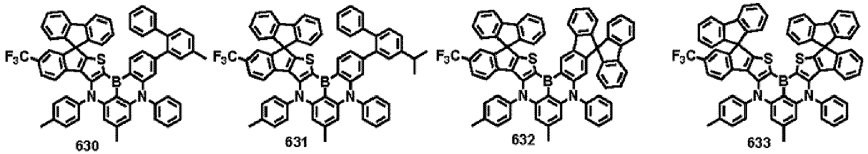

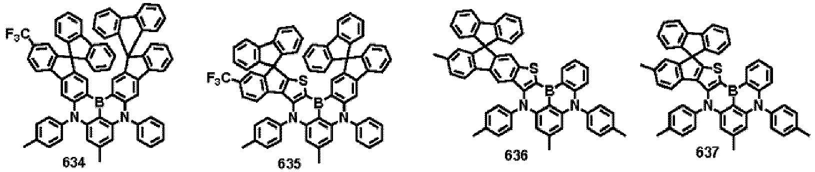

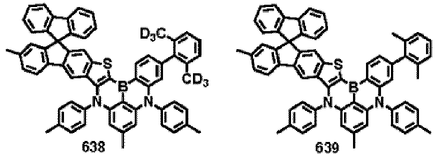

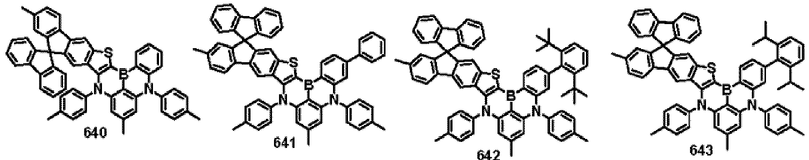

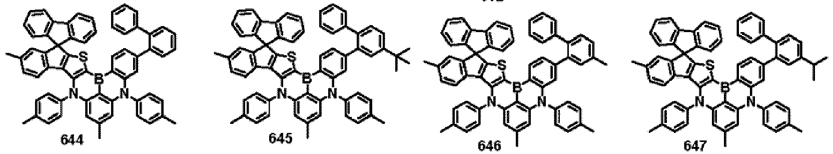

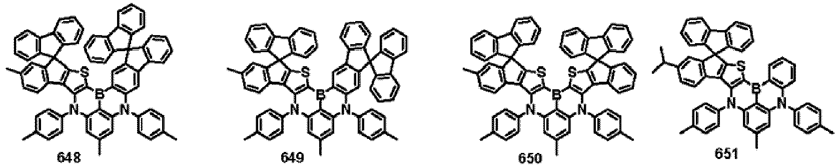

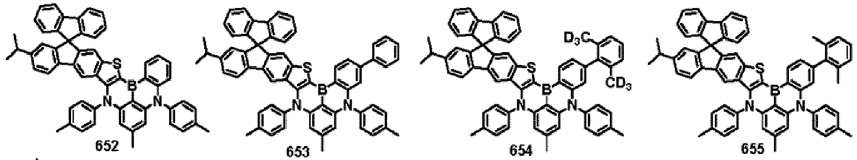

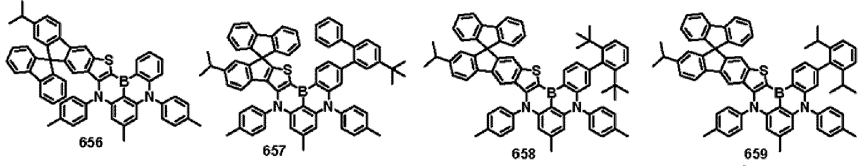

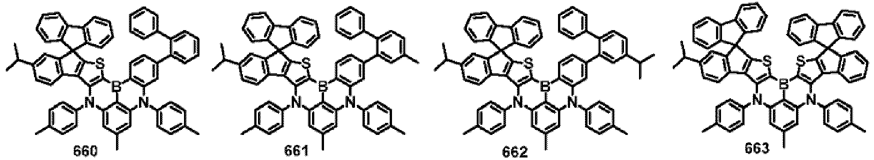

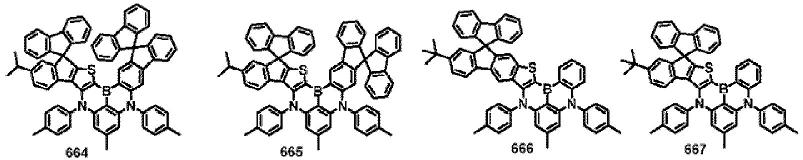

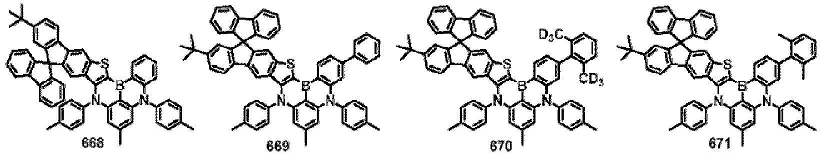

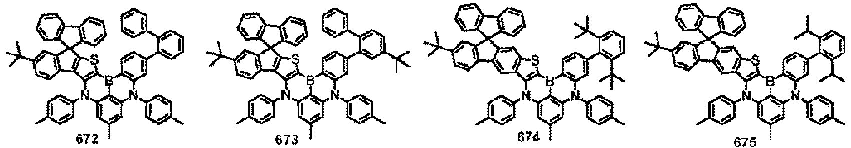

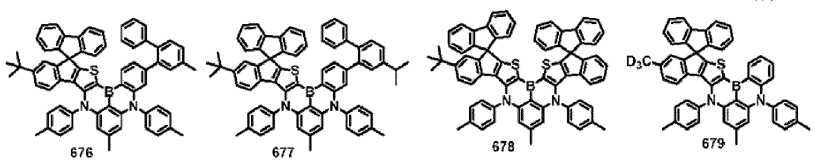

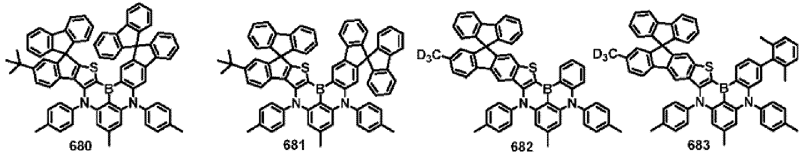

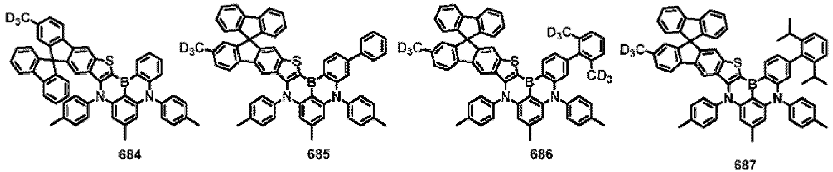

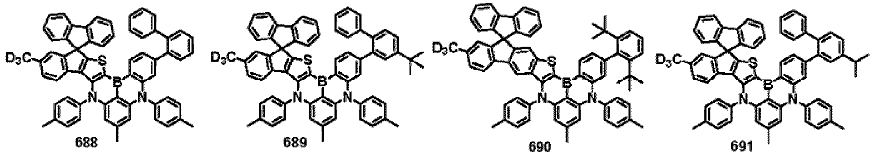

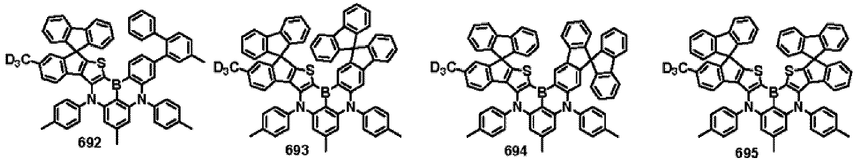

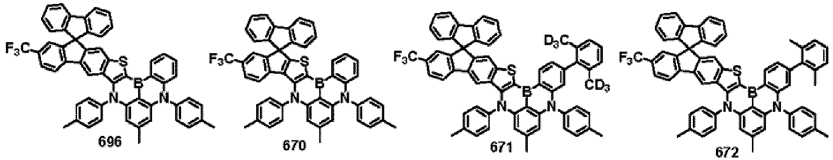

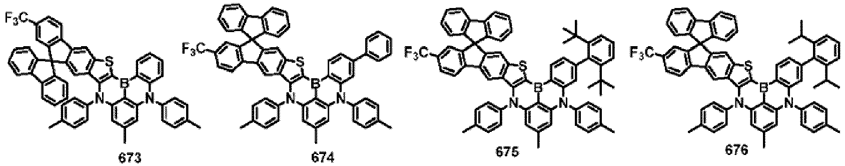

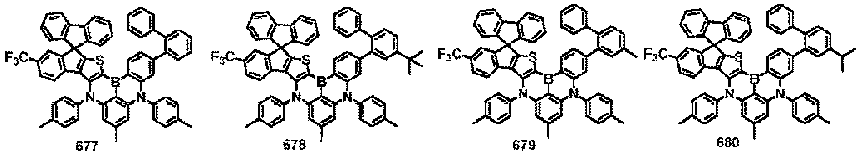

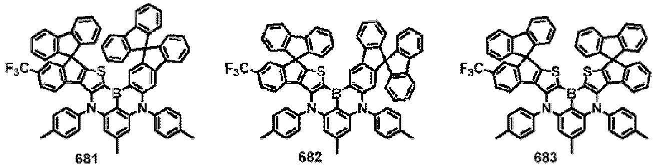

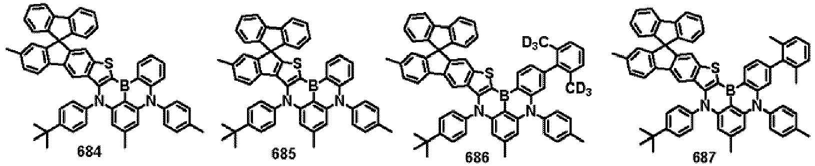

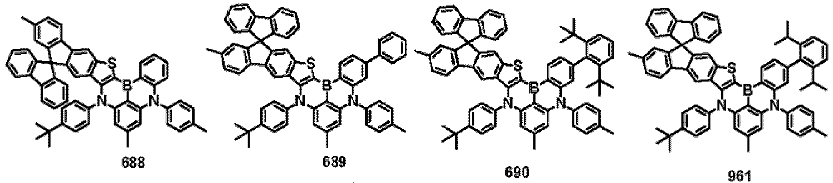

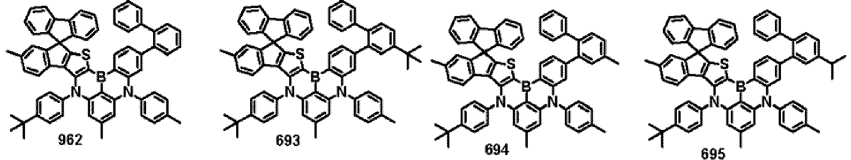

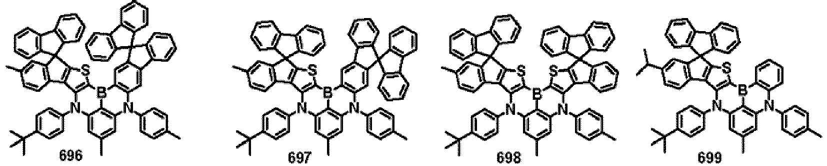

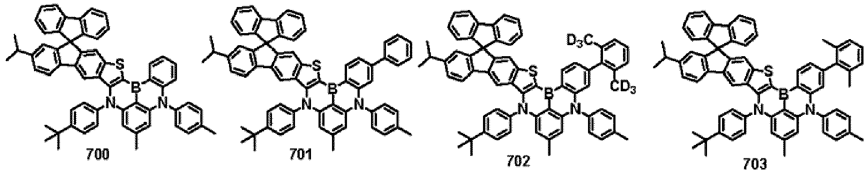

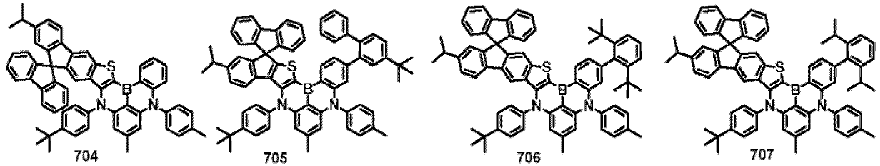

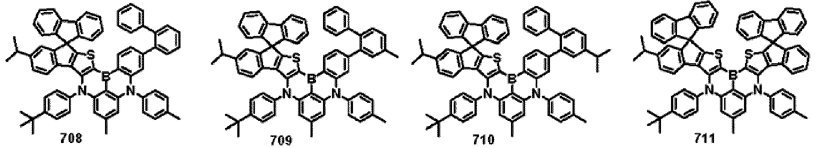

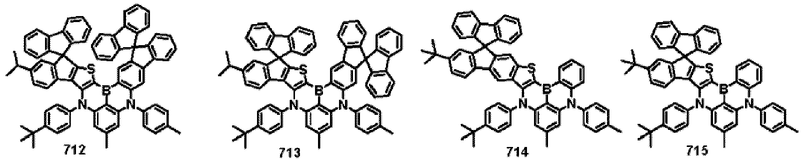

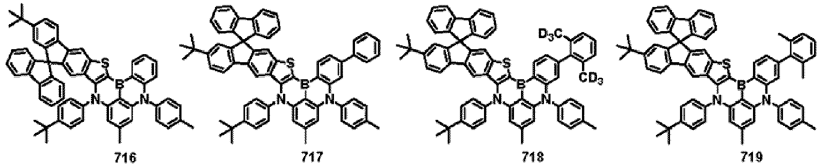

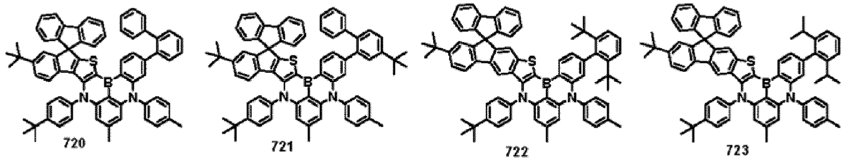

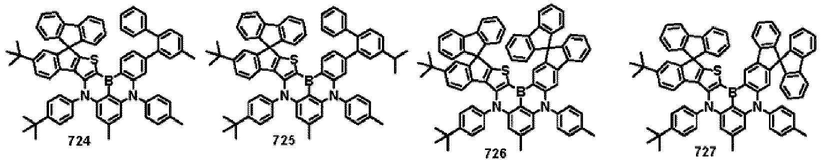

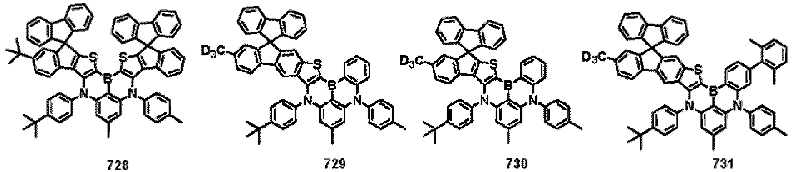

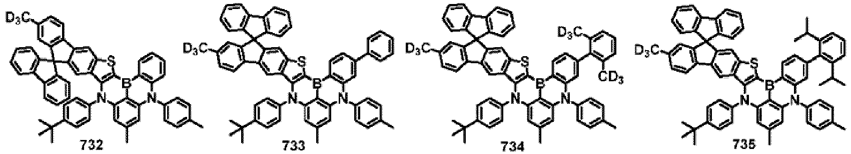

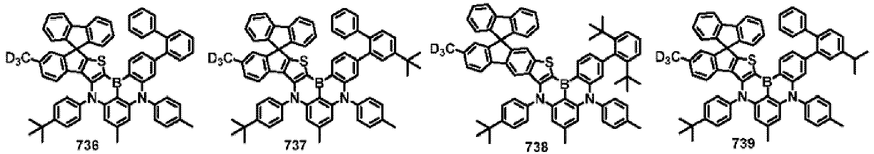

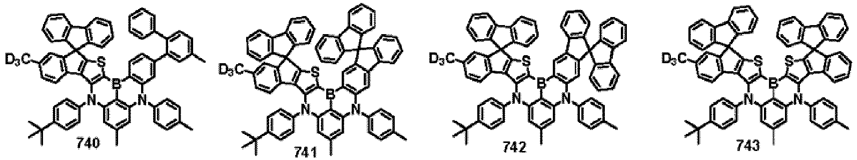

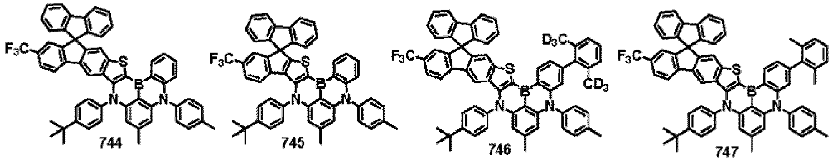

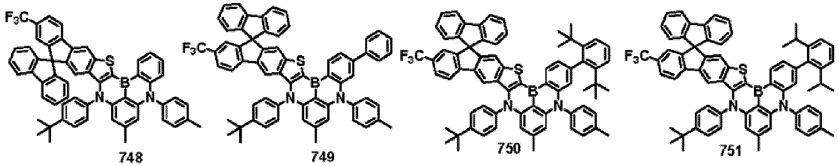

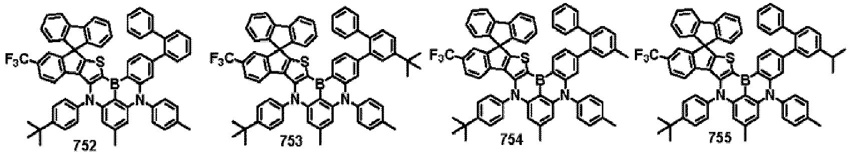

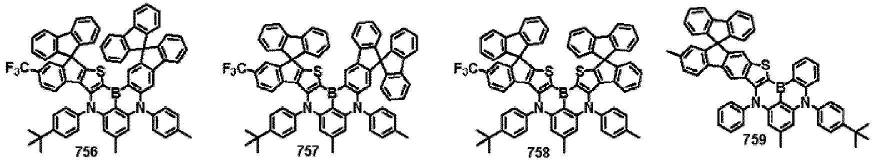

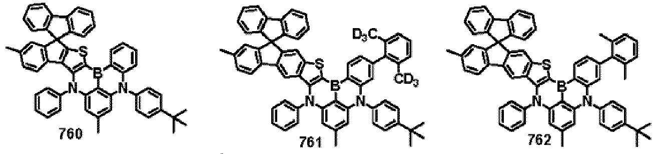

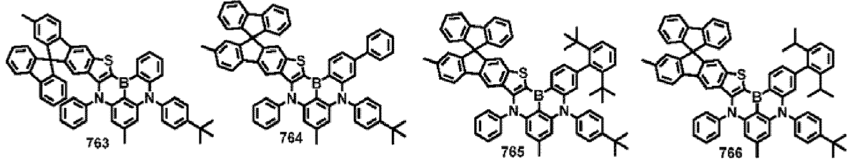

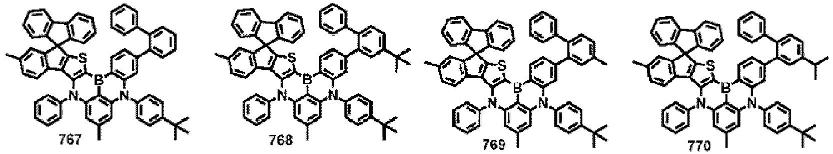

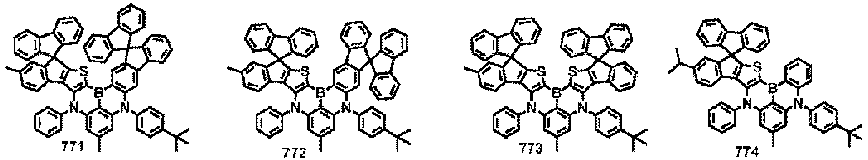

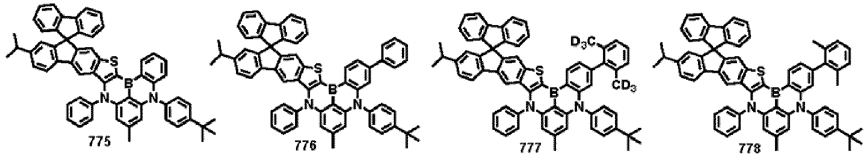

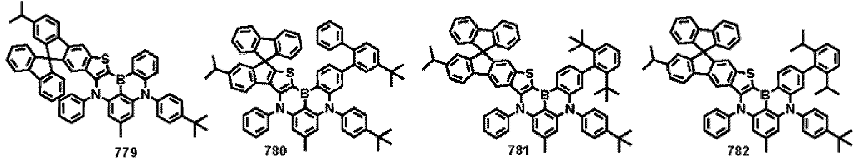

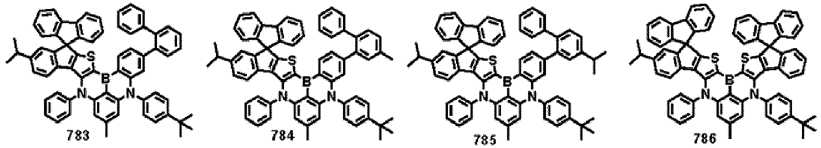

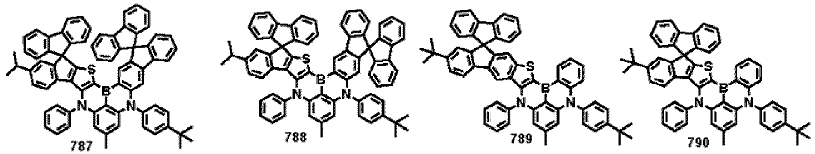

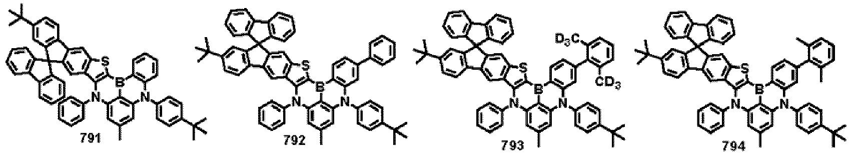

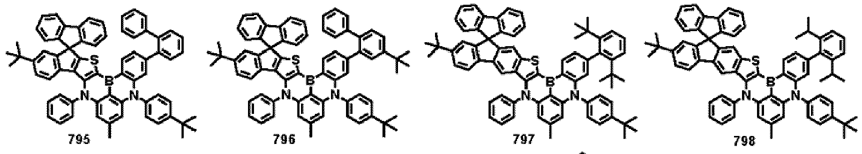

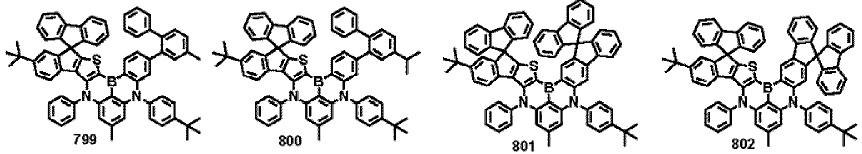

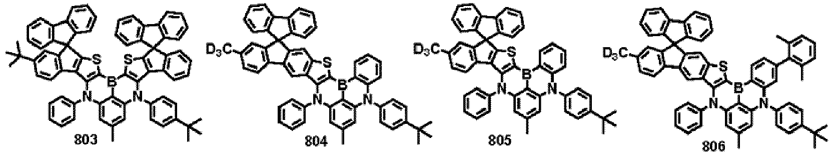

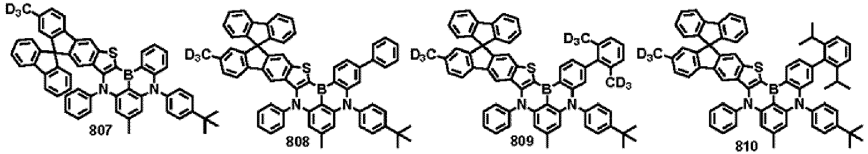

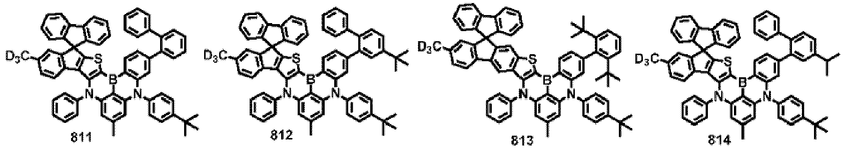

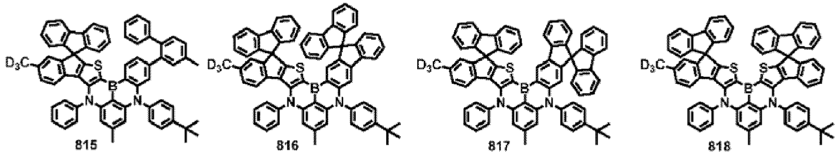

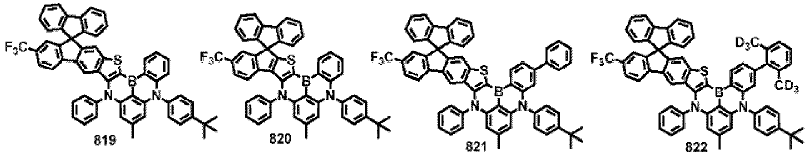

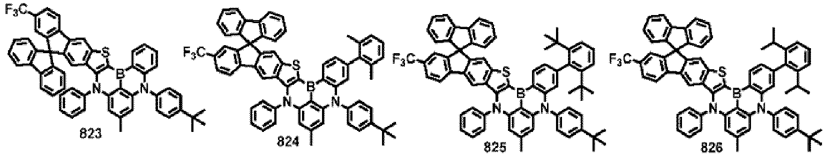

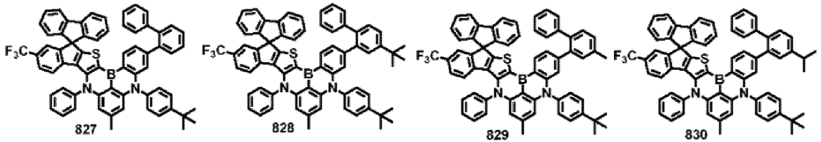

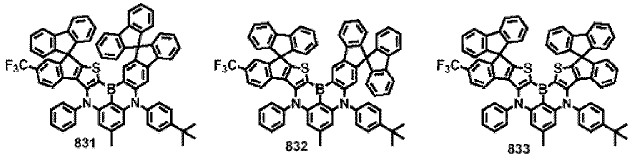

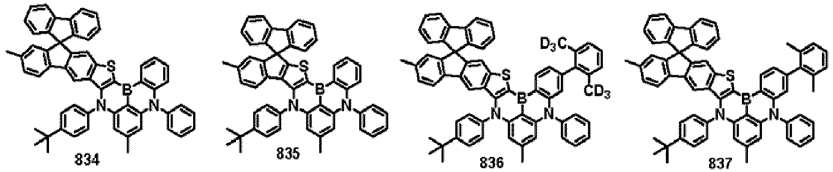

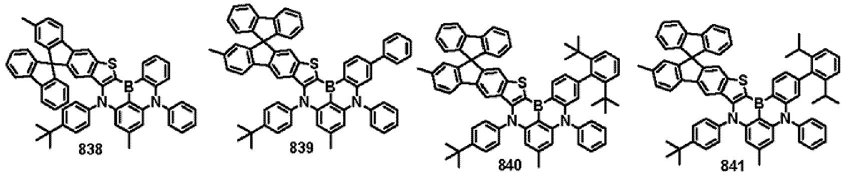

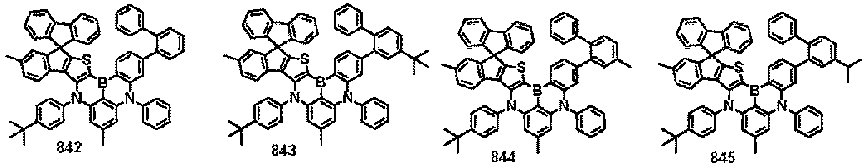

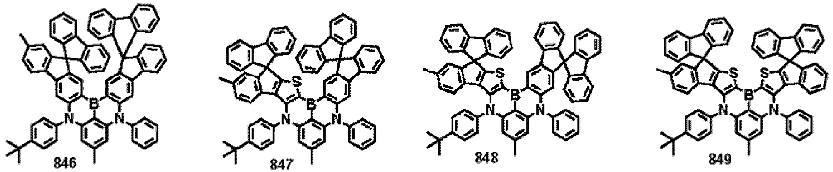

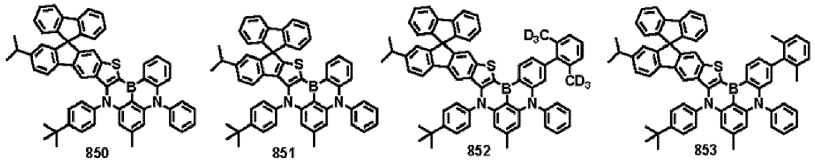

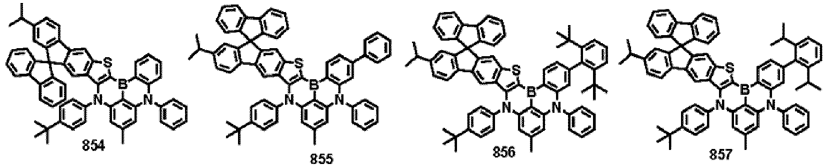

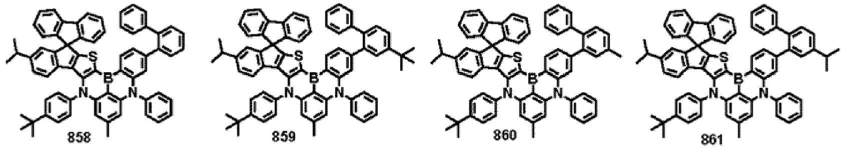

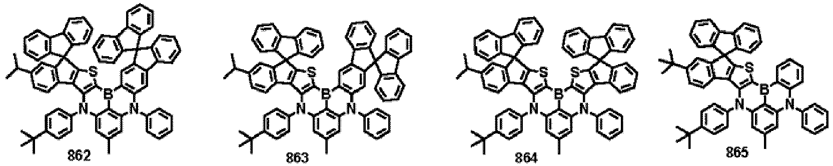

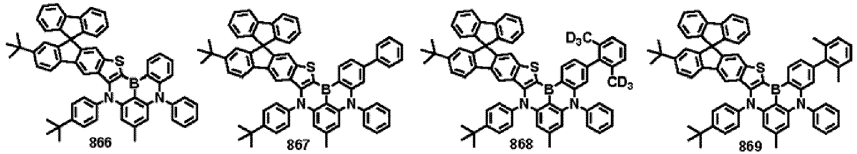

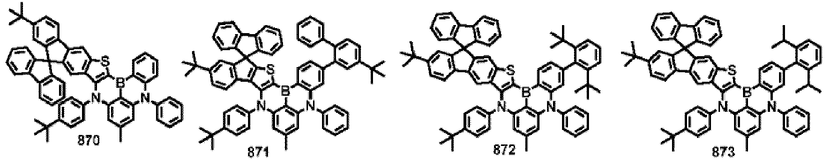

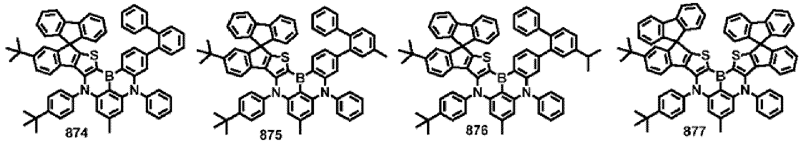

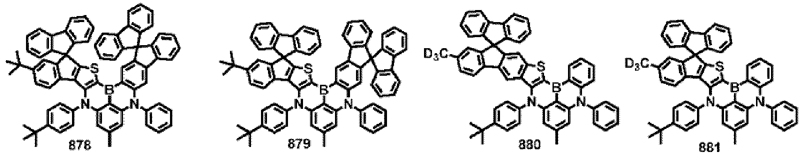

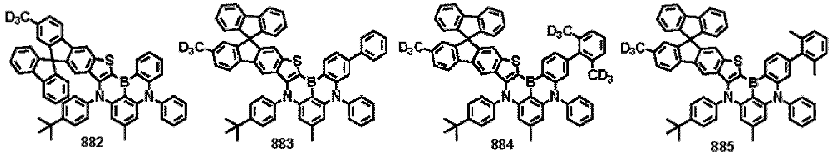

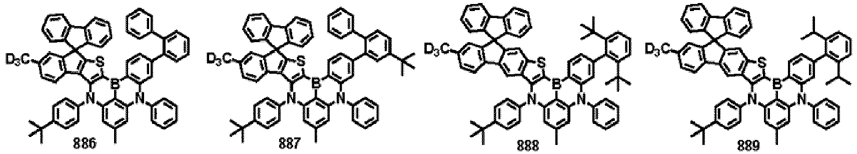

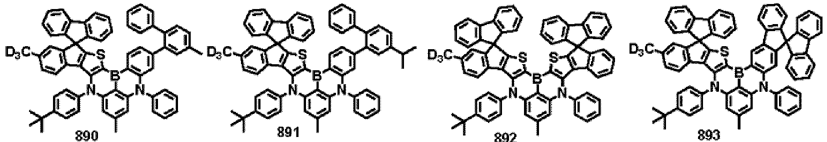

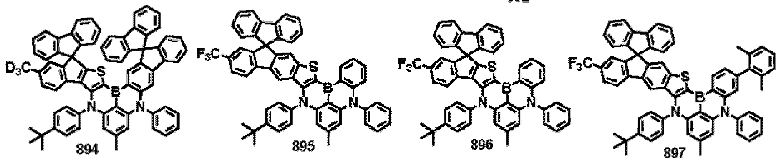

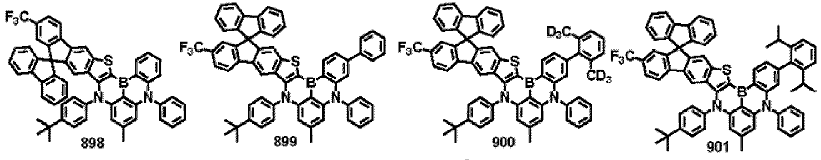

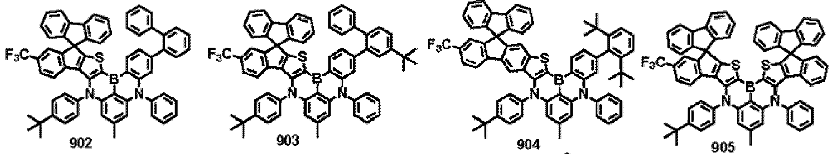

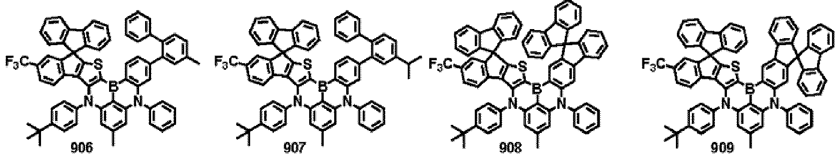

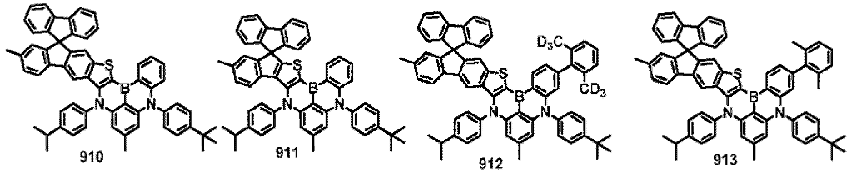

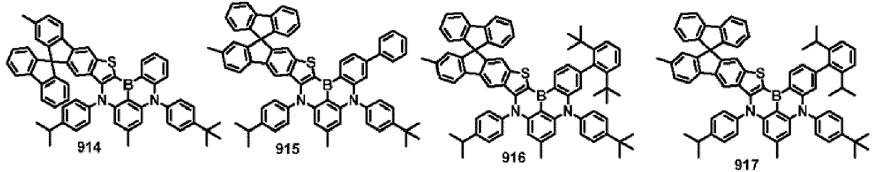

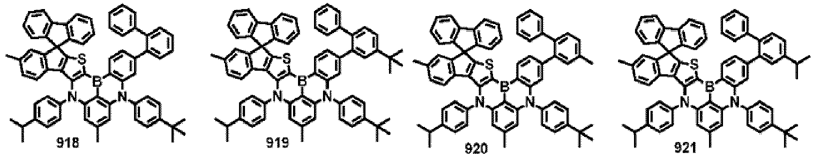

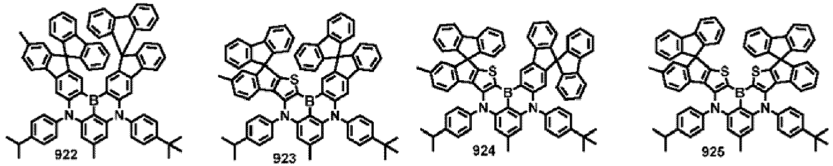

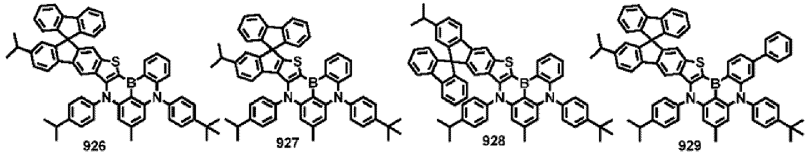

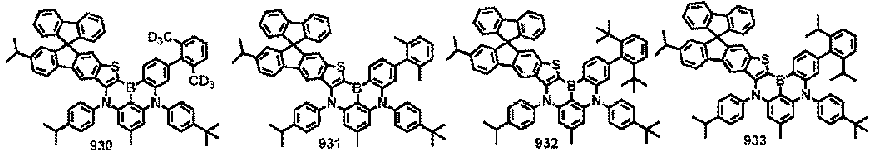

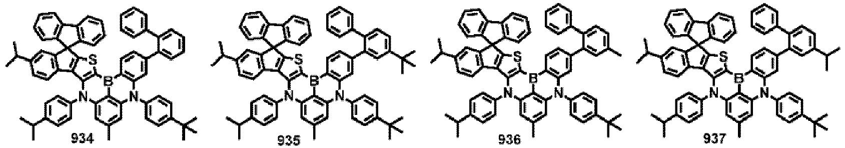

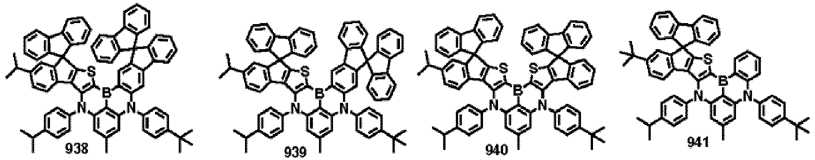

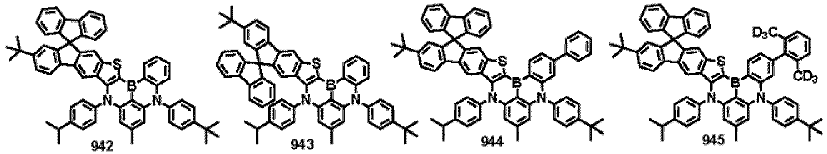

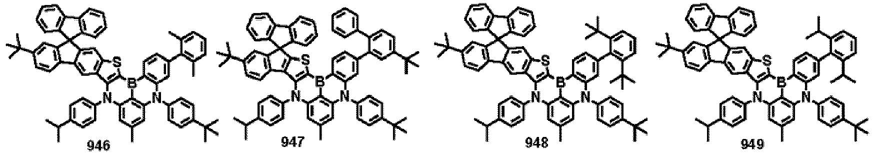

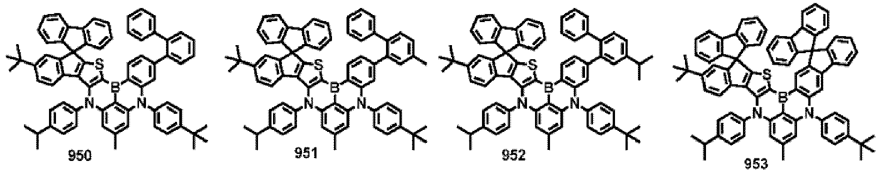

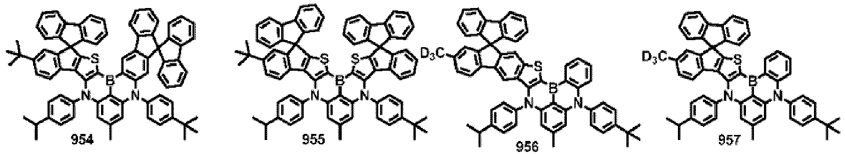

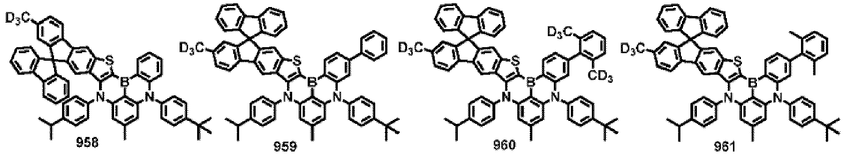

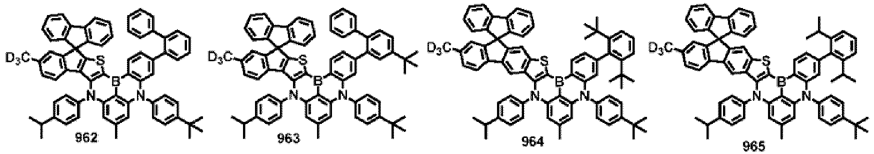

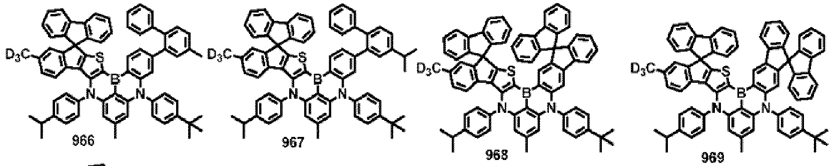

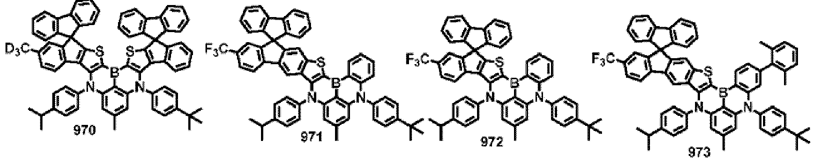

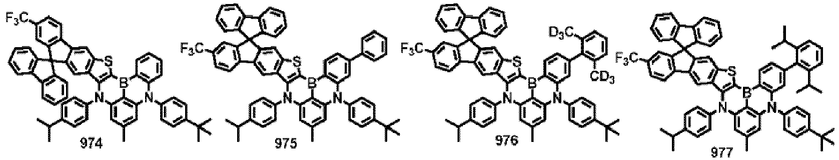

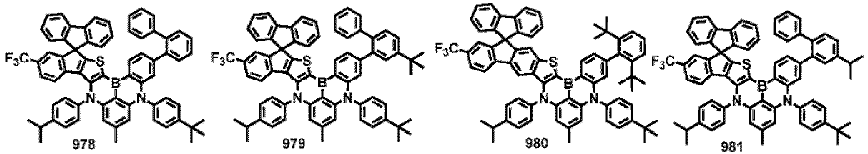

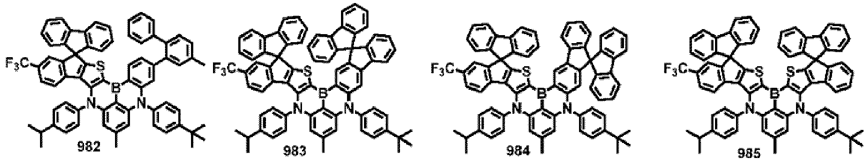

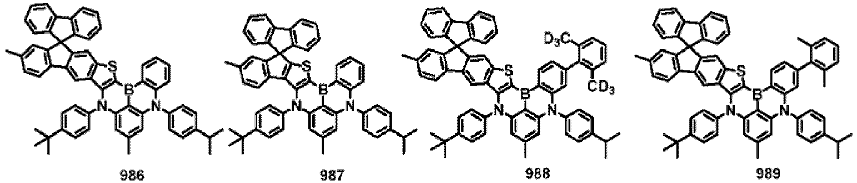

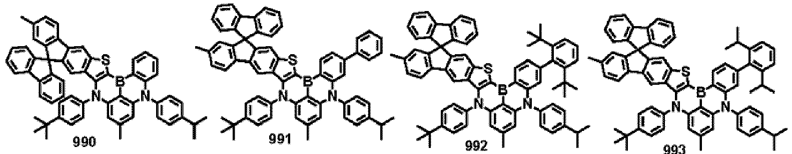

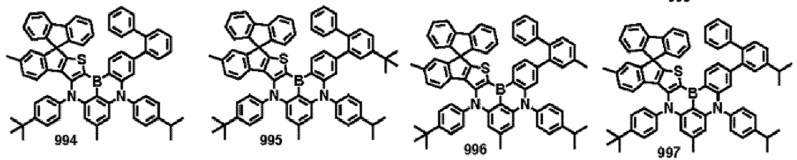

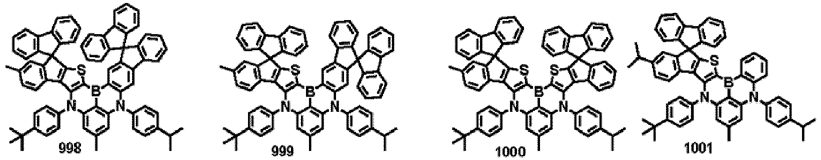

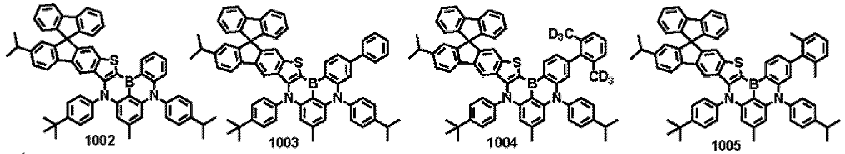

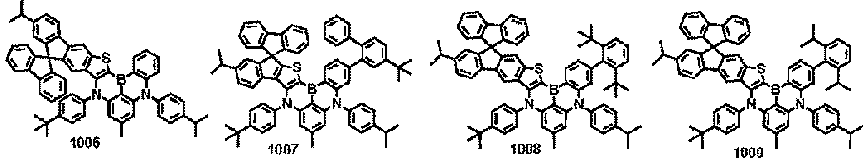

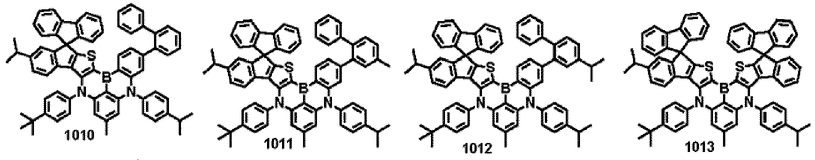

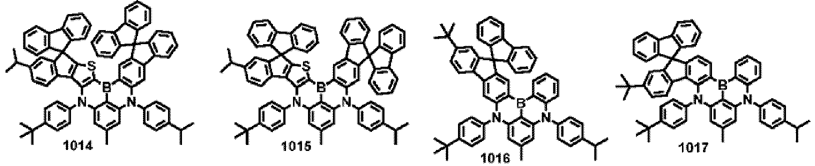

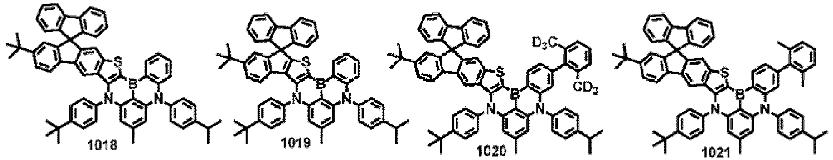

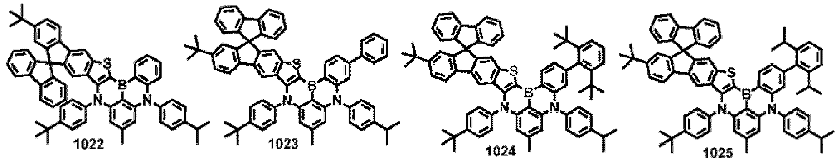

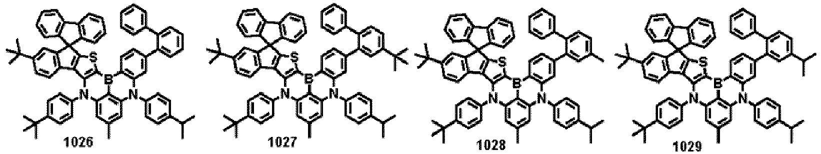

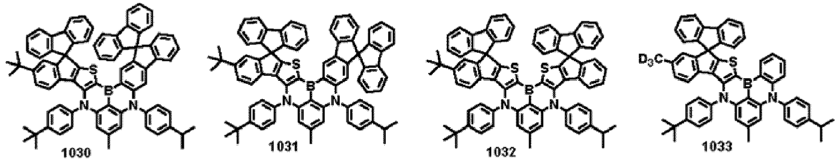

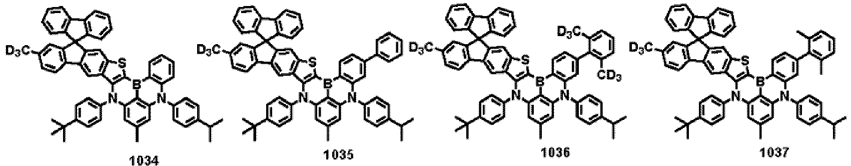

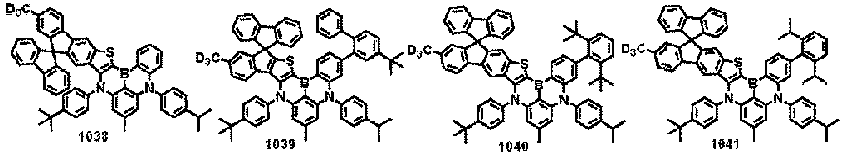

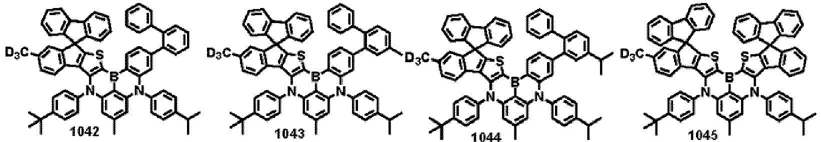

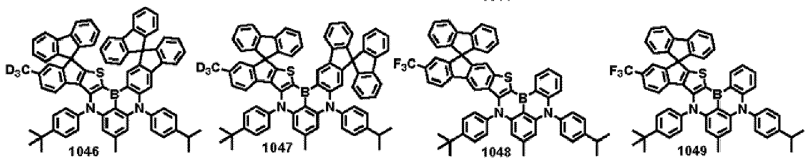

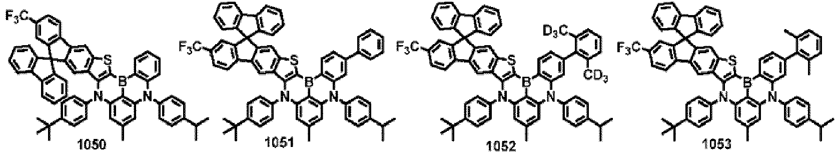

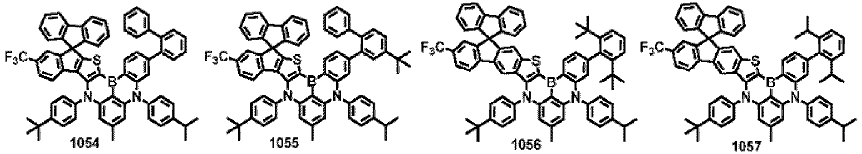

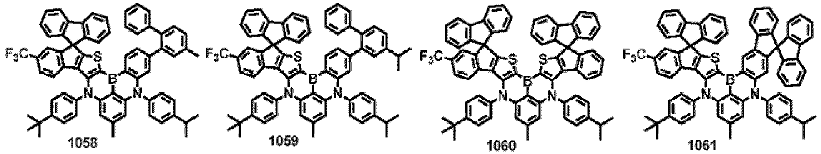

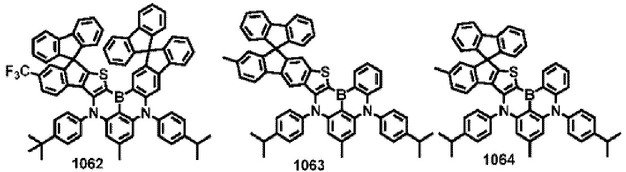

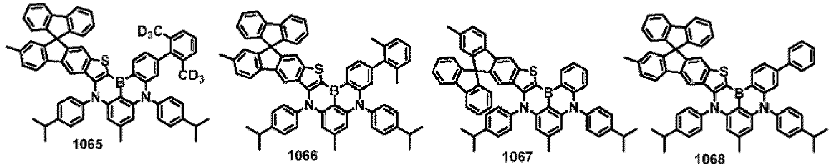

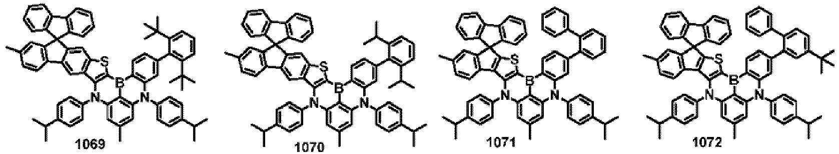

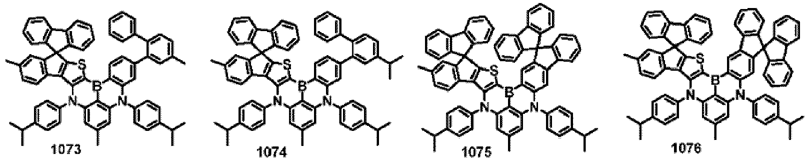

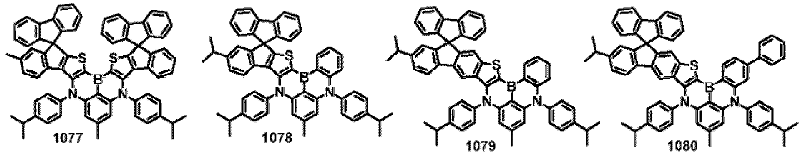

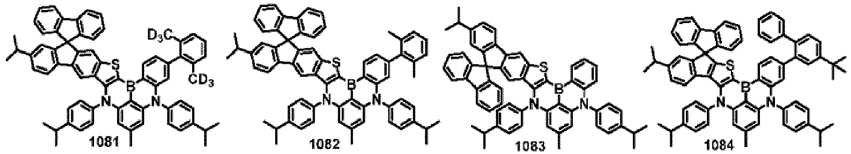

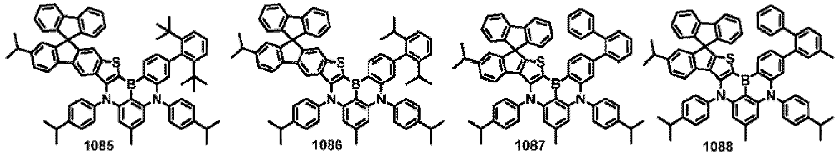

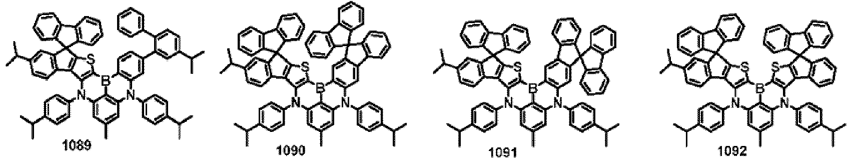

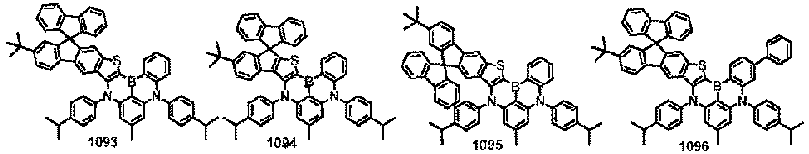

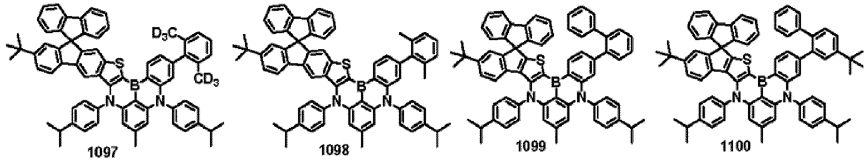

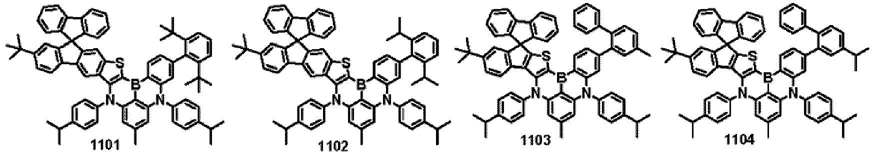

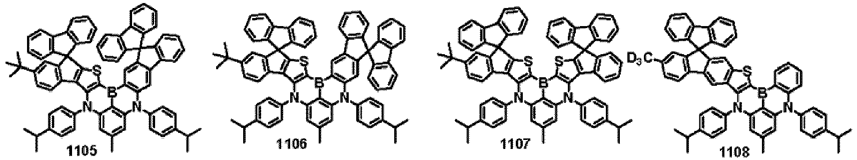

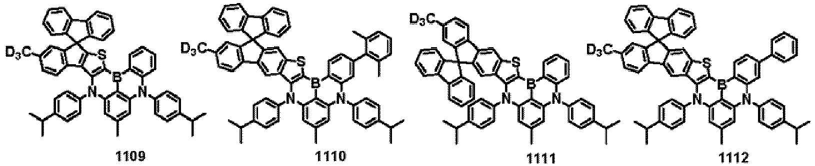

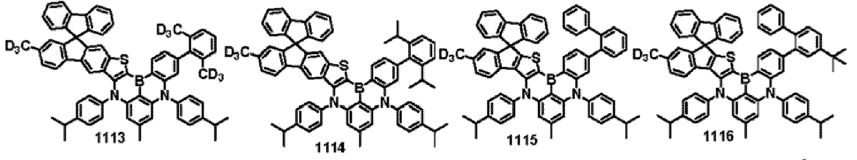

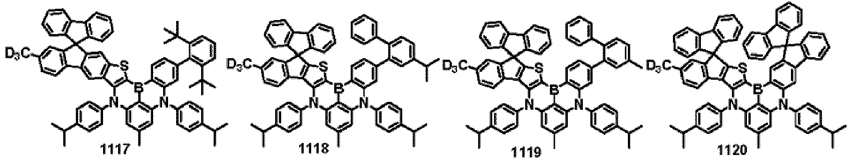

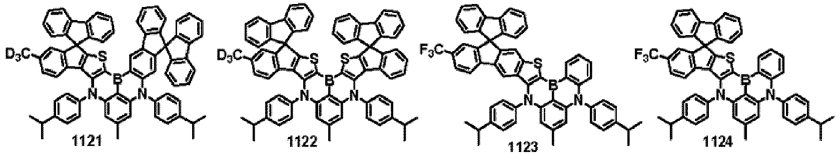

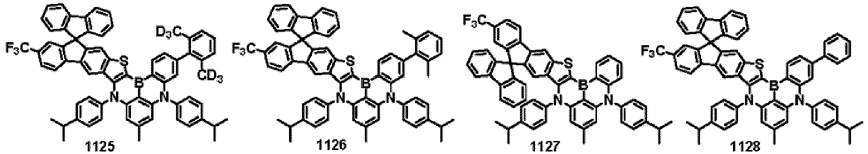

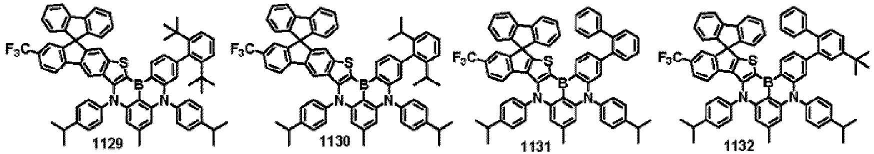

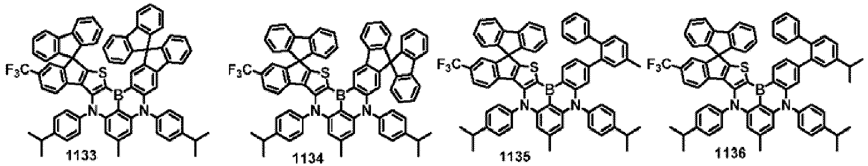

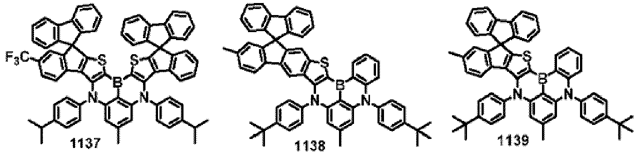

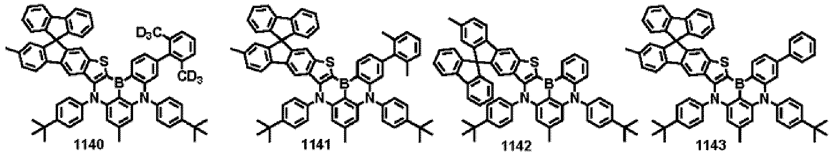

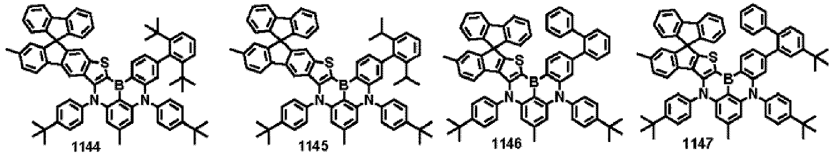

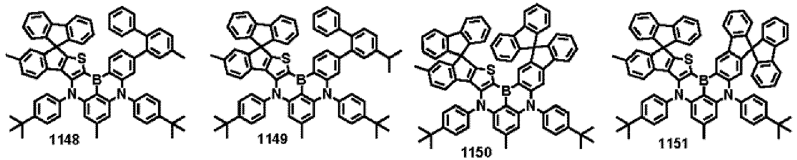

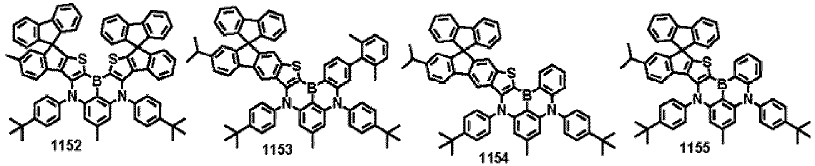

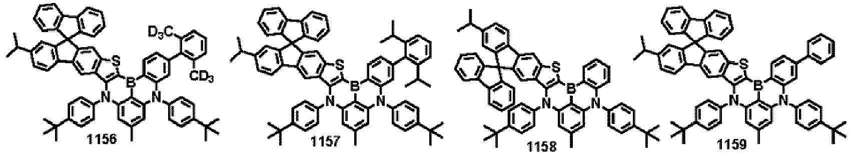

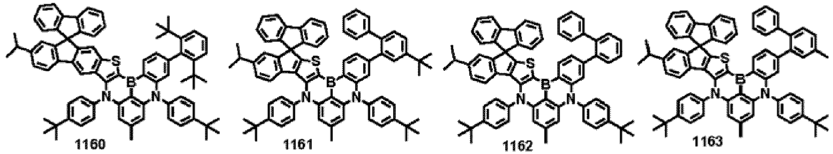

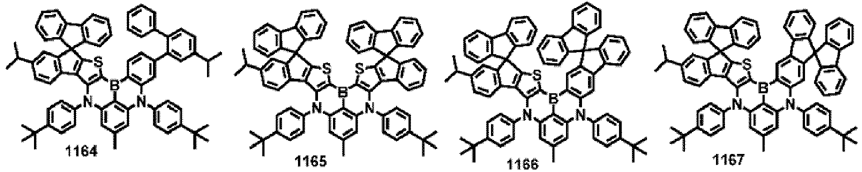

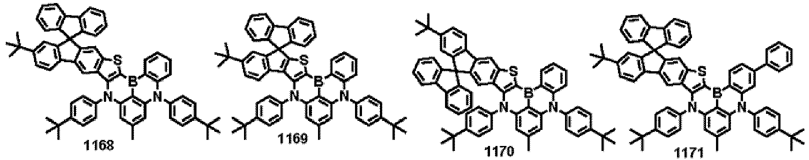

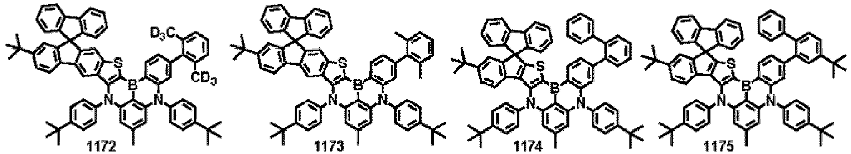

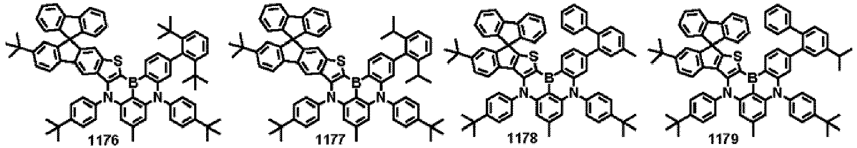

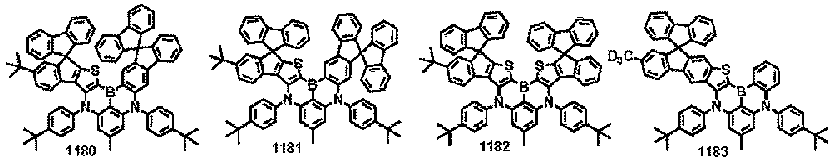

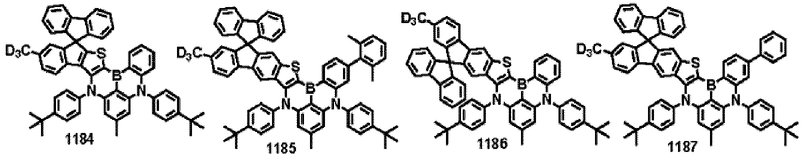

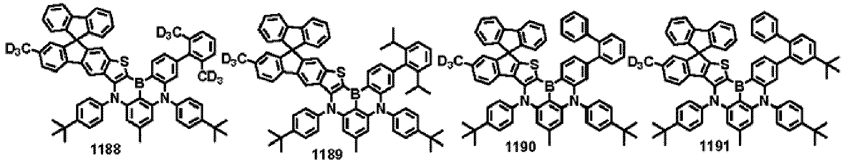

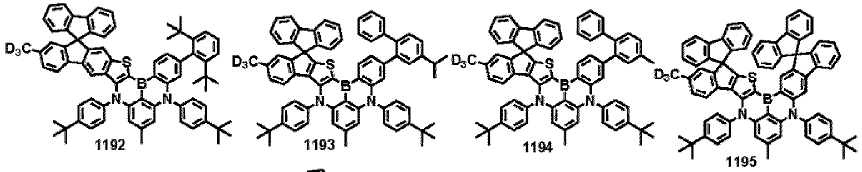

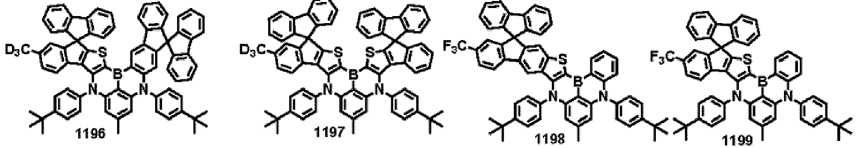

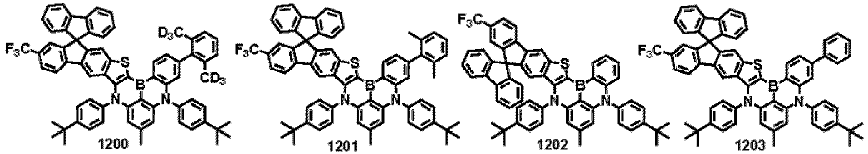

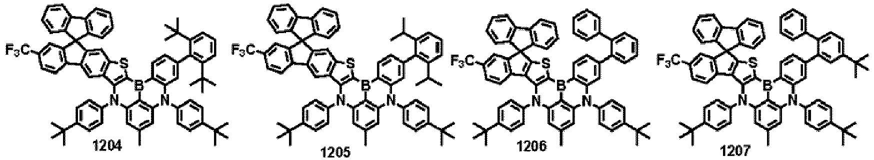

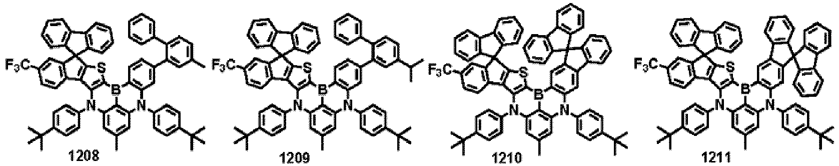

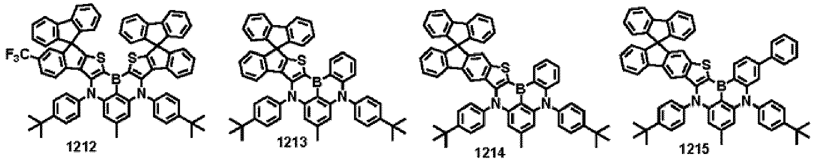

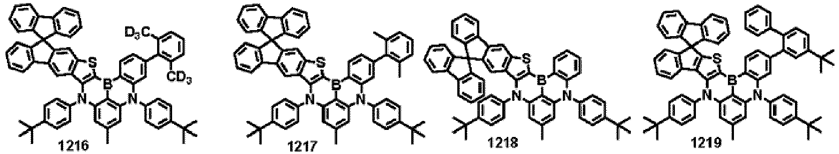

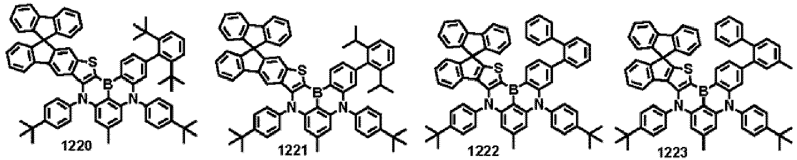

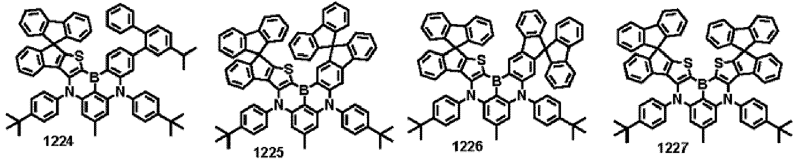

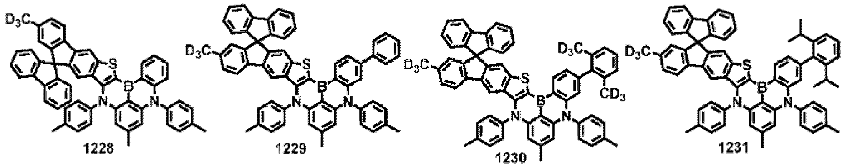

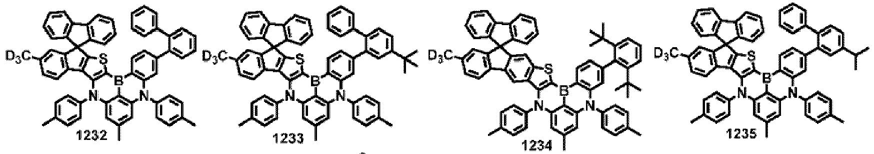

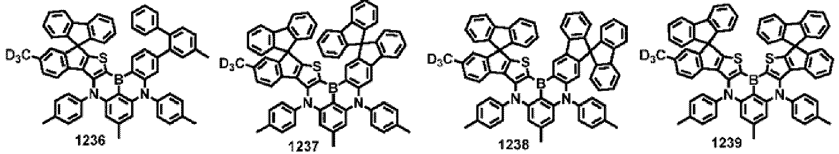

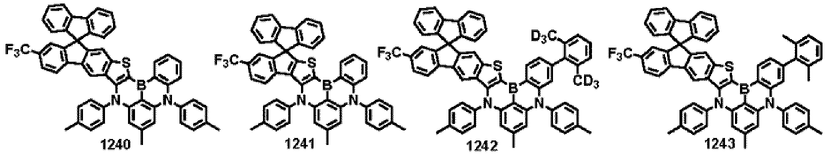

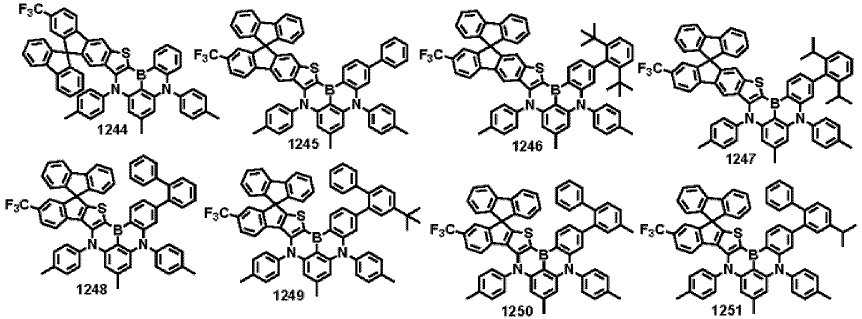

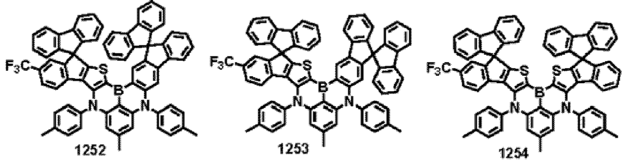

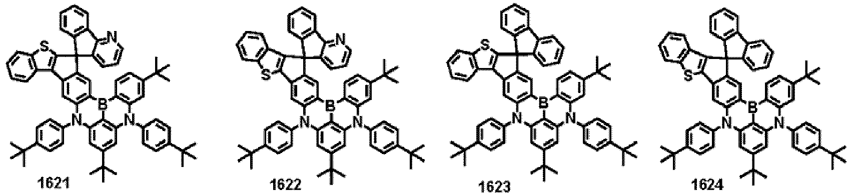

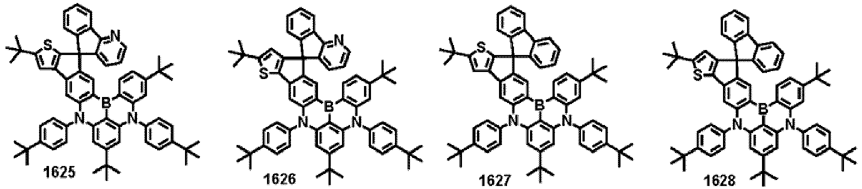

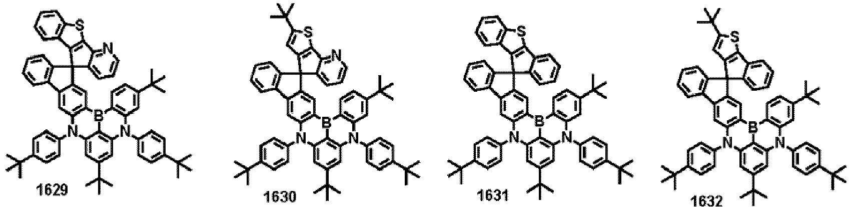

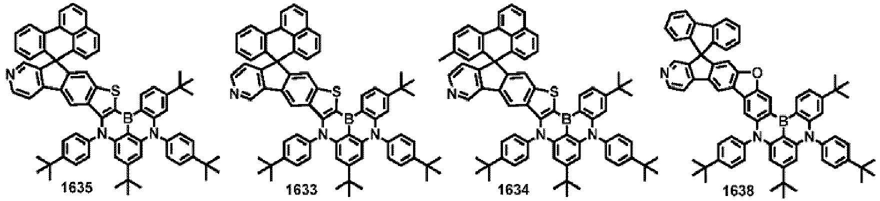

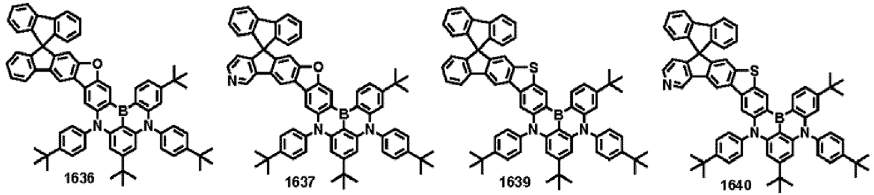

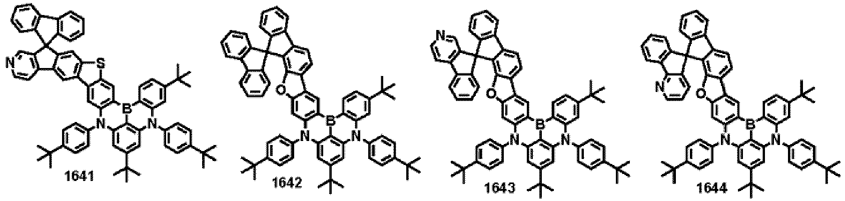

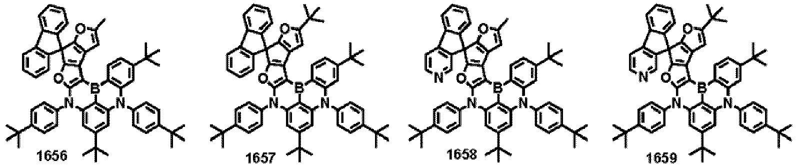

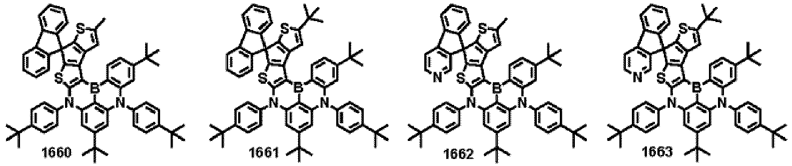

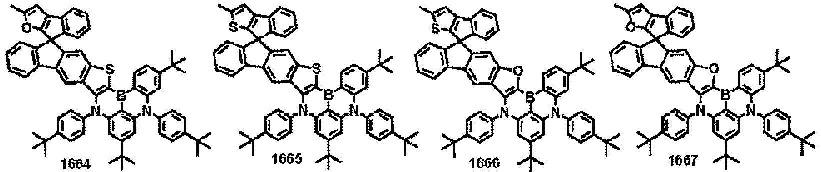

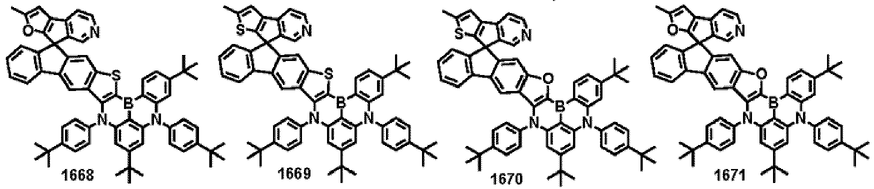

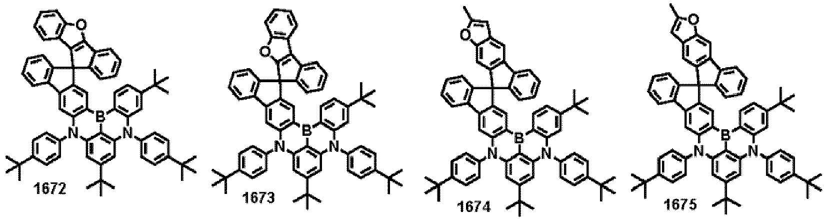

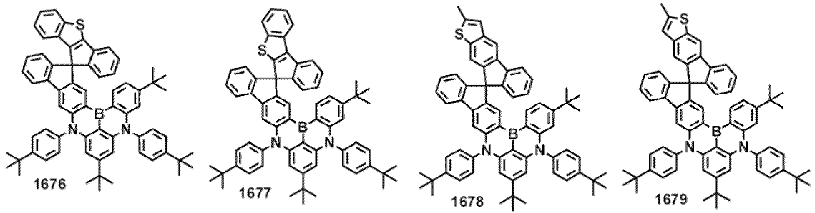

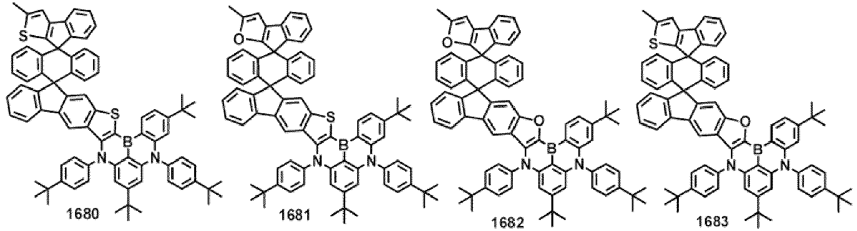

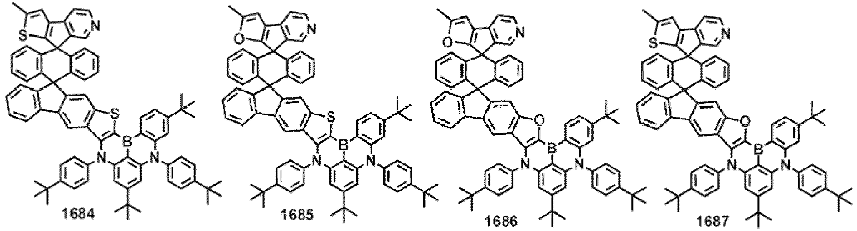

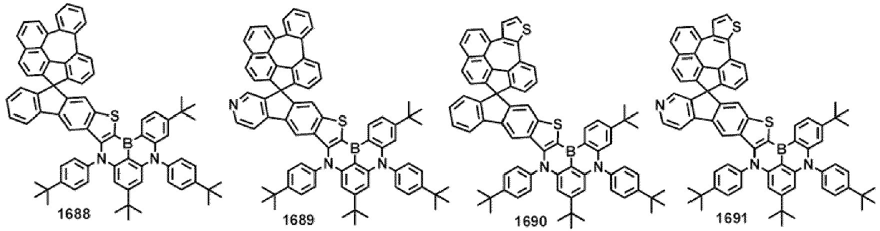

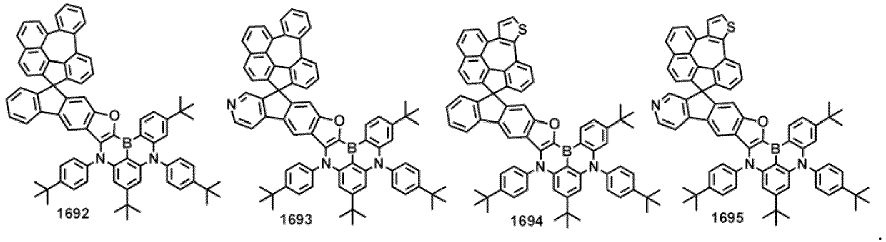

7. A formulation, comprising the spiro compound according to claim 1 or 2 and at least one solvent, wherein the solvent is a saturated hydrocarbon-based solvent, an unsaturated hydrocarbon-based solvent, an ether-based solvent or an ester-based solvent.

8. An organic electroluminescent diode, comprising an anode layer, a cathode layer and an organic functional layer, wherein the organic functional layer is a hole injection layer, a hole transport layer, an emissive layer, a hole blocking layer, an electron injection layer and an electron transport layer, and the organic functional layer comprises the spiro compound according to claim 1 or 2.

9. The organic electroluminescent diode according to claim 8, wherein the organic functional layer is an emissive layer, and the emissive layer further comprises a host compound;
wherein the volume ratio of the spiro compound to the host compound is 1:1-1:99.

10. A display device, comprising the organic electroluminescent diode according to claim 8.
